(19) Europäisches Patentamt / European Patent Office / Office européen des brevets

(11) **EP 4 071 946 A1**

(12) **EUROPEAN PATENT APPLICATION**
published in accordance with Art. 153(4) EPC

(43) Date of publication:
**12.10.2022 Bulletin 2022/41**

(21) Application number: **20912816.4**

(22) Date of filing: **07.12.2020**

(51) International Patent Classification (IPC):
**H01S 5/183** (2006.01)   **H01L 21/3065** (2006.01)
**H01S 5/42** (2006.01)

(52) Cooperative Patent Classification (CPC):
**H01L 21/3065; H01S 5/183; H01S 5/42**

(86) International application number:
**PCT/JP2020/045396**

(87) International publication number:
**WO 2021/140803 (15.07.2021 Gazette 2021/28)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(30) Priority: **08.01.2020 JP 2020001291**

(71) Applicant: **Sony Group Corporation**
**Tokyo 108-0075 (JP)**

(72) Inventors:
• **HAYASHI, Kentaro**
  **Tokyo 108-0075 (JP)**
• **HAMAGUCHI, Tatsushi**
  **Tokyo 108-0075 (JP)**
• **TANAKA, Masayuki**
  **Tokyo 108-0075 (JP)**
• **KODA, Rintaro**
  **Tokyo 108-0075 (JP)**

(74) Representative: **D Young & Co LLP**
**120 Holborn**
**London EC1N 2DY (GB)**

(54) **LIGHT EMITTING ELEMENT**

(57)    A light emitting element includes a laminated structure 20 in which a first compound semiconductor layer 21, an active layer 23, and a second compound semiconductor layer 22 are laminated, a first light reflecting layer 41, and a second light reflecting layer 42 having a flat shape, a base surface 90 located on a side of a first surface of the first compound semiconductor layer 21 has a first region 91 (upwardly convex first-A region 91A and first-B region 91B) including a protruding portion protruding in a direction away from the active layer and a second region 92 having a flat surface, the first light reflecting layer 41 is formed at least on the first-A region 91A, a second curve formed by the first-B region 91B and a straight line formed by the second region 92 inter-sects at an angle exceeding 0°, and the second curve includes at least one kind of figure selected from the group consisting of a combination of a downwardly convex curve, a line segment, and an arbitrary curve.

FIG. 1

EP 4 071 946 A1

## EP 4 071 946 A1

**Description**

TECHNICAL FIELD

The present disclosure relates to a light emitting element, more specifically, a light emitting element including a surface emitting laser element (VCSEL).

BACKGROUND ART

In a light emitting element including a surface emitting laser element, laser oscillation generally occurs by causing a laser beam to resonate between two light reflecting layers (Distributed Bragg Reflector layer, DBR layer). Then, in a surface emitting laser element having a laminated structure in which an n-type compound semiconductor layer (first compound semiconductor layer), an active layer (light emitting layer) including a compound semiconductor, and a p-type compound semiconductor layer (second compound semiconductor layer) are laminated, generally, a second electrode including a transparent conductive material is formed on the p-type compound semiconductor layer, and a second light reflecting layer is formed on the second electrode. Furthermore, a first light reflecting layer and a first electrode are formed on the n-type compound semiconductor layer (on the exposed surface of the substrate in a case where the n-type compound semiconductor layer is formed on the conductive substrate). Note that, in the present specification, the concept "above" may refer to a direction away from the active layer with respect to the active layer, the concept "below" may refer to a direction approaching the active layer with respect to the active layer, and the concepts "convex" and "concave" may refer to the active layer.

In order to suppress diffraction loss due to lateral light field confinement, a structure in which a first light reflecting layer also functions as a concave mirror is well known from, for example, WO 2018/083877 A1. Here, in the technology disclosed in this International Publication, for example, a protrusion is formed in an n-type compound semiconductor layer with respect to an active layer, and the first light reflecting layer is formed on the protrusion.

CITATION LIST

PATENT DOCUMENT

Patent Document 1: WO 2018/083877 A1

SUMMARY OF THE INVENTION

PROBLEMS TO BE SOLVED BY THE INVENTION

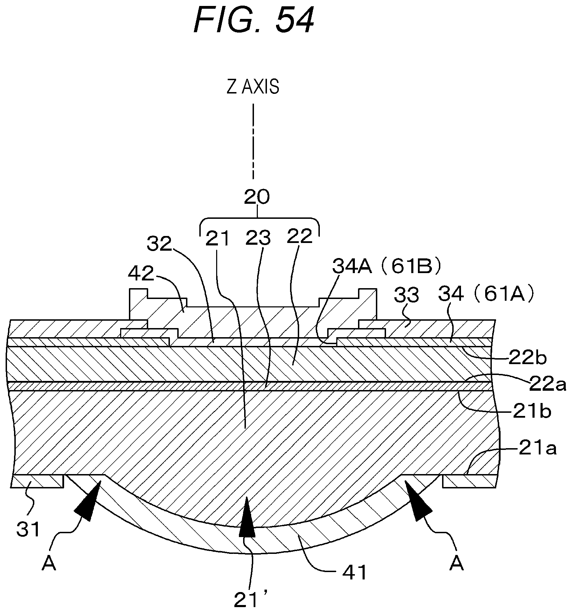

Meanwhile, in the technology disclosed in this International Publication, as illustrated in a schematic partial end view in Fig. 54, a protrusion 21' rises from a flat first compound semiconductor layer 21. A value of a complementary angle $\theta_{CA}$ (described later) of a rising angle is, for example, 15° or more. Note that a rising portion of the protrusion is indicated by an arrow "A" in Fig. 54. Furthermore, reference numerals in Fig. 54 will be described in Examples. Therefore, in a case where a strong external force is applied to the light emitting element for some reason, stress concentrates on the rising portion of the protrusion, and damage may occur in the first compound semiconductor layer and the like. Furthermore, when such damage reaches a resonator structure, optical scattering loss occurs, resulting in an increase in threshold current.

Therefore, an object of the present disclosure is to provide a light emitting element having a configuration and a structure that are hardly damaged even when a strong external force is applied, and a method for manufacturing a light emitting element including the light emitting element.

SOLUTIONS TO PROBLEMS

In order to achieve the above object, according to first and second aspects of the present disclosure, there is provided

a light emitting element including:
a laminated structure in which
a first compound semiconductor layer having a first surface and a second surface facing the first surface,
an active layer facing the second surface of the first compound semiconductor layer, and
a second compound semiconductor layer having a first surface facing the active layer and a second surface facing the first surface
are laminated;
a first light reflecting layer; and
a second light reflecting layer formed on a side of the second surface of the second compound semiconductor layer and having a flat shape,
in which a base surface located on a side of the first surface of the first compound semiconductor layer has a first region including a protruding portion protruding in a direction away from the active layer and a second region surrounding the first region and having a flat surface.

Then, in the light emitting element according to the first aspect of the present disclosure,

the first region includes a first-A region including a top portion of the protruding portion and a first-B region surrounding the first-A region,
the first light reflecting layer is formed on at least the first-A region,
a first curve formed by the first-A region in a cross-sectional shape of the base surface when the base surface is cut along a virtual plane including a lamination direction of the laminated structure is formed by an upwardly convex smooth curve,
at an intersection of a second curve formed by the first-B region and a straight line formed by the second region in the cross-sectional shape of the base surface, a complementary angle $\theta_{CA}$ of an angle formed by the second curve and the straight line has a value exceeding 0°, and
the second curve includes at least one kind of figure selected from the group consisting of a combination of a downwardly convex curve, a line segment, and an arbitrary curve.

Furthermore, in the light emitting element according to the second aspect of the present disclosure,

the first light reflecting layer is formed at least on a top portion of the first region, and
at an intersection of a curve formed by the first region and a straight line formed by the second region in a cross-sectional shape of the base surface when the base surface is cut along a virtual plane including a lamination direction of the laminated structure, a complementary angle $\theta_{CA}$ of an angle formed by the curve and the straight line is 1° or more and 6° or less.

In order to achieve the above object, according to first and second aspects of the present disclosure, there is provided

a method for manufacturing a light emitting element including
a laminated structure in which
a first compound semiconductor layer having a first surface and a second surface facing the first surface,
an active layer facing the second surface of the first compound semiconductor layer, and
a second compound semiconductor layer having a first surface facing the active layer and a second surface facing the first surface
are laminated,
a first light reflecting layer, and
a second light reflecting layer formed on a side of the second surface of the second compound semiconductor layer and having a flat shape,
a base surface located on a side of the first surface of the first compound semiconductor layer having a first region including a protruding portion protruding in a direction away from the active layer and a second region surrounding the first region and having a flat surface,
the first light reflecting layer being formed at least on a top portion of the first region, and
at an intersection of a curve formed by the first region and a straight line formed by the second region in a cross-sectional shape of the base surface when the base surface is cut along a virtual plane including a lamination direction of the laminated structure, a complementary angle $\theta_{CA}$ of an angle formed by the curve and the straight line exceeding 0°.

Then, in the method for manufacturing a light emitting element according to the first aspect of the present disclosure,

the method includes
forming the second light reflecting layer on a side of the second surface of the second compound semiconductor layer after forming the laminated structure;

after performing a protrusion forming step of forming a protrusion where the first region of the base surface is to be formed and forming a flat surface in a region where the second region of the base surface is to be formed;

performing an etch-back step of forming a protrusion a first region of the base surface and forming a flat surface in a second region of the base surface with reference to the second surface of the first compound semiconductor layer by forming a second sacrificial layer on the entire surface and then etching back the first compound semiconductor layer from the base surface toward the inside thereof using the second sacrificial layer as an etching mask; and

forming the first light reflecting layer on at least a top portion of the first region of the base surface, in which

$$\theta_2 < \theta_1$$

is satisfied.

Here, $\theta_1$ is a complementary angle of an angle formed by a curve and a straight line at an intersection of the curve and the straight line, the curve being formed by the region in which the first region is to be formed, and the straight line being formed by the region in which the second region is to be formed, in the cross-sectional shape of the base surface obtained in the protrusion forming step, and $\theta_2$ is a complementary angle of an angle formed by the curve and the straight line at the intersection of the curve formed by the first region and the straight line formed by the second region in the cross-sectional shape of the base surface obtained in the etch-back step.

Furthermore, in the method for manufacturing a light emitting element according to the second aspect of the present disclosure, the method includes

forming the second light reflecting layer on a side of the second surface of the second compound semiconductor layer after forming the laminated structure;

forming a first sacrificial layer on the first region of the base surface on which the first light reflecting layer is to be formed;

performing an etch-back step of forming a protrusion in a first region of the base surface and forming a flat surface in a second region of the base surface with respect to the second surface of the first compound semiconductor layer by forming a second sacrificial layer on the entire surface and then etching back the first compound semiconductor layer from the base surface toward the inside thereof using the second sacrificial layer and the first sacrificial layer as an etching mask; and

forming the first light reflecting layer on at least a top portion of the first region of the base surface, in which

$$\theta_2' < \theta_1'$$

is satisfied.

Here, $\theta_1'$ is a complementary angle of an angle formed by a curve formed by a cross-sectional shape of the first sacrificial layer when the first sacrificial layer is cut along the virtual plane and a straight line formed by a flat portion at an intersection of the curve and the straight line, and

$\theta_2'$ is a complementary angle of an angle formed by the curve and the straight line at an intersection of the curve formed by the first region and the straight line formed by the second region in the cross-sectional shape of the base surface obtained by the etch-back step.

BRIEF DESCRIPTION OF DRAWINGS

Fig. 1 is a schematic partial cross-sectional view of a light emitting element of Example 1.

Fig. 2 is a schematic partial cross-sectional view of a light emitting element array including a plurality of light emitting elements of Example 1.

Fig. 3 is a schematic partial cross-sectional view of Modification-1 of the light emitting element of Example 1.

Fig. 4 is a schematic partial cross-sectional view of Modification-2 of the light emitting element of Example 1.

Fig. 5 is a schematic partial cross-sectional view of Modification-3 of the light emitting element of Example 1.

Fig. 6 is a schematic partial cross-sectional view of Modification-4 of the light emitting element of Example 1.

Fig. 7 is a schematic partial cross-sectional view of Modification-5 of the light emitting element of Example 1.

Fig. 8 is a schematic plan view of arrangement of a first light reflecting layer and a first electrode in the light emitting element array including the plurality of light emitting elements of Example 1.

Fig. 9 is a schematic plan view of the arrangement of the first light reflecting layer and the first electrode in the light emitting element array including the plurality of light emitting elements of Example 1.

Figs. 10A and 10B are schematic partial end views of a laminated structure and the like for explaining a method for manufacturing a light emitting element of Example 1.

Fig. 11 is a schematic partial end view of the laminated structure and the like for explaining the method for manufacturing a light emitting element of Example 1, following Fig. 10B.

Fig. 12 is a schematic partial end view of the laminated structure and the like for explaining the method for manufacturing a light emitting element of Example 1, following Fig. 11.

Figs. 13A and 13B are schematic partial end views of a first compound semiconductor layer and the like for explaining the method for manufacturing a light emitting element of Example 1, following Fig. 12.

Figs. 14A and 14B are schematic partial end views of the first compound semiconductor layer and the like for explaining the method for manufacturing a light emitting element of Example 1, following Fig. 13B.

Fig. 15 is a schematic partial end view of the first compound semiconductor layer and the like for explaining the method for manufacturing a light emitting element of Example 1, following Fig. 14B.

Figs. 16A and 16B are schematic partial end views of a first compound semiconductor layer and the like for explaining a method for manufacturing a light emitting element of Example 2, following Fig. 13B.

Figs. 17A and 17B are schematic plan views illustrating the arrangement of a first region and a second region of a base surface in a light emitting element array of Example 3.

Fig. 18 is a schematic partial end view of a light emitting element of Example 4.

Fig. 19 is a schematic partial end view of a light emitting element of Example 5.

Fig. 20 is a schematic partial end view of a modification of the light emitting element of Example 5.

Figs. 21A, 21B, and 21C are schematic partial end views of a laminated structure and the like for explaining a method for manufacturing a light emitting element of Example 6.

Fig. 22 is a schematic partial end view of a light emitting element of Example 9.

Figs. 23A and 23B are schematic partial end views of a laminated structure and the like for explaining a method for manufacturing a light emitting element of Example 9.

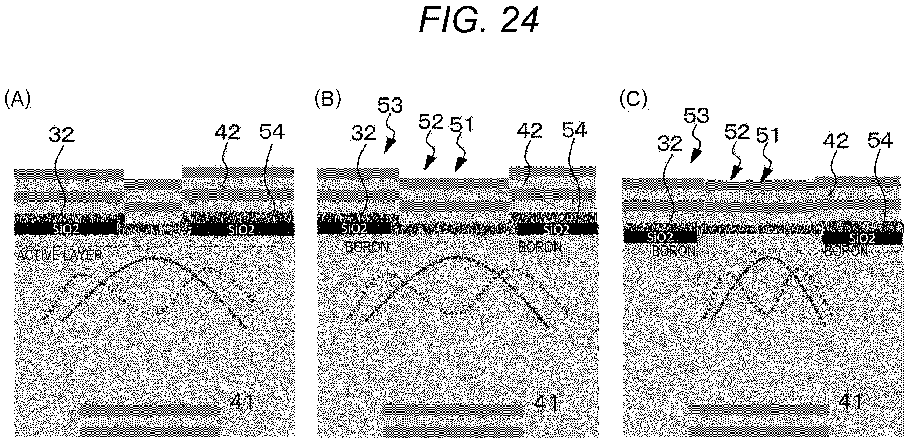

(A), (B), and (C) of Fig. 24 are conceptual diagrams illustrating light field intensities in a conventional light emitting element, the light emitting element of Example 9, and a light emitting element of Example 14, respectively.

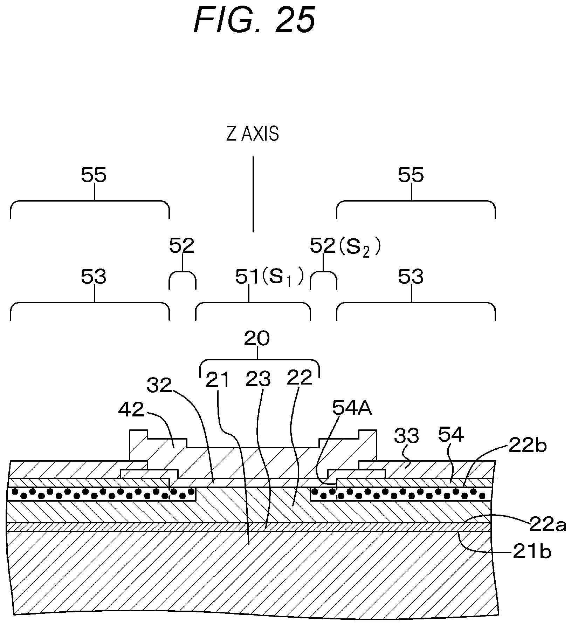

Fig. 25 is a schematic partial end view of a light emitting element of Example 10.

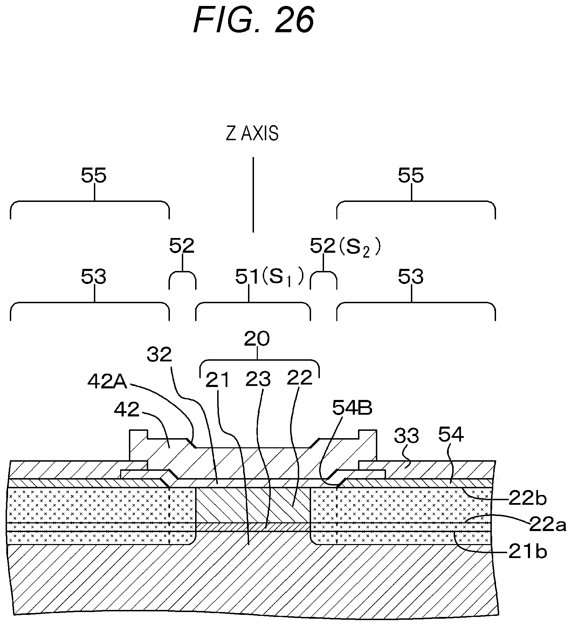

Fig. 26 is a schematic partial end view of a light emitting element of Example 11.

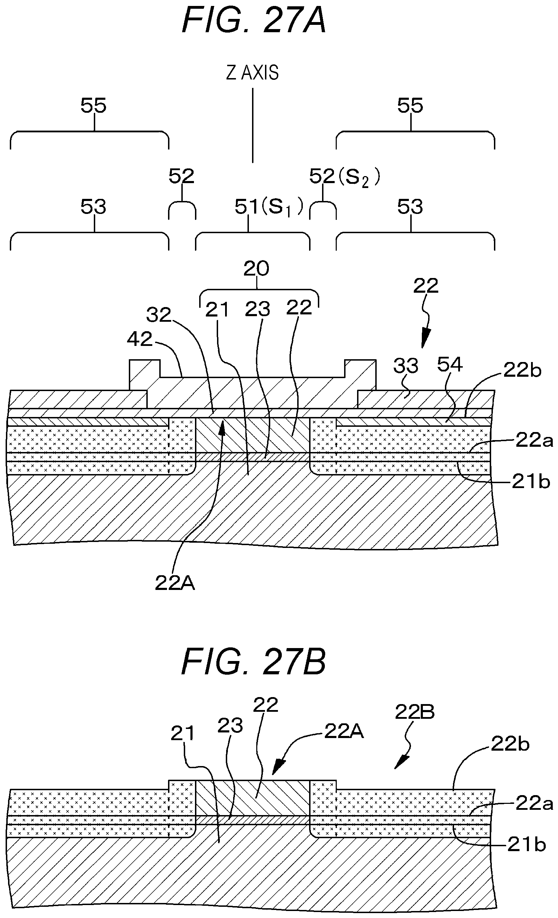

Figs. 27A and 27B are a schematic partial end view of a light emitting element of Example 12 and a schematic partial cross-sectional view obtained by cutting out a main part of the light emitting element of Example 12, respectively.

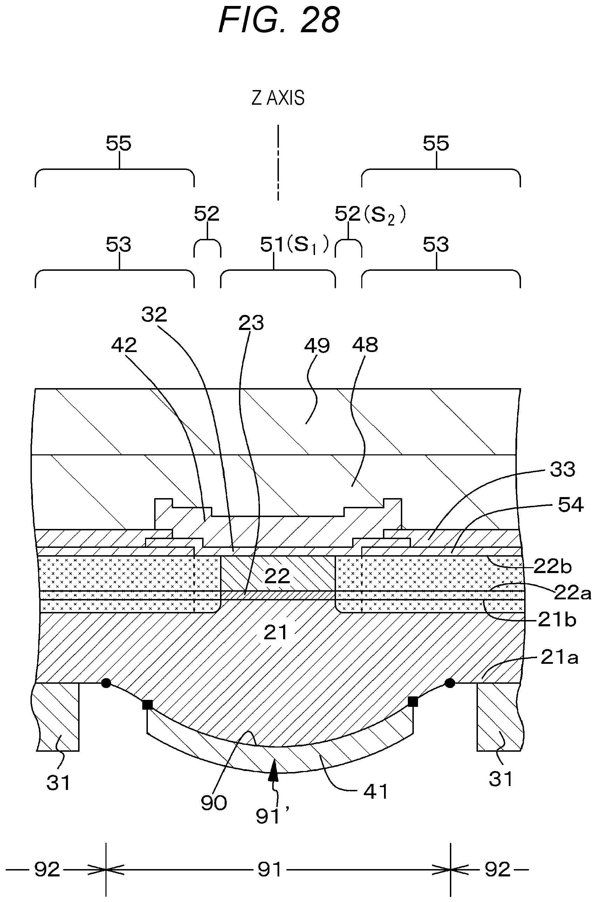

Fig. 28 is a schematic partial end view of a light emitting element of Example 13.

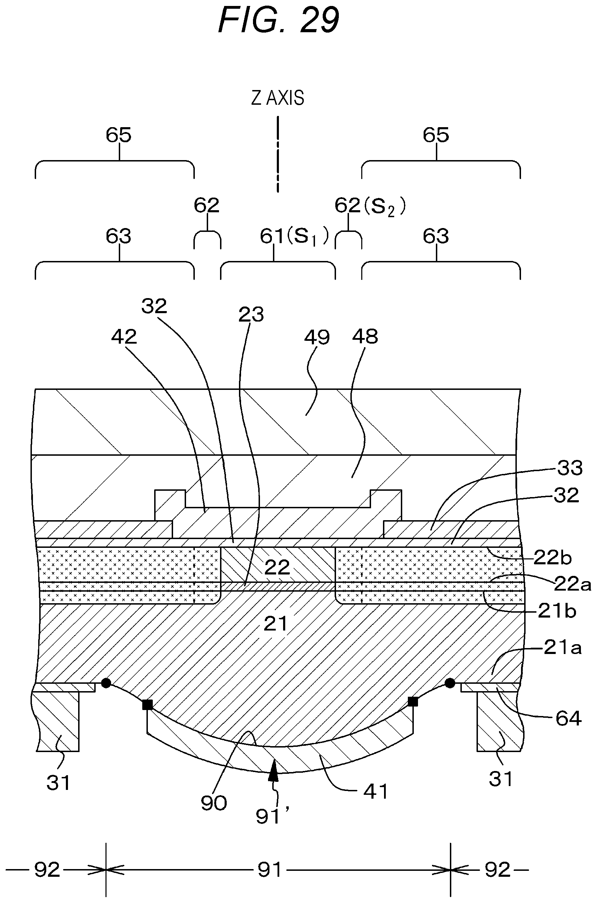

Fig. 29 is a schematic partial end view of a light emitting element of Example 14.

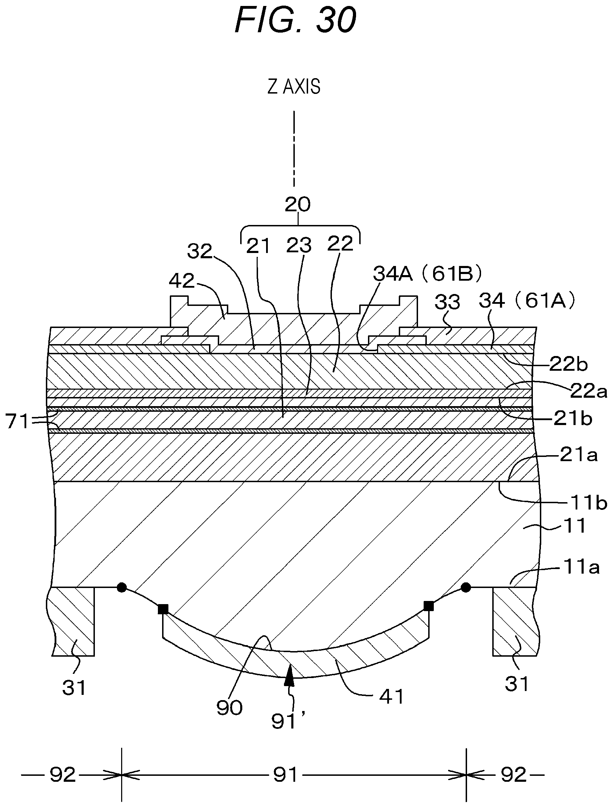

Fig. 30 is a schematic partial cross-sectional view of a light emitting element of Example 15.

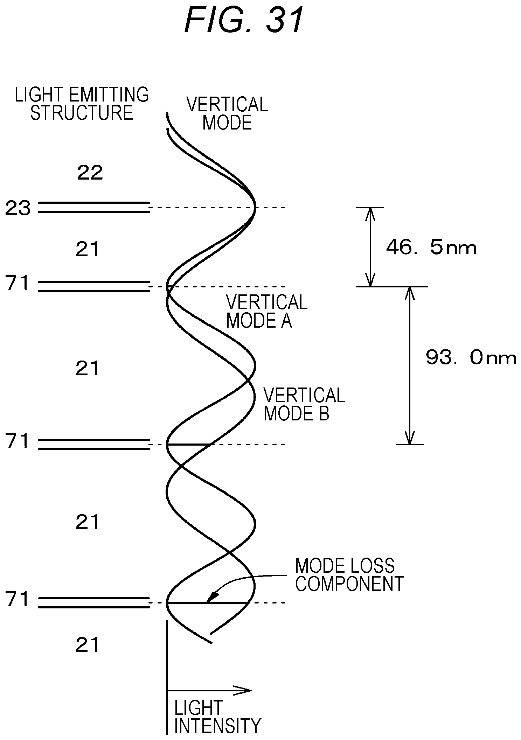

Fig. 31 is a schematic partial cross-sectional view of the light emitting element of Example 15, and a view in which two vertical modes of a vertical mode A and a vertical mode B are superimposed.

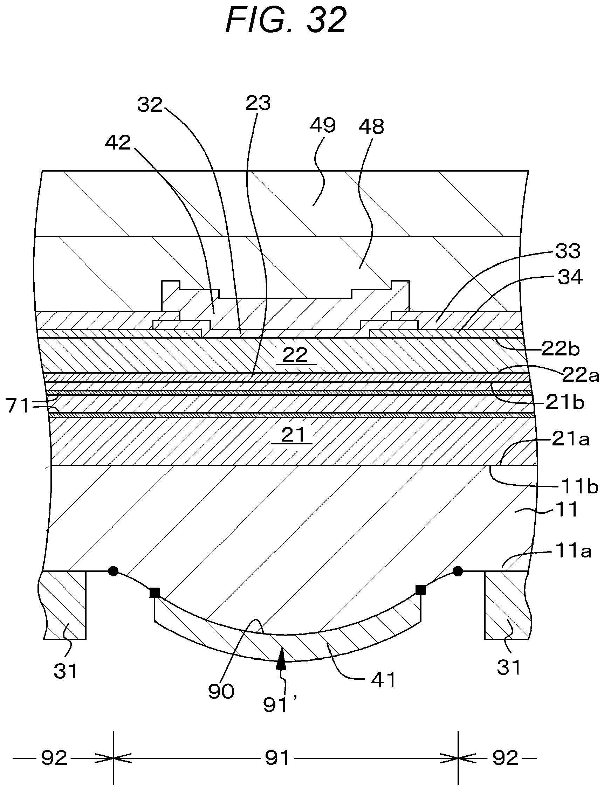

Fig. 32 is a schematic partial cross-sectional view of a light emitting element of Example 18.

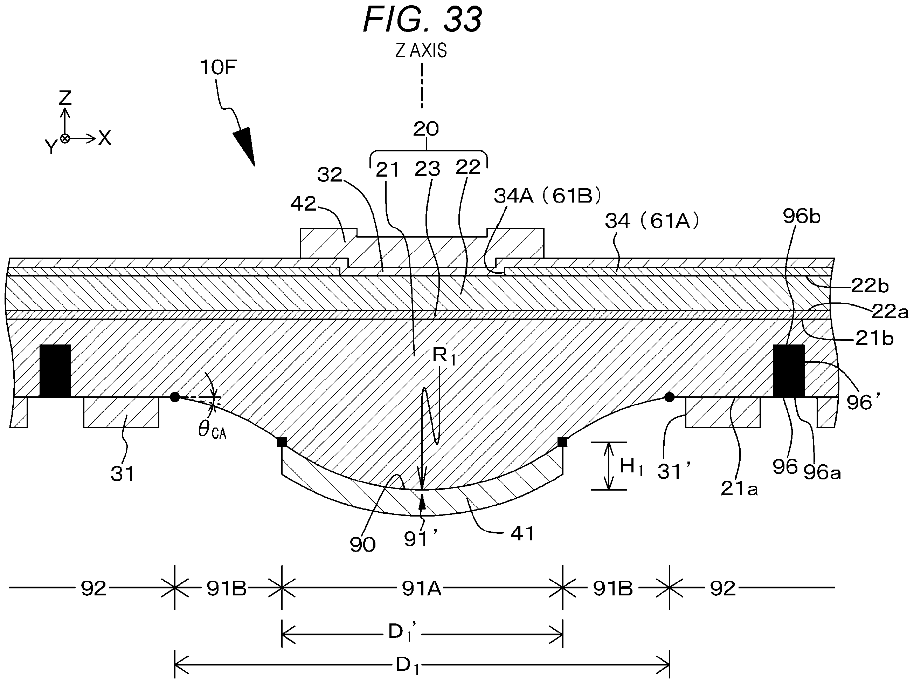

Fig. 33 is a schematic partial cross-sectional view of a light emitting element of Example 19.

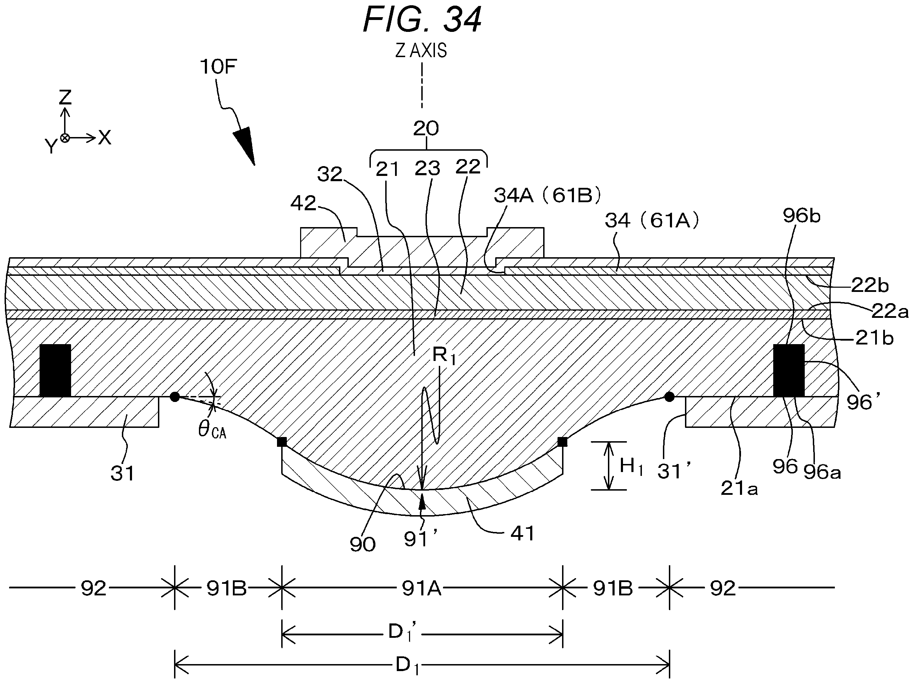

Fig. 34 is a schematic partial cross-sectional view of Modification-1 of the light emitting element of Example 19.

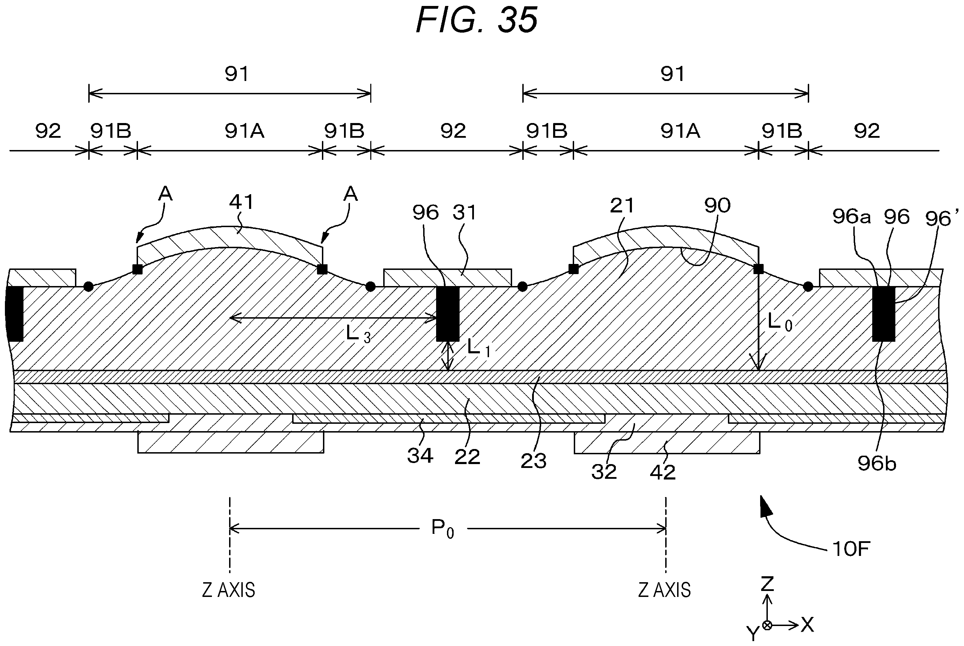

Fig. 35 is a schematic partial cross-sectional view of a light emitting element array including Modification-1 of the light emitting element of Example 19.

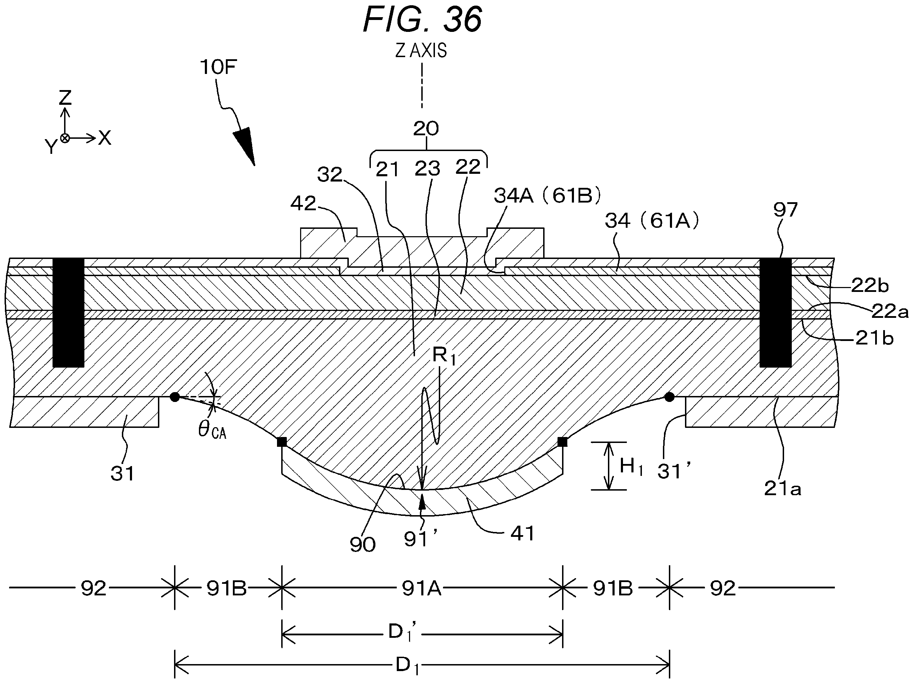

Fig. 36 is a schematic partial cross-sectional view of Modification-2 of the light emitting element of Example 19.

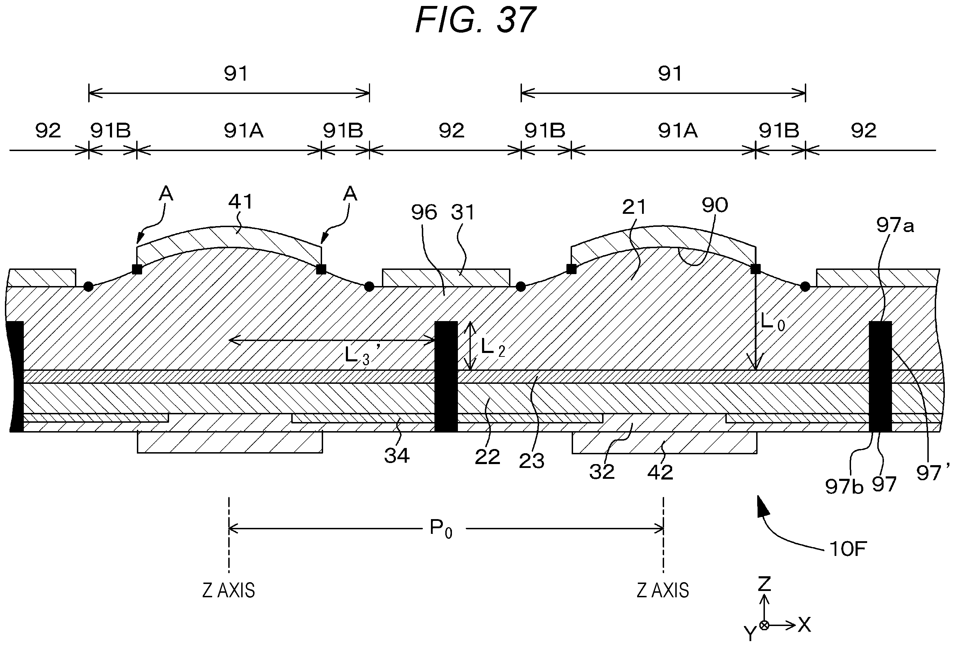

Fig. 37 is a schematic partial cross-sectional view of a light emitting element array including Modification-2 of the light emitting element of Example 19.

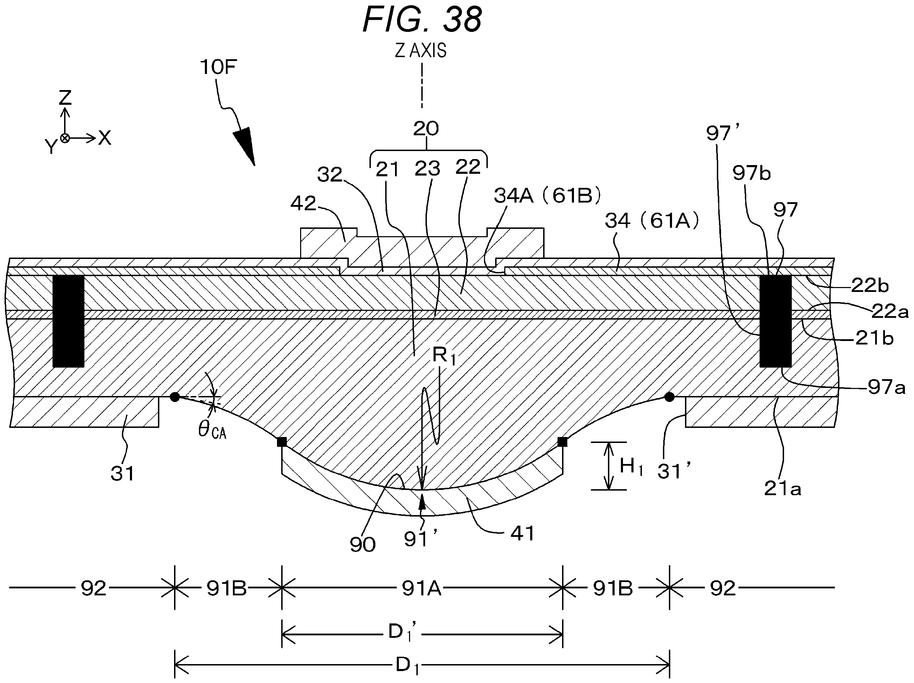

Fig. 38 is a schematic partial cross-sectional view of Modification-3 of the light emitting element of Example 19.

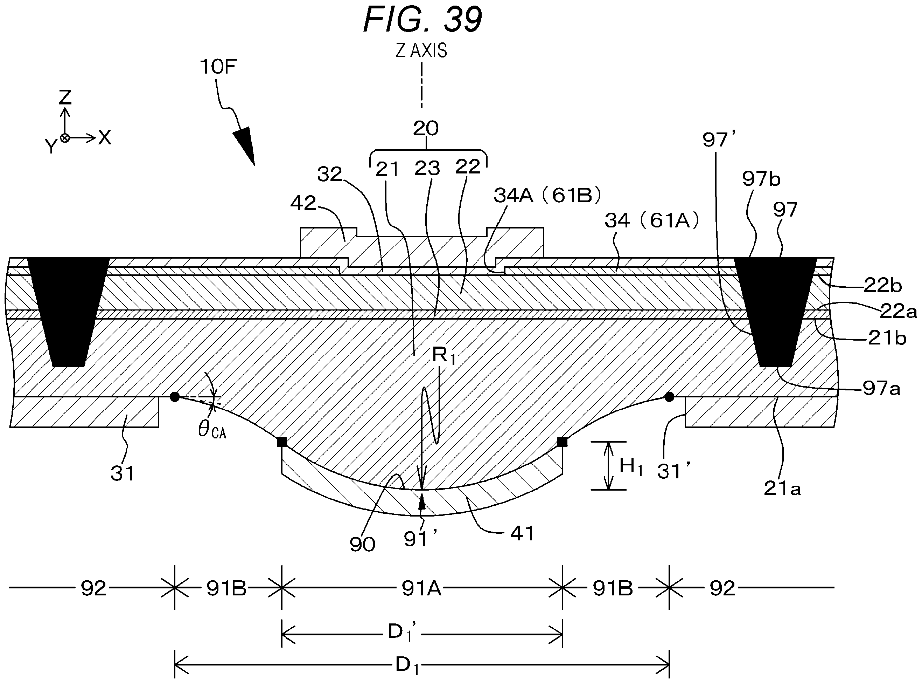

Fig. 39 is a schematic partial cross-sectional view of Modification-4 of the light emitting element of Example 19.

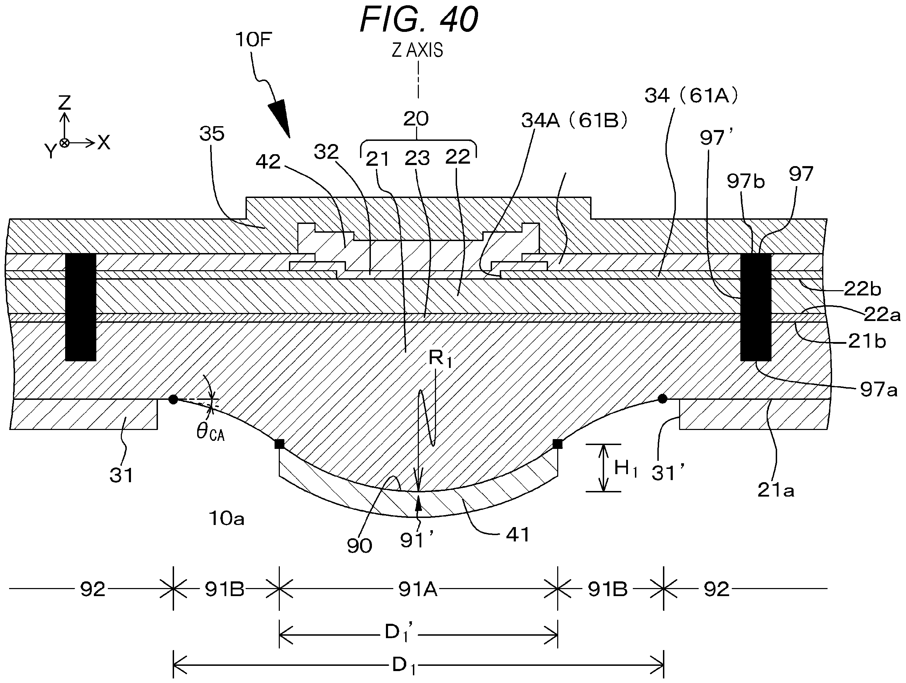

Fig. 40 is a schematic partial cross-sectional view of Modification-5 of the light emitting element of Example 19.

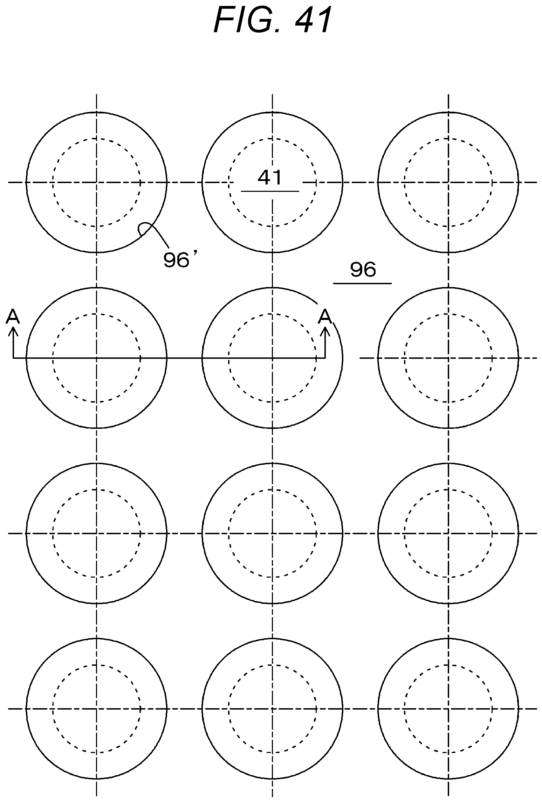

Fig. 41 is a schematic plan view illustrating arrangement of a first light reflecting layer and a partition wall in a light emitting element array including light emitting elements of Example 19.

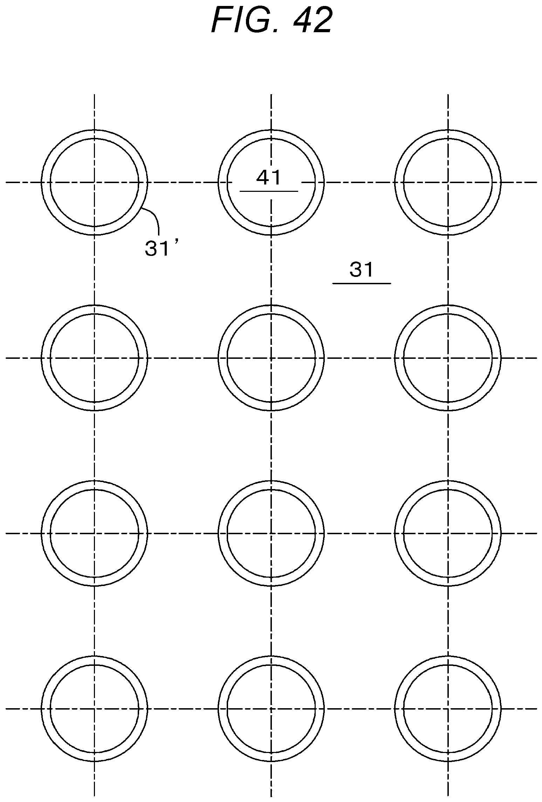

Fig. 42 is a schematic plan view illustrating arrangement of a first light reflecting layer and a first electrode in a light emitting element array including Modification-1 of the light emitting element of Example 19 illustrated in Fig. 41.

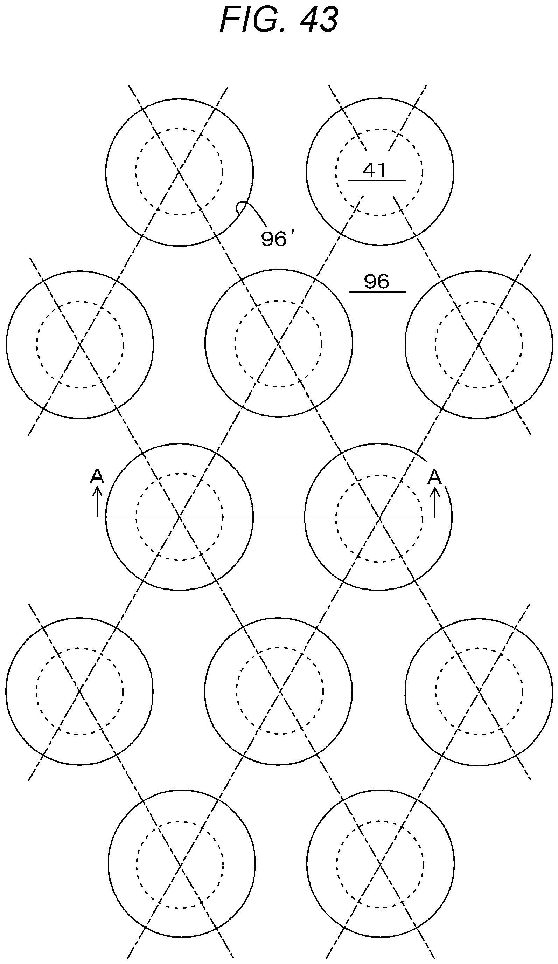

Fig. 43 is a schematic plan view illustrating arrangement of the first light reflecting layer and the partition wall in the light emitting element array including the light emitting elements of Example 19.

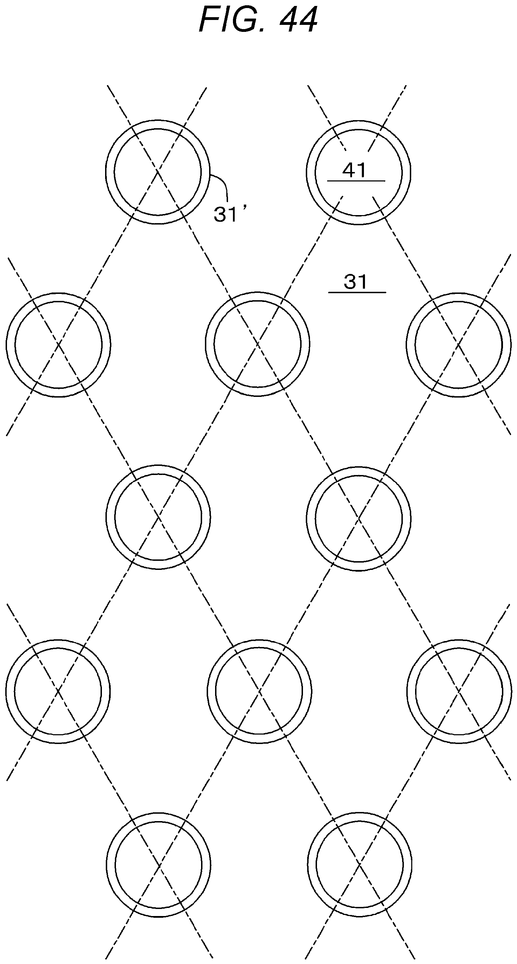

Fig. 44 is a schematic plan view illustrating arrangement of the first light reflecting layer and the first electrode in the light emitting element array including Modification-1 of the light emitting element of Example 19 illustrated in Fig. 43.

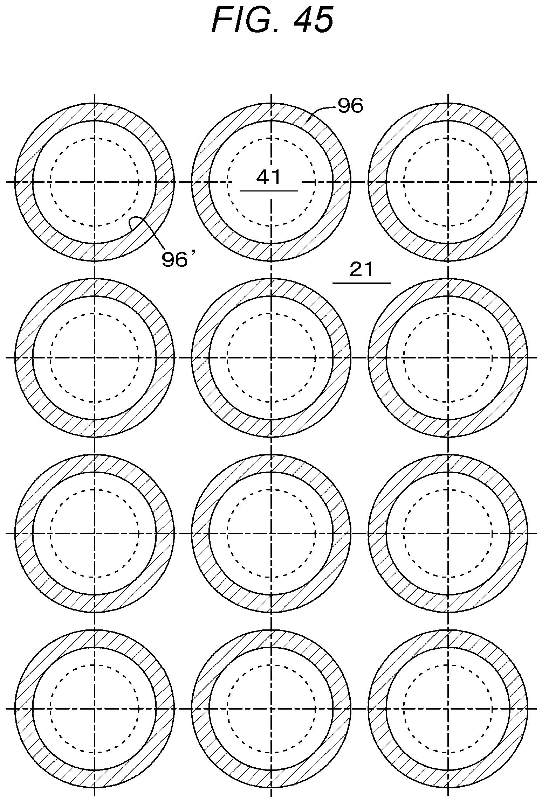

Fig. 45 is a schematic plan view illustrating arrangement of the first light reflecting layer and the partition wall in the light emitting element array including the light emitting elements of Example 19.

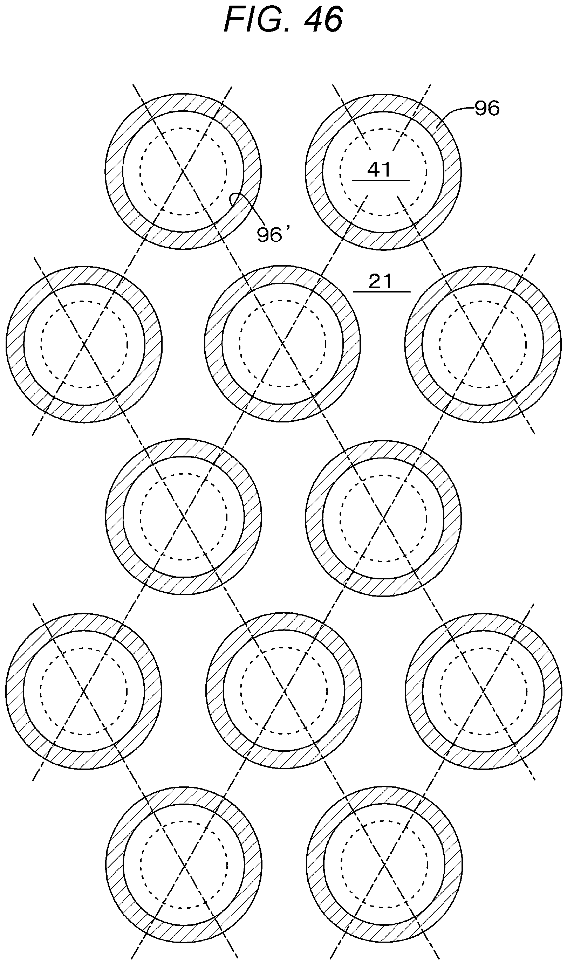

Fig. 46 is a schematic plan view illustrating arrangement of the first light reflecting layer and the first electrode in the light emitting element array including Modification-1 of the light emitting element of Example 19 illustrated in Fig. 45.

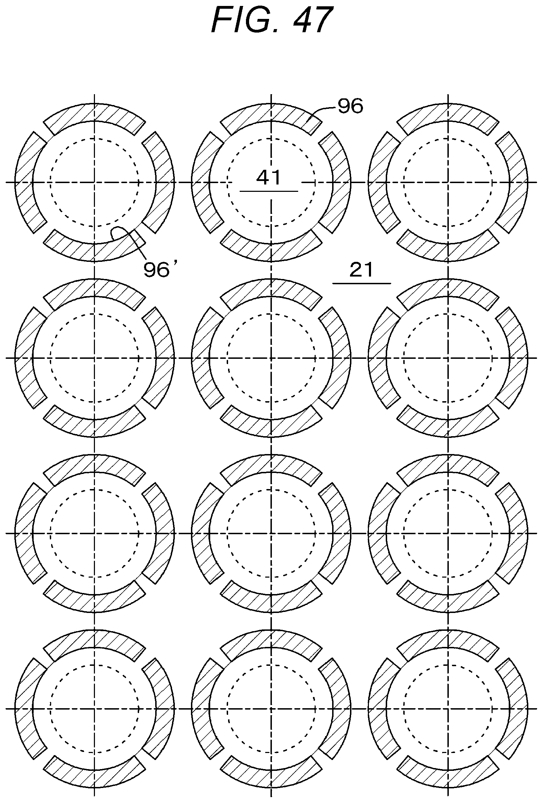

Fig. 47 is a schematic plan view illustrating arrangement of the first light reflecting layer and the partition wall in the light emitting element array including the light emitting elements of Example 19.

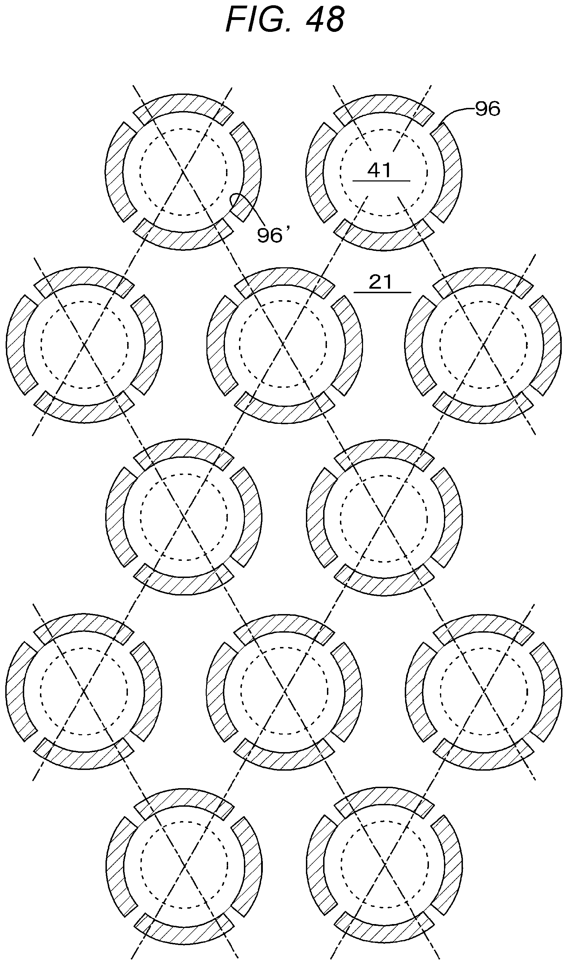

Fig. 48 is a schematic plan view illustrating arrangement of a first light reflecting layer and a first electrode in a light emitting element array including Modification-1 of the light emitting element of Example 19 illustrated in Fig. 47.

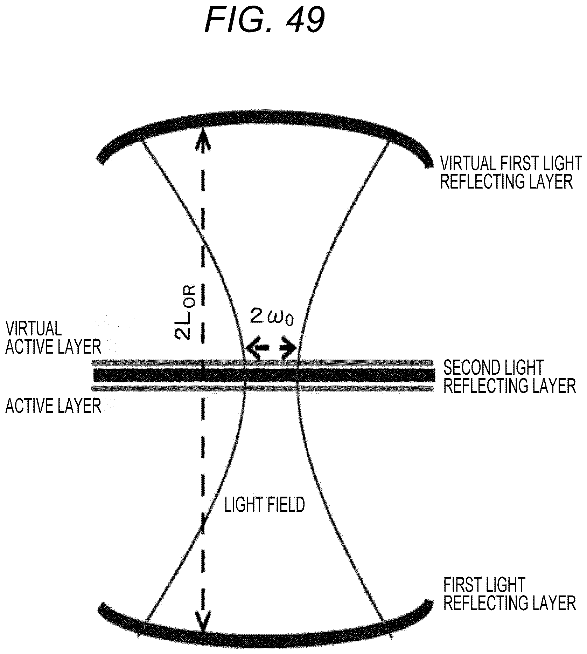

Fig. 49 is a conceptual diagram assuming a Fabry-Perot resonator sandwiched between two concave mirror portions having the same curvature radius.

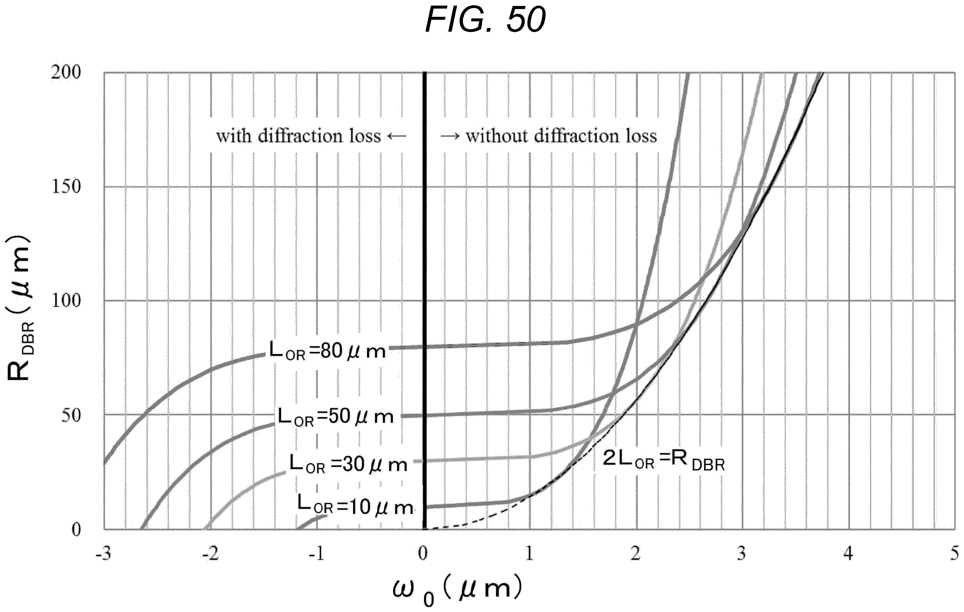

Fig. 50 is a graph illustrating a relationship among a value of $\omega_0$, a value of a resonator length $L_{OR}$, and a value of a curvature radius $R_1(R_{DBR})$ of the concave mirror portion of the first light reflecting layer.

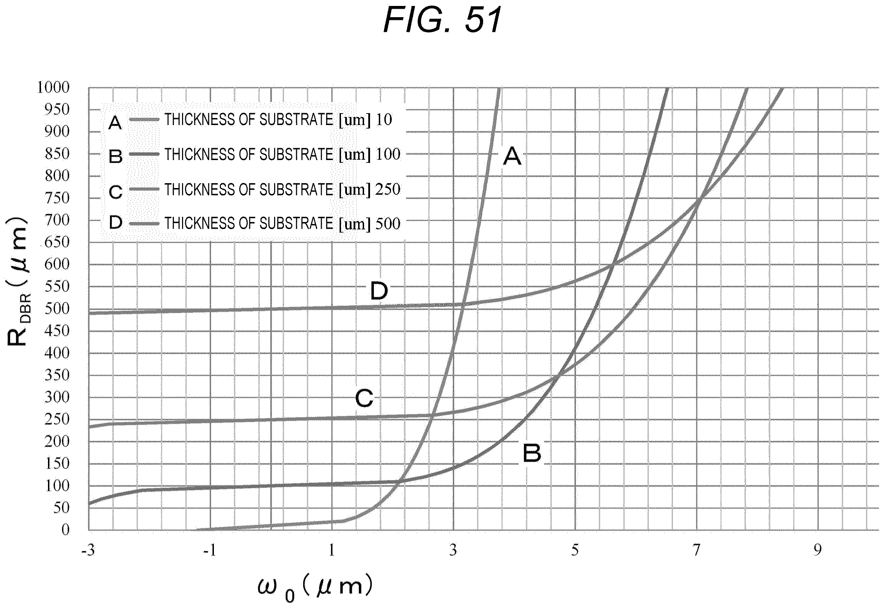

Fig. 51 is a graph illustrating a relationship among the value of $\omega_0$, the value of the resonator length $L_{OR}$, and the value of a curvature radius $R_1(R_{DBR})$ of the concave mirror portion of the first light reflecting layer.

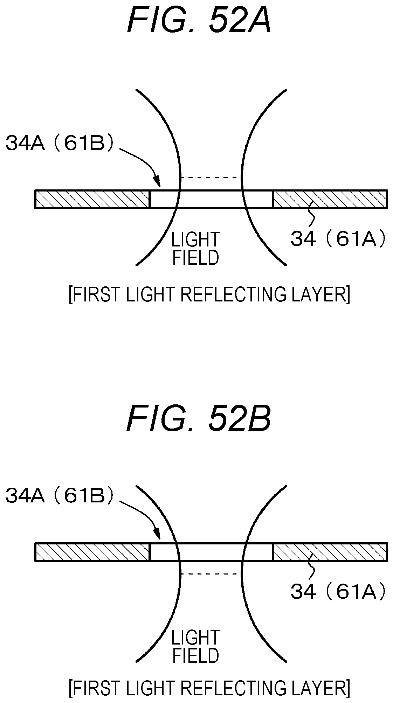

Figs. 52A and 52B are a view schematically illustrating a converging state of a laser beam when the value of $\omega_0$ is "positive" and a view schematically illustrating a converging state of a laser beam when a value of $\omega_0$ is "negative", respectively.

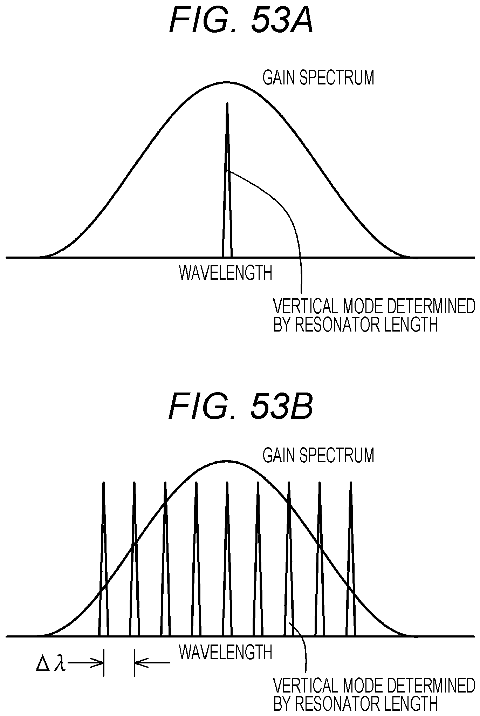

Figs. 53A and 53B are conceptual diagrams schematically illustrating a vertical mode existing in a gain spectrum determined by an active layer.

Fig. 54 is a schematic partial end view of a conventional light emitting element.

## MODE FOR CARRYING OUT THE INVENTION

Hereinafter, the present disclosure will be described based on examples with reference to the drawings, but the present disclosure is not limited to the examples, and various numerical values and materials in the examples are examples. Note that the description will be given in the following order.

1. General description of light emitting elements according to first and second aspects of the present disclosure, and methods for manufacturing light emitting element according to first and second aspects of the present disclosure
2. Example 1 (light emitting element according to first and second aspects of the present disclosure, method for manufacturing light emitting element according to first aspect of the present disclosure, and light emitting element of first configuration)
3. Example 2 (method for manufacturing light emitting element according to second aspect of present disclosure)
4. Example 3 (modification of Examples 1 and 2)
5. Example 4 (another modification of Examples 1 and 2, light emitting element of second configuration)
6. Example 5 (still another modification of Examples 1 and 2, light emitting element of third configuration)
7. Example 6 (modification of Example 5)
8. Example 7 (modifications of Examples 1 to 6)
9. Example 8 (modification of Examples 1 to 7, light emitting element of fourth configuration)
10. Example 9 (modifications of Examples 1 to 8, light emitting element of configuration 5-A)
11. Example 10 (modification of Example 9, light emitting element of configuration 5-B)
12. Example 11 (modifications of Examples 9 and 10, light emitting element of configuration 5-C)
13. Example 12 (modifications of Examples 9 to 11, light emitting element of configuration 5-D)
14. Example 13 (modifications of Examples 9 to 12)
15. Example 14 (modifications of Examples 1 to 13, light emitting element of configuration 6-A, light emitting element of configuration 6-B, light emitting element of configuration 6-C, and light emitting element of configuration 6-D)
16. Example 15 (modifications of Example 1 to Example 14, light emitting element of configuration 7)
17. Example 16 (modification of Example 15)
18. Example 17 (another modification of Example 15)
19. Example 18 (modifications of Examples 15 to 17)
20. Example 19 (modifications of Examples 1 to 18)
21. <Others>

<General description of light emitting elements according to first and second aspects of the present disclosure, and methods for manufacturing light emitting element according to first and second aspects of the present disclosure>

In a method for manufacturing a light emitting element according to a first aspect of the present disclosure, in a protrusion forming step, after a first sacrificial layer having a convex surface is formed on a region where a first region of a base surface is to be formed, etch-back processing is performed from the base surface toward the inside using the first sacrificial layer as an etching mask. Not that, in the protrusion forming step, after a first sacrificial layer/formation layer is formed in the region where the first region of the base surface is to be formed, the first sacrificial layer/formation layer is patterned, and then the patterned first sacrificial layer/formation layer is subjected to heat treatment, whereby the first sacrificial layer having a convex surface can be formed. In some cases, the first sacrificial layer having a convex surface can be formed based on a nanoimprint method. However, the method for forming the first sacrificial layer having a convex surface is not particularly limited to these methods, and it is not essential to form the first sacrificial layer having a convex surface.

In the method of manufacturing a light emitting element according to the first aspect of the present disclosure including the above-described preferable form, in an etch-back step, after a second sacrificial layer is formed a plurality of times, etch-back processing is performed from the base surface toward the inside using the second sacrificial layer as an etching mask.

Furthermore, in the method of manufacturing the light emitting element according to the first aspect of the present disclosure including the preferable form described above, the etch-back step can be repeated so that $\theta_{CA} = \theta_2$. That is, in the etch-back step, a step of forming the second sacrificial layer once or twice or more and then performing etch-back processing from the base surface toward the inside thereof using the second sacrificial layer as the etching mask can be repeated.

Furthermore, in the method for manufacturing a light emitting element according to the second aspect of the present disclosure, in the etch-back step, the second sacrificial layer may be formed a plurality of times, and then etch-back processing is performed from the base surface toward the inside using the second sacrificial layer and the first sacrificial layer as the etching mask.

In the method for manufacturing a light emitting element according to the second aspect of the present disclosure including the preferable form described above, a step of forming the second sacrificial layer on the entire surface after executing the etch-back step, and then performing etch-back processing from the base surface toward the inside using the second sacrificial layer as an etching mask is repeated, so that $\theta_{CA} = \theta_2'$. The number of times of forming the second sacrificial layer on the entire surface may be one or two or more.

Furthermore, in the method for manufacturing a light emitting element according to the second aspect of the present disclosure including the various preferable forms described above, a form in which the first sacrificial layer having a convex surface is formed on the first region of the base surface on which the first light reflecting layer is to be formed can be adopted. In some cases, the first sacrificial layer having a convex surface can be formed based on a nanoimprint method. However, the method for forming the first sacrificial layer having a convex surface is not particularly limited to these methods, and it is not essential to form the first sacrificial layer having a convex surface. The first sacrificial layer and the second sacrificial layer can include an organic material such as a resist material, a ceramic material such as SOG, a semiconductor metal material, and the like.

According to the Young-Dupre law, an angle (contact angle $\theta_E$) formed by a fluid material and a substrate in a case where the fluid material is dropped on a flat substrate can be expressed by the following expression.

$$(\gamma_{so} - \gamma_{sl}) / \gamma = \cos(\theta_E)$$

Here,

$\gamma$ is interface energy (corresponding to surface tension of interface) between fluid and air,
$\gamma_{so}$ is interface energy (surface tension of substrate, corresponding to force for expanding fluid material) between substrate and air, and
$\gamma_{sl}$ is interface energy (surface tension between the substrate and the fluid, corresponding to force for preventing an increase in energy due to expansion of interface between substrate and fluid material) between substrate and fluid. As described above, the contact angle $\theta_E$ between the fluid and the substrate is limited by physical properties of the fluid material and the substrate. In a general system, the contact angle $\theta_E$ rarely becomes 10° or less, and it is not easy to set the complementary angle $\theta_{CA}$ to a smaller value (for example, 10° or less).

In the light emitting element according to the first and second aspects of the present disclosure and the light emitting element manufactured by the method for manufacturing a light emitting element according to the first and second aspects of the present disclosure including the preferable forms described above, a form in which the complementary angle $\theta_{CA}$ is 1° or more and 10° or less, and preferably 1° or more and 6° or less can be adopted.

Specifically, when a second curve is represented by a function $F(X)$, an intersection of the first region (first-B region) and the second region is defined as an origin (0, 0), and a straight line configured by the second region and passing through the origin (0, 0) is defined as an X axis, an angle formed by a tangent of $F(X)$ at the origin (0, 0) and the X axis is $\theta_{CA}$. In some cases, the curve also includes a line segment.

In the light emitting element according to the first aspect of the present disclosure including the preferable form described above, the light emitting element according to the second aspect of the present disclosure, and the light emitting element manufactured by the method for manufacturing a light emitting element according to the first and second aspects of the present disclosure including the preferable form described above (hereinafter, these light emitting elements may be collectively referred to as a "light emitting element and the like of the present disclosure"), a form can be made in which a curvature radius $R_1$ of the top portion of the first region of the base surface is $1.5 \times 10^{-5}$ m or more and $2 \times 10^{-4}$ m or less.

Furthermore, in the light emitting element and the like of the present disclosure including the above-described preferable form, a form in which a height (arrow height) $H_1$ of the first region with respect to the flat surface of the second region is 1 $\mu$m or more and 5 $\mu$m or less can be adopted.

Furthermore, in the light emitting element and the like of the present disclosure including the preferable form described above, when the curvature radius of the top portion of the first region (first-A region) of the base surface is $R_1$ and the resonator length of the light emitting element is $L_{OR}$, a form can be made in which

$$1 \leq R_1/L_{OR} \leq 10$$

is satisfied.

Furthermore, in the light emitting element and the like of the present disclosure including the preferable form described above, a form in which the diameter $D_1$ of the first region of the base surface is $3 \times 10^{-6}$ m or more and $1 \times 10^{-4}$ m or less can be adopted. Note that, in a case where the planar shape of the first region of the base surface is other than a circle, when an area of the first region of the base surface is "S",

$D_1$ defined by

$$S = \pi \ (D_1/2)^2$$

is the diameter. Furthermore, the diameter $D_1'$ of the first-A region of the base surface can be $2 \times 10^{-6}$ m or more and $9 \times 10^{-5}$ m or less, and

$$0.1 \leq D_1'/D_1 \leq 1$$

is preferably satisfied.

Furthermore, in the light emitting element and the like of the present disclosure including the preferable form described above, when the resonator length is $L_{OR}$, $1 \times 10^{-5}$ m $\leq L_{OR}$ is preferably satisfied.

In the light emitting element and the like of the present disclosure, "smooth" is an analytical term. For example, when a real variable function f(x) can be differentiated in a < x < b and f'(x) is continuous, it can be said that the real variable function f(x) can be continuously differentiated in terms of words and is expressed as being smooth.

In the light emitting element and the like of the present disclosure, the first light reflecting layer is formed at least in the first-A region of the base surface, but an extending portion of the first light reflecting layer may be formed in the first-B region of the base surface, or the first light reflecting layer may not be formed in the first-B region. Furthermore, in a case where the extending portion of the first light reflecting layer is formed in the first-B region of the base surface, the extending portion of the first light reflecting layer may be formed in the second region of the base surface occupying the peripheral region, or the extending portion of the first light reflecting layer may not be formed in the second region.

Furthermore, in the light emitting element and the like of the present disclosure including the preferable forms described above, a form in which the first surface of the first compound semiconductor layer constitutes the base surface can be adopted. The light emitting element having such a configuration is referred to as a "first configuration" for convenience. Alternatively, a compound semiconductor substrate may be disposed between the first surface of the first compound semiconductor layer and the first light reflecting layer, and the base surface may be constituted by the surface of the compound semiconductor substrate. The light emitting element having such a configuration is referred to as a "light emitting element of the second configuration" for convenience. In this case, for example, the compound semiconductor substrate may include a GaN substrate. As the GaN substrate, any of a polar substrate, a semi-polar substrate, and a non-polar substrate may be used. As the thickness of the compound semiconductor substrate, $5 \times 10^{-5}$ m to $1 \times 10^{-4}$ m can be exemplified, but the thickness is not limited to such a value. Alternatively, a base material may be disposed between the first surface of the first compound semiconductor layer and the first light reflecting layer, or the compound semiconductor substrate and the base material may be disposed between the first surface of the first compound semiconductor layer and the first light reflecting layer, and the base surface may be constituted by the surface of the base material. The light emitting element having such a configuration is referred to as a "light emitting element of the third configuration" for convenience. Examples of the material constituting the base material include transparent dielectric materials such as $TiO_2$, $Ta_2O_5$, and $SiO_2$, silicone-based resins, and epoxy-based resins.

In the light emitting element and the like of the present disclosure including the preferable form described above, in the material constituting various compound semiconductor layers (including the compound semiconductor substrate) located between the active layer and the first light reflecting layer, it is preferable that there is no modulation of the refractive index of 10% or more (there is no refractive index difference of 10% or more based on the average refractive index of the laminated structure), and this can suppress the occurrence of disturbance of the light field in the resonator.

Furthermore, in the light emitting element and the like of the present disclosure including the preferable form described above, a value of the thermal conductivity of the laminated structure can be higher than a value of thermal conductivity of the first light reflecting layer. The value of the thermal conductivity of the dielectric material constituting the first light reflecting layer is generally about 10 watts/(m·K) or less. Meanwhile, a value of thermal conductivity of the GaN-based compound semiconductor constituting the laminated structure is about 50 watts/(m·K) to 100 watts/(m·K).

In the light emitting element and the like of the present disclosure including the preferable form described above, a figure (first curve) drawn by the first-A region when the first-A region is cut along a virtual plane including a lamination direction of the laminated structure can be a part of a circle, a part of a parabola, a part of a sine curve, a part of an ellipse, and a part of a catenary curve. The figure may not strictly be a part of a circle, may not strictly be a part of a parabola, may not strictly be a part of a sine curve, may not strictly be a part of an ellipse, or may not strictly be a part of a catenary curve. That is, the case of being substantially a part of a circle, the case of being substantially a part of a parabola, the case of being substantially a part of a sine curve, the case of being substantially a part of an ellipse, and the case of being substantially a part of a catenary curve are also included in the case of "the figure is a part of a circle, a part of a parabola, a part of a sine curve, substantially a part of an ellipse, and substantially a part of a catenary curve". The figure drawn by the first-A region or the first-B region can be obtained by measuring the shape of the first-A region or the first-B region with a measuring instrument and analyzing the obtained data based on the least square method.

The second curve includes at least one kind of figure selected from the group consisting of a combination of a downwardly convex curve, a line segment, and an arbitrary curve. Specifically, the "downwardly convex curve" can be a curve (configuration to be a part of a circle, a part of a parabola, a part of a sine curve, a part of an ellipse, a part of a catenary curve) similar to the first curve described above. Furthermore, the "combination of arbitrary curves" also includes a line segment and an upwardly convex curve.

A connection portion between the first curve and the second curve, or the connection portion such as a plurality of curves in a case where the second curve is configured by a plurality of curves and the like may be continuous or smooth in terms of analysis (that is, it may be differentiable), may be discontinuous in terms of analysis, or the connection portion may not be smooth in terms of analysis (that is, differentiation may be impossible).

When the "downwardly convex curve" is represented by [A], the line segment is represented by [B], the combination of arbitrary curves is represented by [C], and "=>" means "connected" (connection portion), the following combinations can be exemplified as a combination of the first curve and the second curve.

    (1) First curve => [A]
    (2) First curve => [B]
    (3) First curve => [C]
    (4) First curve => any one of [A, B, C] => any one of [A, B, C]
    (5) First curve => any one of [A, B, C] => any one of [A, B, C] => any one of [A, B, C]

For example, in the case of the above (4), it means that the first curve is connected to any one of combinations of the downwardly convex curve, the line segment, and the arbitrary curve, and any one of the combinations of the downwardly convex curve, the line segment, and the arbitrary curve is further connected to any one of the combinations of the downwardly convex curve, the line segment, and the arbitrary curve (however, the curves are not the same).

With the light emitting element and the like of the present disclosure including the preferable forms described above, a surface emitting laser element (Vertical Cavity Laser, VCSEL) that emits a laser beam via the first light reflecting layer can be configured, or a surface emitting laser element that emits a laser beam via the second light reflecting layer can be configured. In some cases, a substrate (described later) for manufacturing a light emitting element may be removed.

In the light emitting element array in which a plurality of the light emitting elements and the like of the present disclosure including the preferable form described above are arranged, it is desirable that a formation pitch (distance from axis of first light reflecting layer constituting light emitting element to axis of first light reflecting layer constituting adjacent light emitting element) of the light emitting elements is 3 $\mu$m or more and 50 $\mu$m or less, preferably 5 $\mu$m or more and 30 $\mu$m or less, and more preferably 8 $\mu$m or more and 25 $\mu$m or less. Furthermore, in the light emitting element array, a center portion (top portion) of the first light reflecting layer of each light emitting element may be located on a vertex (intersection) of the square lattice, or may be located on a vertex (intersection) of a regular triangular lattice, although not limited.

Furthermore, in the light emitting element and the like of the present disclosure including the preferable forms described above, the laminated structure can include at least one material selected from the group consisting of a GaN-based compound semiconductor, an InP-based compound semiconductor, and a GaAs-based compound semiconductor. Specifically, the laminated structure can include

(a) configuration including GaN-based compound semiconductor,
(b) configuration including InP-based compound semiconductor,
(c) configuration including GaAs-based compound semiconductor,
(d) configuration including GaN-based compound semiconductor and InP-based compound semiconductor,
(e) configuration including GaN-based compound semiconductor and GaAs-based compound semiconductor,
(f) configuration including InP-based compound semiconductor and GaAs-based compound semiconductor, and
(g) configuration including GaN-based compound semiconductor, InP-based compound semiconductor, and GaAs-based compound semiconductor.

In the light emitting element and the like of the present disclosure, more specifically, the laminated structure can include, for example, an AlInGaN-based compound semiconductor. Here, more specific examples of the AlInGaN-based compound semiconductor include GaN, AlGaN, InGaN, and AlInGaN. Furthermore, these compound semiconductors may contain a boron (B) atom, a thallium (Tl) atom, an arsenic (As) atom, a phosphorus (P) atom, or an antimony (Sb) atom as desired. The active layer desirably has a quantum well structure. Specifically, the active layer may have a single quantum well structure (SQW structure) or a multiple quantum well structure (MQW structure). The active layer having a quantum well structure has a structure in which at least one well layer and one barrier layer are laminated, and examples of the combination of (compound semiconductor constituting well layer and compound semiconductor constituting barrier layer) include $(In_yGa_{(1-y)}N, GaN)$, $(In_yGa_{(1-y)}N, In_zGa_{(1-z)}N)$ [where y > z], and $(In_yGa_{(1-y)}N, AlGaN)$. The first compound semiconductor layer may include a compound semiconductor of a first conductivity type (for example, n-type), and the second compound semiconductor layer may include a compound semiconductor of a second conductivity type (for example, p-type) different from the first conductivity type. The first compound semiconductor layer and the second compound semiconductor layer are also referred to as a first cladding layer and a second cladding layer. The first compound semiconductor layer and the second compound semiconductor layer may be a single structure layer, a multi-layer structure layer, or a superlattice structure layer. Furthermore, a layer including a composition gradient layer and a concentration gradient layer can also be used.

Alternatively, examples of the group III atoms constituting the laminated structure can include gallium (Ga), indium (In), and aluminum (Al), and examples of the group V atoms constituting the laminated structure can include arsenic (As), phosphorus (P), antimony (Sb), and nitrogen (N). Specific examples thereof include AlAs, GaAs, AlGaAs, AlP, GaP, GaInP, AlInP, AlGaInP, AlAsP, GaAsP, AlGaAsP, AlInAsP, GaInAsP, AlInAs, GaInAs, AlGaInAs, AlAsSb, GaAsSb, AlGaAsSb, AlN, GaN, InN, AlGaN, GaNAs, and GaInNAs, and specific examples of the compound semiconductor constituting the active layer include GaAs, AlGaAs, GaInAs, GaInAsP, GaInP, GaSb, GaAsSb, GaN, InN, GaInN, GaInN, GaInNAs, and GaInNAsSb.

Examples of the quantum well structure include a two-dimensional quantum well structure, a one-dimensional quantum well structure (quantum fine wire), and a zero-dimensional quantum well structure (quantum dot). Examples of a material constituting the quantum well can include Si; Se; CIGS(CuInGaSe), CIS(CuInSe_2), CuInS_2, CuAlS_2, and CuAlSe_2, CuGaS_2, CuGaSe_2, AgAlS_2, AgAlSe_2, AgInS_2, and AgInSe_2 which are chalcopyrite-based compounds; Perovskite-based material; GaAs, GaP, InP, AlGaAs, InGaP, AlGaInP, InGaAsP, GaN, InAs, InGaAs, GaInNAs, GaSb, and GaAsSb which are Group III-V compounds; CdSe, CdSeS, CdS, CdTe, $In_2Se_3$, $In_2S_3$, $Bi_2Se_3$, $Bi_2S_3$, ZnSe, ZnTe, ZnS, HgTe, HgS, PbSe, PbS, and $TiO_2$, and the like, but are not limited thereto.

The laminated structure is formed on the second surface of the substrate for manufacturing a light emitting element or formed on the second surface of the compound semiconductor substrate. Not that the second surface of the substrate for manufacturing a light emitting element or the compound semiconductor substrate faces the first surface of the first compound semiconductor layer, and the first surface of the substrate for manufacturing a light emitting element or the compound semiconductor substrate faces the second surface of the substrate for manufacturing a light emitting element. Examples of the substrate for manufacturing a light emitting element include a GaN substrate, a sapphire substrate, a GaAs substrate, a SiC substrate, an alumina substrate, a ZnS substrate, a ZnO substrate, an AlN substrate, a LiMgO substrate, a $LiGaO_2$ substrate, a $MgAl_2O_4$ substrate, an InP substrate, a Si substrate, and a substrate in which an underlayer or a buffer layer is formed on the surface (main surface) of these substrates, but the use of a GaN substrate is preferable because of low defect density. Furthermore, examples of the compound semiconductor substrate include a GaN substrate, an InP substrate, and a GaAs substrate. Although it is known that characteristics of a GaN substrate vary depending on a growth surface, such as polarity/non-polarity/semi-polarity, any main surface (second surface) of the GaN substrate can be used for formation of a compound semiconductor layer. Furthermore, regarding the main surface of the GaN substrate, depending on the crystal structure (for example, a cubic crystal type, a hexagonal crystal type, and the like), a crystal plane orientation called a so-called A plane, B plane, C plane, R plane, M plane, N plane, S plane, and the like, or a plane in which these are turned off in a specific direction can also be used. Examples of a method for forming various compound semiconductor layers constituting the light emitting element include, but are not limited to, a metal organic chemical vapor deposition method (MOCVD method), a metal organic chemical vapor deposition method (MOVPE method), a molecular beam epitaxy method (MBE method), a hydride vapor phase epitaxy method (HVPE method) in which halogen contributes to transport or reaction, an atomic layer deposition method (ALD method), a migration enhanced epitaxy method (MEE method), a plasma-assisted physical vapor deposition method (PPD method), and the like.

The GaAs and InP materials also have a zinc blende structure. Examples of the main surface of the compound semiconductor substrate including these materials include surfaces turned off in a specific direction in addition to surfaces such as (100), (111)AB, (211)AB, and (311)AB. Note that "AB" means that the 90° off direction is different, and whether the main material of the surface is group III or group V is determined by the off direction. By controlling these crystal plane orientation and film formation conditions, composition unevenness and dot shape can be controlled. As a film forming method, a film forming method such as an MBE method, an MOCVD method, an MEE method, or an ALD method is generally used as with the GaN-based method, but the film forming method is not limited to these methods.

Here, in the formation of the GaN-based compound semiconductor layer, examples of the organic gallium source gas in the MOCVD method include a trimethylgallium (TMG) gas and a triethylgallium (TEG) gas, and examples of the nitrogen source gas include an ammonia gas and a hydrazine gas. In formation of a GaN-based compound semiconductor layer having an n-type conductivity type, for example, silicon (Si) may be added as an n-type impurity (n-type dopant), and in formation of a GaN-based compound semiconductor layer having a p-type conductivity type, for example, magnesium (Mg) may be added as a p-type impurity (p-type dopant). In a case where aluminum (Al) or indium (In) is contained as a constituent atom of the GaN-based compound semiconductor layer, a trimethylaluminum (TMA) gas may be used as an Al source, and a trimethylindium (TMI) gas may be used as an In source. Further, a monosilane gas ($SiH_4$ gas) may be used as the Si source, and a biscyclopentadienyl magnesium gas, methylcyclopentadienyl magnesium, or biscyclopentadienyl magnesium ($Cp_2Mg$) may be used as the Mg source. Note that examples of the n-type impurity (n-type dopant) can include Ge, Se, Sn, C, Te, S, O, Pd, and Po in addition to Si, and examples of the p-type impurity (p-type dopant) can include Zn, Cd, Be, Ca, Ba, C, Hg, and Sr in addition to Mg.

In a case where the laminated structure includes an InP-based compound semiconductor or a GaAs-based compound semiconductor, TMGa, TEGa, TMIn, TMAl, and the like, which are organic metal raw materials, are generally used as the group III raw material. Furthermore, as the group V raw material, an alkyne gas ($AsH_3$ gas), a phosphine gas ($PH_3$ gas), ammonia ($NH_3$), and the like are used. Note that, as the group V raw material, an organometallic raw material may be used, and examples thereof can include tertiary-butylarsine (TBAs), tertiary-butylphosphine (TBP), dimethylhydrazine (DMHy), trimethylantimony (TMSb), and the like. These materials are effective in low-temperature growth because they decompose at low temperatures. As the n-type dopant, monosilane ($SiH_4$) is used as a Si source, hydrogen selenide ($H_2Se$) is used as a Se source, and the like. Furthermore, dimethyl zinc (DMZn), biscyclopentadienyl magnesium ($Cp_2Mg$), and the like are used as the p-type dopant. As the dopant material, a material similar to a GaN-based material is a candidate.

The laminated structure is formed on the second surface of the substrate for manufacturing a light emitting element or formed on the second surface of the compound semiconductor substrate. Not that the second surface of the substrate for manufacturing a light emitting element or the compound semiconductor substrate faces the first surface of the first compound semiconductor layer, and the first surface of the substrate for manufacturing a light emitting element or the compound semiconductor substrate faces the second surface of the substrate for manufacturing a light emitting element. Examples of the substrate for manufacturing a light emitting element include a GaN substrate, a sapphire substrate, a GaAs substrate, a SiC substrate, an alumina substrate, a ZnS substrate, a ZnO substrate, an AlN substrate, a LiMgO substrate, a $LiGaO_2$ substrate, a $MgAl_2O_4$ substrate, an InP substrate, a Si substrate, and a substrate in which an underlayer or a buffer layer is formed on the surface (main surface) of these substrates, but the use of a GaN substrate is preferable because of low defect density. Furthermore, examples of the compound semiconductor substrate include a GaN substrate, an InP substrate, and a GaAs substrate. Although it is known that characteristics of a GaN substrate vary depending on a growth surface, such as polarity/non-polarity/semi-polarity, any main surface (second surface) of the GaN substrate can be used for formation of a compound semiconductor layer. Furthermore, regarding the main surface of the GaN substrate, depending on the crystal structure (for example, a cubic crystal type, a hexagonal crystal type, and the like), a crystal plane orientation called a so-called A plane, B plane, C plane, R plane, M plane, N plane, S plane, and the like, or a plane in which these are turned off in a specific direction can also be used. Examples of a method for forming various compound semiconductor layers constituting the light emitting element include, but are not limited to, a metal organic chemical vapor deposition method (MOCVD method), a metal organic chemical vapor deposition method (MOVPE method), a molecular beam epitaxy method (MBE method), a hydride vapor phase epitaxy method (HVPE method) in which halogen contributes to transport or reaction, an atomic layer deposition method (ALD method), a migration enhanced epitaxy method (MEE method), a plasma-assisted physical vapor deposition method (PPD method), and the like.

In the manufacture of the light emitting element and the like of the present disclosure, the substrate for manufacturing a light emitting element may be left, or the substrate for manufacturing a light emitting element may be removed after sequentially forming the active layer, the second compound semiconductor layer, the second electrode, and the second light reflecting layer on the first compound semiconductor layer. Specifically, the active layer, the second compound semiconductor layer, the second electrode, and the second light reflecting layer may be sequentially formed on the first compound semiconductor layer, and then the second light reflecting layer may be fixed to the support substrate, and then the substrate for manufacturing a light emitting element may be removed to expose the first compound semiconductor layer (the first surface of the first compound semiconductor layer). The substrate for manufacturing a light emitting element can be removed by a wet etching method using an alkali aqueous solution such as a sodium hydroxide aqueous solution or a potassium hydroxide aqueous solution, an ammonia solution + a hydrogen peroxide solution, a sulfuric acid solution + a hydrogen peroxide solution, a hydrochloric acid solution + a hydrogen peroxide solution, a phosphoric acid solution + a hydrogen peroxide solution, and the like, a dry etching method such as a chemical mechanical polishing method (CMP method), a mechanical polishing method, or a reactive ion etching (RIE) method, a lift-off method using a laser, and the like, or a combination thereof.

The support substrate may include, for example, various substrates exemplified as a substrate for manufacturing a light emitting element, or may include an insulating substrate including AlN and the like, a semiconductor substrate including Si, SiC, Ge and the like, a metal substrate, or an alloy substrate, but it is preferable to use a substrate having conductivity, or it is preferable to use a metal substrate or an alloy substrate from the viewpoint of mechanical characteristics, elastic deformation, plastic deformation, heat dissipation, and the like. The thickness of the support substrate can be, for example, 0.05 mm to 1 mm. As a method for fixing the second light reflecting layer to the support substrate, a known method such as a solder bonding method, a normal temperature bonding method, a bonding method using an adhesive tape, a bonding method using wax bonding, or a method using an adhesive can be used, but from the viewpoint of ensuring conductivity, it is desirable to adopt a solder bonding method or a normal temperature bonding method. For example, in a case where a silicon semiconductor substrate that is a conductive substrate is used as a support substrate, it is desirable to adopt a method capable of bonding at a low temperature of 400°C or lower in order to suppress warpage due to a difference in thermal expansion coefficient. In a case where a GaN substrate is used as the support substrate, the bonding temperature may be 400°C or higher.

The first electrode electrically connected to the first compound semiconductor layer may be common to the plurality of light emitting elements, and the second electrode electrically connected to the second compound semiconductor layer may be common to the plurality of light emitting elements, or may be individually provided in the plurality of light emitting elements.

In a case where the substrate for manufacturing a light emitting element is left, the first electrode may be formed on the first surface facing the second surface of the substrate for manufacturing a light emitting element, or may be formed on the first surface facing the second surface of the compound semiconductor substrate. Furthermore, in a case where the substrate for manufacturing a light emitting element is not left, the substrate may be formed on the first surface of the first compound semiconductor layer constituting the laminated structure. Note that, in this case, since the first light reflecting layer is formed on the first surface of the first compound semiconductor layer, for example, the first electrode may be formed so as to surround the first light reflecting layer. The first electrode desirably has a single-layer configuration or a multi-layer configuration including at least one metal (including an alloy) selected from the group consisting of, for example, gold (Au), silver (Ag), palladium (Pd), platinum (Pt), nickel (Ni), Ti (titanium), vanadium (V), tungsten (W), chromium (Cr), Al (aluminum), Cu (copper), Zn (zinc), tin (Sn), and indium (In), and specifically, for example, Ti/Au, Ti/Al, Ti/Al/Au, Ti/Pt/Au, Ni/Au, Ni/Au/Pt, Ni/Pt, Pd/Pt, and Ag/Pd can be exemplified. Note that the layer before "/" in the multi-layer configuration is located closer to the active layer side. The above similarly applies to the following description. The first electrode can be formed by, for example, a PVD method such as a vacuum vapor deposition method or a sputtering method.

In a case where the first electrode is formed so as to surround the first light reflecting layer, the first light reflecting layer and the first electrode may be in contact with each other. Alternatively, the first light reflecting layer and the first electrode may be separated from each other. In some cases, a state in which the first electrode is formed up to an edge portion of the first light reflecting layer and a state in which the first light reflecting layer is formed up to an edge portion of the first electrode can be mentioned.

Specific examples of the planar shape of the first light reflecting layer, the first region, the first-A region, the first-B region, and the second light reflecting layer can include a circle, an ellipse, an ellipse, a rectangle, and a regular polygon (regular triangle, square, regular hexagon, and the like).

The second electrode may include a transparent conductive material. Examples of the transparent conductive material constituting the second electrode can include an indium-based transparent conductive material [specifically, for example, indium tin oxide (including ITO, Indium Tin Oxide, Sn-doped $In_2O_3$, crystalline ITO and amorphous ITO), indium-zinc oxide (IZO), indium-gallium oxide (IGO), indium-doped gallium-zinc oxide (IGZO, In-GaZnO$_4$), IFO (F-doped $In_2O_3$), ITiO (Ti-doped $In_2O_3$), InSn, InSnZnO], a tin-based transparent conductive material [specifically, for example, tin oxide (SnOx), ATO (Sb-doped $SnO_2$), and FTO (F-doped $SnO_2$)], a zinc-based transparent conductive material [specifically, for example, zinc oxide (including ZnO, Al-doped ZnO (AZO) and B-doped ZnO), gallium-doped zinc oxide (GZO), AlMgZnO (aluminum oxide and magnesium oxide-doped zinc oxide)], NiO, TiOx, and graphene. Alternatively, examples of the second electrode include a transparent conductive film having gallium oxide, titanium oxide, niobium oxide, antimony oxide, nickel oxide, and the like as a base layer, and also include a transparent conductive material such as a spinel-type oxide or an oxide having a $YbFe_2O_4$ structure. However, the material constituting the second electrode depends on the arrangement state of the second light reflecting layer and the second electrode, but is not limited to the transparent conductive material, and metals such as palladium (Pd), platinum (Pt), nickel (Ni), gold (Au), cobalt (Co), and rhodium (Rh) can also be used. The second electrode may include at least one of these materials. The second electrode can be formed by, for example, a PVD method such as a vacuum vapor deposition method or a sputtering method. Alternatively, a low-resistance semiconductor layer can be used as the transparent electrode layer, and in this case, specifically, an n-type GaN-based compound semiconductor layer can also be used. Furthermore, in a case where the layer adjacent to the n-type GaN-based compound semiconductor layer is p-type, the electrical resistance of the interface can be reduced by bonding both via a tunnel junction. When the second electrode includes a transparent conductive material, the current can be expanded in the lateral direction (in-plane direction of the second compound semiconductor layer), and the current can be efficiently supplied to the current injection region (described later).

A first pad electrode and a second pad electrode may be provided on the first electrode and the second electrode in order to be electrically connected to an external electrode or circuit (hereinafter, it may be referred to as an "external circuit and the like"). The pad electrode desirably has a single-layer configuration or a multi-layer configuration containing at least one metal selected from the group consisting of Ti (titanium), aluminum (Al), Pt (platinum), Au (gold), Ni (nickel), and Pd (palladium). Alternatively, the pad electrode may have a multi-layer configuration exemplified by a Ti/Pt/Au multi-layer configuration, a Ti/Au multi-layer configuration, a Ti/Pd/Au multi-layer configuration, a Ti/Pd/Au multi-layer configuration, a Ti/Ni/Au multi-layer configuration, and a Ti/Ni/Au/Cr/Au multi-layer configuration. In a case where the first electrode includes an Ag layer or an Ag/Pd layer, it is preferable that a cover metal layer including, for example, Ni/TiW/Pd/TiW/Ni is formed on the surface of the first electrode, and a pad electrode including, for example, a multi-layer structure of Ti/Ni/Au or a multi-layer structure of Ti/Ni/Au/Cr/Au is formed on the cover metal layer.

The light reflecting layer (Distributed Bragg Reflector Layer, DBR Layer) constituting the first light reflecting layer and the second light reflecting layer is constituted by, for example, a semiconductor multi-layer film or a dielectric multi-layer film. Examples of the dielectric material include oxides such as Si, Mg, Al, Hf, Nb, Zr, Sc, Ta, Ga, Zn, Y, B, and Ti, nitrides (for example, SiNx, AlN$_X$, AlGaNx, GaNx, BNx, and the like), and fluorides. Specifically, SiOx, TiOx, NbOx, ZrOx, TaOx, ZnOx, AlOx, HfOx, SiN$_X$, AlN$_X$, and the like can be exemplified. Then, the light reflecting layer can be obtained by alternately laminating two or more kinds of dielectric films including dielectric materials having different refractive indexes among these dielectric materials. For example, a multi-layer film such as SiOx/SiNy, SiOx/TaOx, SiO$_X$/NbO$_Y$, SiO$_X$/ZrO$_Y$, or SiO$_X$/AlN$_Y$ is preferable. In order to obtain a desired light reflectance, a material constituting each dielectric film, a film thickness, the number of laminated layers, and the like may be appropriately selected. The thickness of each dielectric film can be appropriately adjusted depending on the material to be used and the like, and is determined by an oscillation wavelength (emission wavelength) $\lambda_0$ and the refractive index n at the oscillation wavelength $\lambda_0$ of the material to be used. Specifically, an odd multiple of $\lambda_0/(4n)$ is preferable. For example, in a case where the light reflecting layer includes SiO$_X$/NbO$_Y$ in a light emitting element having an oscillation wavelength $\lambda_0$ of 410 nm, the light reflecting layer may have a wavelength of about 40 nm to 70 nm. The number of laminated layers may be 2 or more, and preferably about 5 to 20. The thickness of the entire light reflecting layer can be, for example, about 0.6 $\mu$m to 1.7 $\mu$m. Furthermore, the light reflectance of the light reflecting layer is desirably 95% or more. The size and shape of the light reflecting layer are not particularly limited as long as the light reflecting layer covers a current injection region or an element region (these will be described later).

The light reflecting layer can be formed based on a known method, and specifically, for example, the method can include a PVD method such as a vacuum vapor deposition method, a sputtering method, a reactive sputtering method, an ECR plasma sputtering method, a magnetron sputtering method, an ion beam assisted vapor deposition method, an ion plating method, or a laser ablation method; various CVD methods; application methods such as a spray method, a spin coating method, and a dipping method; methods of combining two or more of these methods; and a method of combining these methods with any one or more of whole or partial pretreatments, irradiation of inert gas (Ar, He, Xe, and the like) or plasma, irradiation of oxygen gas or ozone gas, plasma, oxidation treatment (heat treatment), and exposure treatment.

A current injection region is provided to regulate current injection into the active layer. Specific examples of a shape of a boundary between a current injection region and a current non-injection/inner region, a shape of a boundary between the current non-injection/inner region and a current non-injection/outer region, and a planar shape of an opening portion provided in the element region or the current confinement region can include a circle, an ellipse, an ellipse, a rectangle, and a regular polygon (regular triangle, square, regular hexagon, and the like). The shape of the boundary between the current injection region and the current non-injection/inner region and the shape of the boundary between the current non-injection/inner region and the current non-injection/outer region are desirably similar or approximate. Here, the "element region" refers to a region into which a narrowed current is injected, a region in which light is confined due to a refractive index difference and the like, a region where laser oscillation occurs in a region sandwiched between the first light reflecting layer and the second light reflecting layer, or a region actually contributing to laser oscillation in a region sandwiched between the first light reflecting layer and the second light reflecting layer.

In the light emitting element and the like of the present disclosure, a bump may be disposed on the second surface (the exposed surface of the light emitting element on the second light reflecting layer side) of the light emitting element. Examples of the bump include a gold (Au) bump, a solder bump, and an indium (In) bump, and a method for disposing the bump can be a known method. Specifically, the bump is provided on the second pad electrode provided on the second electrode, or is provided on an extending portion of the second pad electrode. Alternatively, a brazing material may be used instead of the bump. For example, as the brazing material, brazing materials (subscripts all represent atom%) such as In (indium: melting point: 157°C); Indium-gold-based low melting point alloy; Tin(Sn)-based high-temperature solder such as $Sn_{80}Ag_{20}$ (melting point: 220 to 370°C) and $Sn_{95}Cu_5$ (melting point: 227 to 370°C); Lead (Pb)-based high-temperature solder such as $Pb_{97.5}Ag_{2.5}$ (melting point: 304°C), $Pb_{94.5}Ag_{5.5}$ (melting point: 304 to 365°C), and $Pb_{97.5}Ag_{1.5}Sn_{1.0}$ (melting point: 309°C); Zinc(Zn)-based high-temperature solder such as $Zn_{95}Al_5$ (melting point: 380°C); Tin-lead-based standard solder such as $Sn_5Pb_{95}$ (melting point: 300 to 314°C) and $Sn_2Pb_{98}$ (melting point: 316 to 322°C); and $Au_{88}Ga_{12}$ (melting point: 381°C) can be exemplified.

A side surface or an exposed surface of the laminated structure may be covered with a covering layer (insulating film). The covering layer (insulating film) can be formed based on a known method. A refractive index of a material constituting the covering layer (insulating film) is preferably smaller than a refractive index of a material constituting the laminated structure. Examples of the material constituting the covering layer (insulating film) can include SiOx-based materials including $SiO_2$, $SiN_X$-based materials, $SiO_YN_Z$-based materials, TaOx, ZrOx, $AlN_X$, $AlO_X$, and GaOx, or organic materials such as polyimide-based resins. Examples of a method for forming the covering layer (insulating film) include a PVD method such as a vacuum vapor deposition method or a sputtering method, a CVD method, and the covering layer (insulating film) can be formed based on a coating method.

[Example 1]

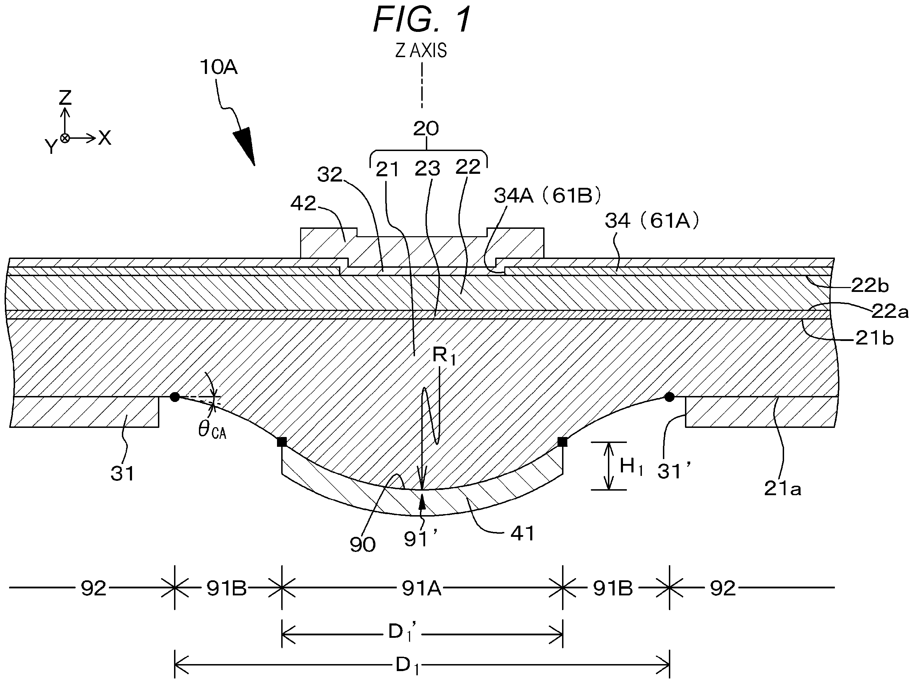

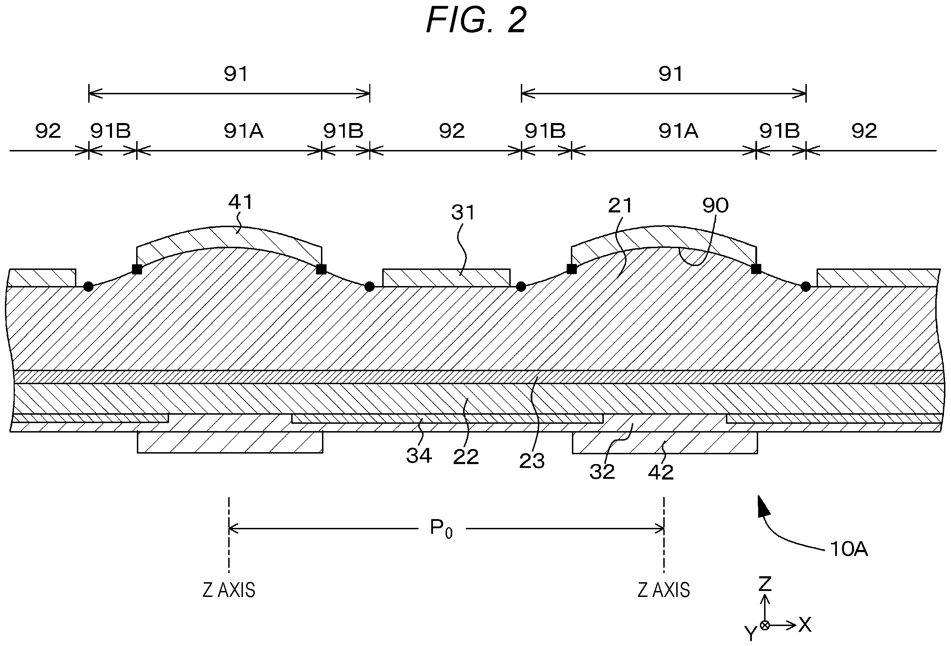

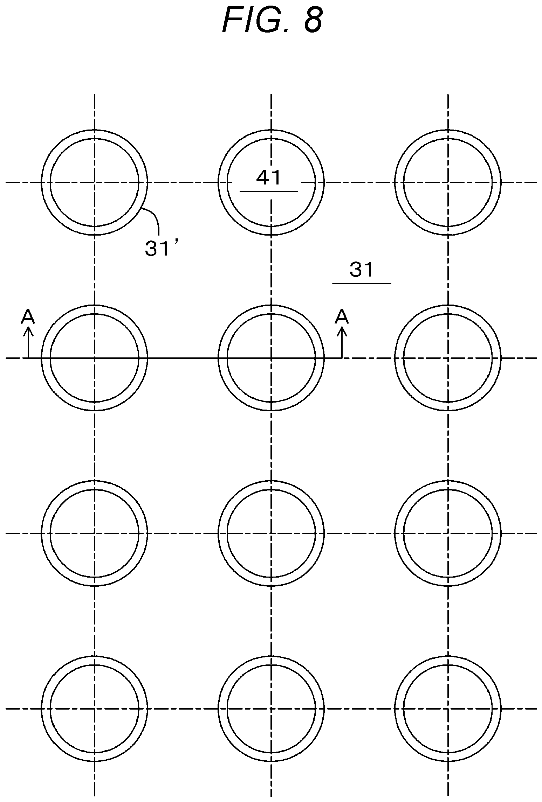

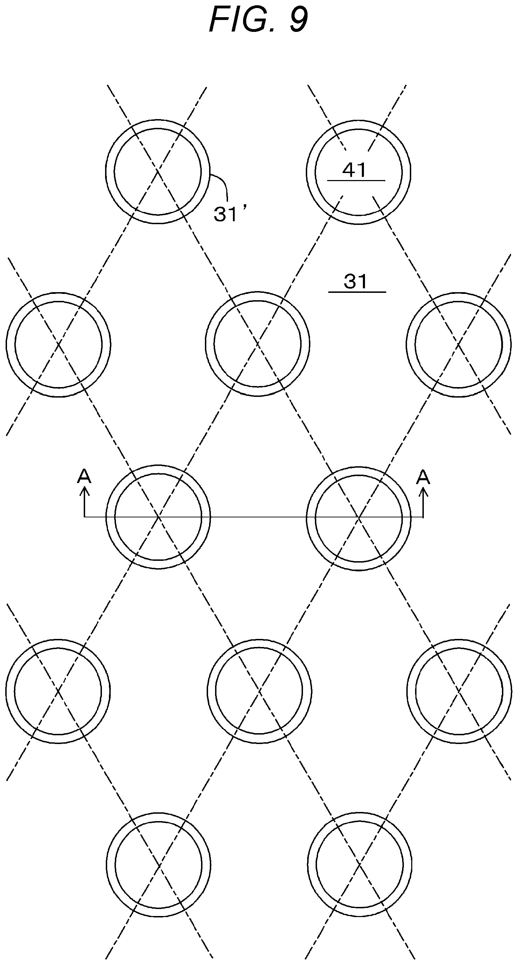

Example 1 relates to the light emitting element according to the first and second aspects of the present disclosure, the light emitting element of the first configuration, and the method for manufacturing a light emitting element according to the first aspect of the present disclosure. Fig. 1 illustrates a schematic partial cross-sectional view of a light emitting element of Example 1, Fig. 2 illustrates a schematic partial cross-sectional view of a light emitting element array in which a plurality of light emitting elements of Example 1 is arranged, and Figs. 8 and 9 illustrate schematic plan views of arrangement of a first light reflecting layer and a first electrode in the light emitting element array. Here, Fig. 8 illustrates a case where the light emitting element is positioned on a vertex (intersection) of a square lattice, and Fig. 9 illustrates a case where the light emitting element is positioned on a vertex (intersection) of a regular triangular lattice. Figs. 1 and 2 or Figs. 3, 4, 5, 6, and 7 to be described later are schematic partial cross-sectional views taken along an arrow A-A in Fig. 8 or 9. Furthermore, in the drawing, the Z axis indicates an axis (perpendicular line with respect to laminated structure passing through center of first light reflecting layer) of the first light reflecting layer constituting the light emitting element.

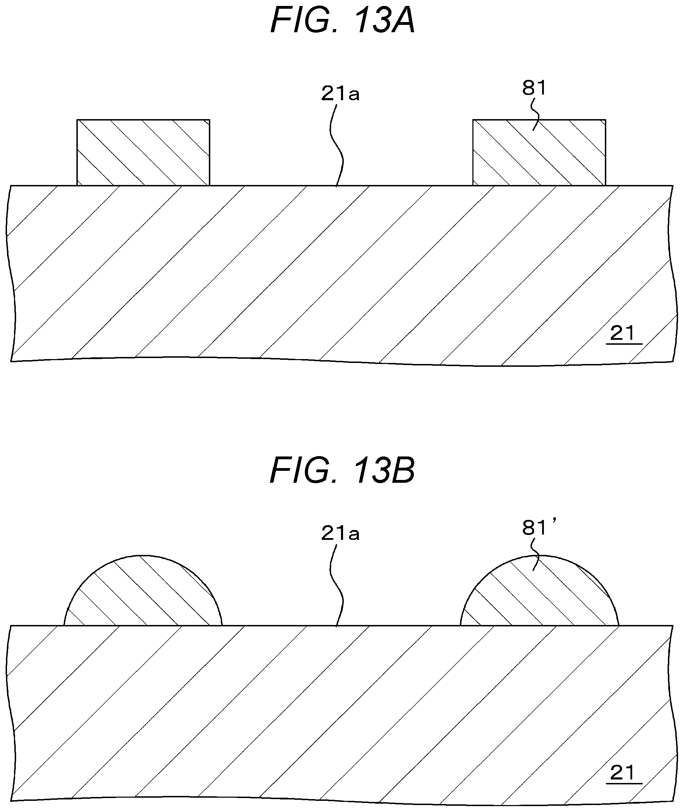

Note that the active layer, the second compound semiconductor layer, the second light reflecting layer, and the like is not illustrated in Figs. 13A, 13B, 14A, 14B, 15, 16A, and 16B, and Figs. 22, 23A, 23B, 25, 26, 27A, and 27B.

The light emitting element 10A of Example 1 or the light emitting elements of Examples 2 to 19 described later include:

a laminated structure 20 in which

a first compound semiconductor layer 21 having a first surface 21a and a second surface 21b facing the first surface 21a,

an active layer (light emitting layer) 23 facing the second surface 21b of the first compound semiconductor layer 21, and

a second compound semiconductor layer 22 having a first surface 22a facing the active layer 23 and a second surface 22b facing the first surface 22a

are laminated;

a first light reflecting layer 41; and

a second light reflecting layer 42 formed on a side of the second surface of the second compound semiconductor layer 22 and having a flat shape,

in which a base surface 90 located on a side of the first surface of the first compound semiconductor layer 21 has a first region 91 including a protruding portion in a direction away from the active layer 23, and a second region 92 surrounding the first region 91 and having a flat surface.

Then, expressed in accordance with the light emitting element according to the first aspect of the present disclosure,

the first region 91 includes a first-A region 91A including a top portion of the protruding portion and a first-B region 91B surrounding the first-A region 91A, and

the first light reflecting layer 41 is formed on at least the first-A region 91A,

a first curve formed by the first-A region 91A in the cross-sectional shape of the base surface 90 when the base surface 90 is cut along a virtual plane (in the illustrated example, for example, XZ plane) including a lamination direction of the laminated structure 20 is formed by an upwardly convex smooth curve (that is, a smooth curve having a convex shape in a direction away from the active layer 23),

at an intersection of a second curve formed by the first-B region 91B and a straight line formed by the second region 92 in the cross-sectional shape of the base surface 90, a complementary angle $\theta_{CA}$ of an angle formed by the second curve and the straight line has a value exceeding 0° (specifically, 1° or more and 6° or less), and

the second curve includes at least one kind of figure selected from the group consisting of a combination of a downwardly convex curve (a curve having a convex shape toward the direction approaching the active layer 23), a line segment, and an arbitrary curve.

Furthermore, when expressed in accordance with the light emitting element according to the second aspect of the present disclosure,

the first light reflecting layer 41 is formed at least on a top portion 91' of the first region 91, and

at an intersection of a curve formed by the first region 91 and a straight line formed by the second region 92 in the cross-sectional shape of the base surface 90 when the base surface 90 is cut along a virtual plane (in the illustrated example, for example, XZ plane) including a lamination direction of the laminated structure 20, a complementary angle $\theta_{CA}$ of an angle formed by the curve and the straight line is 1° or more and 6° or less.

The first compound semiconductor layer 21 has a first conductivity type (specifically, n-type), and the second compound semiconductor layer 22 has a second conductivity type (specifically, p-type) different from the first conductivity type. Furthermore, the light emitting element of Example includes a surface emitting laser element (Vertical Cavity Laser, VCSEL) that emits a laser beam.

Then, a curvature radius $R_1$ of the top portion 91' of the first region 91 of the base surface 90 is desirably $1.5 \times 10^{-5}$ m or more and $2 \times 10^{-4}$ m or less, a height (arrow height) $H_1$ of the first region 91 with respect to the flat surface of the second region 92 is desirably 1 $\mu$m or more and 5 $\mu$m or less, and furthermore, when the curvature radius of the top portion 91' of the first region 91 (the first-A region 91A) of the base surface 90 is $R_1$ and the resonator length of the light emitting element is $L_{OR}$,

$$1 \leq R_1/L_{OR} \leq 10$$

is desirably satisfied. Furthermore, a diameter $D_1$ of the first region 91 of the base surface 90 is preferably $3 \times 10^{-6}$ m or more and $1 \times 10^{-4}$ m or less, and a diameter $D_1'$ of the first-A region 91 of the base surface 90 is preferably $2 \times 10^{-6}$ m or more and $9 \times 10^{-5}$ m or less, and further preferably satisfies $1 \times 10^{-5}$ m $\leq L_{OR}$. Note that, in the light emitting element array, a formation pitch $P_0$ of the light emitting elements 10A is preferably 3 $\mu$m or more and 50 $\mu$m or less, preferably 5 $\mu$m or more and 30 $\mu$m or less, and more preferably 8 $\mu$m or more and 25 $\mu$m or less. Specific examples in Example 1 will be described below.

$R_1 = 87$ $\mu$m
$H_1 = 3.9$ $\mu$m

$$R_1/L_{OR} = 3.5$$

$D_1 = 52 \ \mu m$
$D_1' = 50 \ \mu m$
$L_{OR} = 25 \ \mu m$

In the light emitting element 10A of Example 1, the first surface 21a of the first compound semiconductor layer 21 constitutes the base surface 90. That is, the light emitting element 10A of Example 1 is the light emitting element of the first configuration.

In the light emitting element 10A of Example 1, the first light reflecting layer 41 is formed at least in the first-A region 91A of the base surface 90, but specifically, the first light reflecting layer 41 is formed in the first-A region 91A of the base surface 90. However, the present invention is not limited thereto, and the extending portion of the first light reflecting layer 41 may be formed in the first-B region 91B of the base surface 90, and further, the extending portion of the first light reflecting layer 41 may be formed in the second region 92 of the base surface 90 that occupies the peripheral region.

The light emitting element 10A of Example 1 illustrated in Fig. 1 corresponds to the case of (1) described above, and in the light emitting element 10A, a figure (first curve) drawn by the first-A region 91A when the first-A region 91A is cut along a virtual plane (in the illustrated example, for example, the XZ plane) including the lamination direction (Z-axis direction) of the laminated structure 20 is, for example, a part of a circle. Furthermore, the second curve formed by the first-B region 91B is a downwardly convex curve, specifically, for example, a part of a circle. A connection portion (indicated by a black square) between the first curve and the second curve is continuous and smooth in terms of analysis (that is, it can be differentiated). A connection portion between the first region 91 (first-B region 91B) and the second region 92 is indicated by a black circle.

The laminated structure 20 can include at least one material selected from the group consisting of a GaN-based compound semiconductor, an InP-based compound semiconductor, and a GaAs-based compound semiconductor. In Example 1, specifically, the laminated structure 20 includes a GaN-based compound semiconductor.

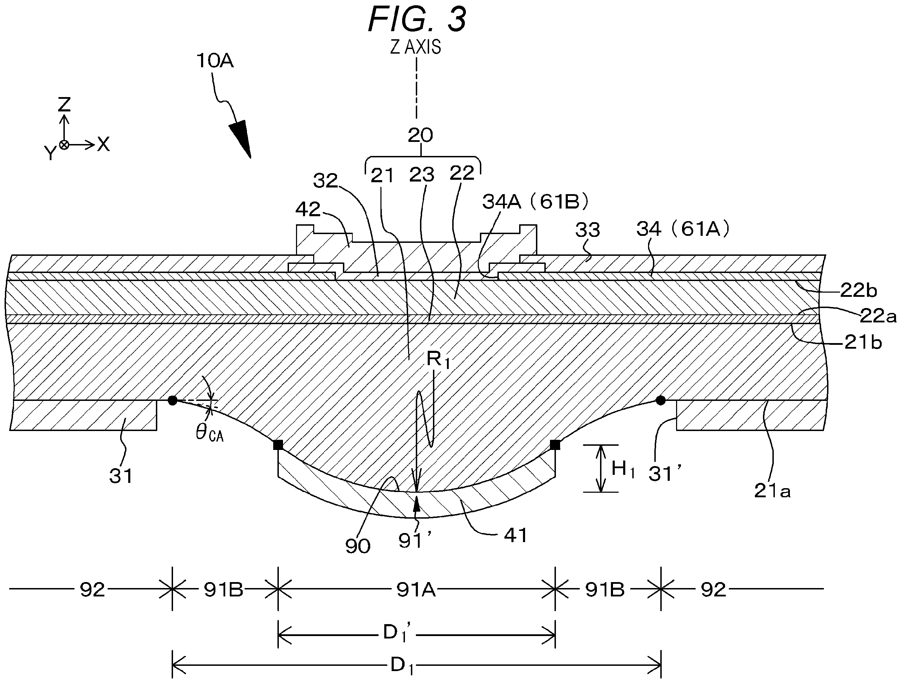

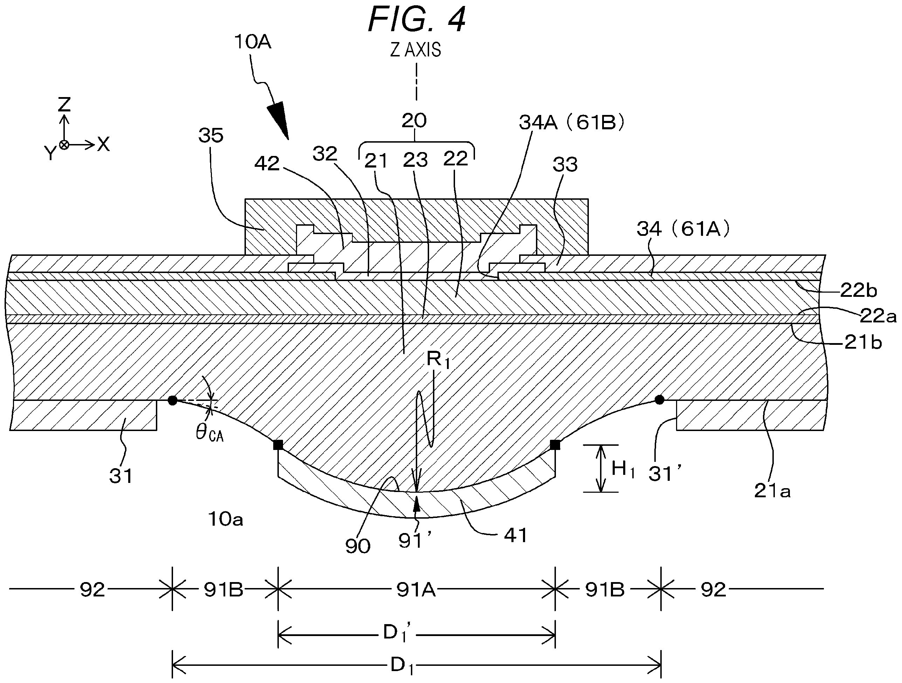

Specifically, the first compound semiconductor layer 21 includes, for example, an n-GaN layer doped with Si of about $2 \times 10^{16}$ cm$^{-3}$, the active layer 23 includes a five-layered multiple quantum well structure in which an $In_{0.04}Ga_{0.96}N$ layer (barrier layer) and an $In_{0.16}Ga_{0.84}N$ layer (well layer) are laminated, and the second compound semiconductor layer 22 includes, for example, a p-GaN layer doped with magnesium of about $1 \times 10^{19}$ cm$^{-3}$. The plane orientation of the first compound semiconductor layer 21 is not limited to the {0001} plane, and may be, for example, a {20-21} plane which is a semipolar plane, and the like. The first electrode 31 including Ti/Pt/Au is electrically connected to an external circuit and the like via a first pad electrode (not illustrated) including Ti/Pt/Au or V/Pt/Au, for example. Meanwhile, the second electrode 32 is formed on the second compound semiconductor layer 22, and the second light reflecting layer 42 is formed on the second electrode 32. The second light reflecting layer 42 on the second electrode 32 has a flat shape. The second electrode 32 includes a transparent conductive material, specifically, ITO having a thickness of 30 nm. A second pad electrode 33 includes, for example, Pd/Ti/Pt/Au, Ti/Pd/Au, or Ti/Ni/Au for electrical connection with an external circuit and the like may be formed or connected on an edge portion of the second electrode 32 (see Figs. 3 and 4). The first light reflecting layer 41 and the second light reflecting layer 42 have a laminated structure of a $Ta_2O_5$ layer and a $SiO_2$ layer or a laminated structure of a SiN layer and a $SiO_2$ layer. The first light reflecting layer 41 and the second light reflecting layer 42 have a multi-layer structure as described above, but are represented by one layer for simplification of the drawing. The planar shape of each of opening portions 34A provided in the first electrode 31 (specifically, opening portion 31' provided in the first electrode 31), the first light reflecting layer 41, the second light reflecting layer 42, and an insulating layer (current confinement layer) 34 is circular.

In order to obtain the current confinement region, as described above, the insulating layer (current confinement layer) 34 including an insulating material (for example, SiOx, SiNx, or AlOx) may be formed between the second electrode 32 and the second compound semiconductor layer 22, and the insulating layer (current confinement layer) 34 is provided with an opening portion 34A for injecting a current into the second compound semiconductor layer 22. Alternatively, in order to obtain the current confinement region, the second compound semiconductor layer 22 may be etched by a RIE method and the like to form a mesa structure. Alternatively, a part of the laminated second compound semiconductor layer 22 may be partially oxidized from the lateral direction to form the current confinement region. Alternatively, an impurity (for example, boron) may be ion-implanted into the second compound semiconductor layer 22 to form a current confinement region including a region with reduced conductivity. Alternatively, these may be appropriately combined. However, the second electrode 32 needs to be electrically connected to a portion (current injection region) of the second compound semiconductor layer 22 through which a current flows due to current confinement.

In the example illustrated in Fig. 1, the second electrode 32 is common to the light emitting elements 10A constituting the light emitting element array, and the second electrode 32 is connected to an external circuit and the like via a first pad electrode (not illustrated). The first electrode 31 is also common to the light emitting elements 10A constituting the light emitting element array, and is connected to an external circuit and the like via a first pad electrode (not illustrated). Then, light may be emitted to the outside via the first light reflecting layer 41, or light may be emitted to the outside via the second light reflecting layer 42.

Alternatively, as illustrated in a schematic partial cross-sectional view of Modification-1 of the light emitting element 10A of Example 1 in Fig. 3, the second electrode 32 is individually formed in the light emitting element 10A constituting the light emitting element array, and is connected to an external circuit and the like via the second pad electrode 33. The first electrode 31 is common to the light emitting elements 10A constituting the light emitting element array, and is connected to an external circuit and the like via a first pad electrode (not illustrated). Then, light may be emitted to the outside via the first light reflecting layer 41, or light may be emitted to the outside via the second light reflecting layer 42.

Alternatively, as illustrated in a schematic partial cross-sectional view of Modification-2 of the light emitting element 10A of Example 1 in Fig. 4, the second electrode 32 is individually formed in the light emitting element 10A constituting the light emitting element array. Furthermore, a bump 35 is formed on the second pad electrode 33 formed on the second electrode 32, and is connected to an external circuit and the like via the bump 35. The first electrode 31 is common to the light emitting elements 10A constituting the light emitting element array, and is connected to an external circuit and the like via a first pad electrode (not illustrated). The bump 35 is disposed in a portion on a side of the second surface of the second compound semiconductor layer 22 facing the base surface 90, and covers the second light reflecting layer 42. Examples of the bump 35 include a gold (Au) bump, a solder bump, and an indium (In) bump. A method for arranging the bumps 35 can be a known method. Then, light is emitted to the outside via the first light reflecting layer 41. Note that the bump 35 may be provided in the light emitting element 10A illustrated in Fig. 1. Examples of the shape of the bump 35 include a cylindrical shape, an annular shape, and a hemispherical shape.

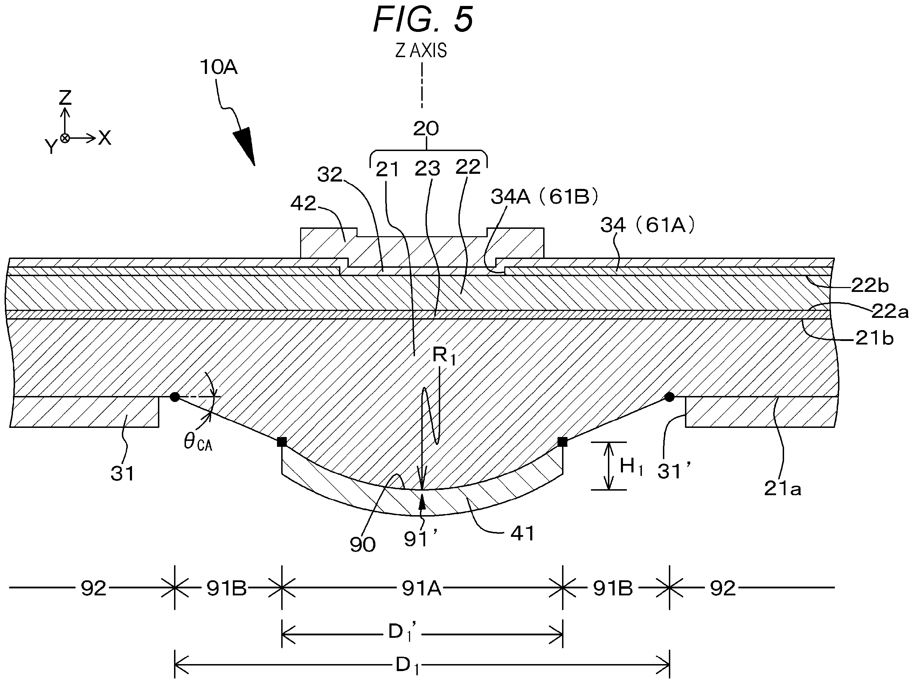

Fig. 5 illustrates a schematic partial cross-sectional view of Modification-3 of the light emitting element 10A of Example 1. In Modification-3 corresponding to the case of (2) described above, the second curve is configured by a line segment. A connection portion (indicated by a black square) between the first curve and the second curve is continuous and smooth in terms of analysis (that is, it can be differentiated). Alternatively, the connection portion between the first curve and the second curve is not continuous or smooth in terms of analysis (that is, it is not differentiable).

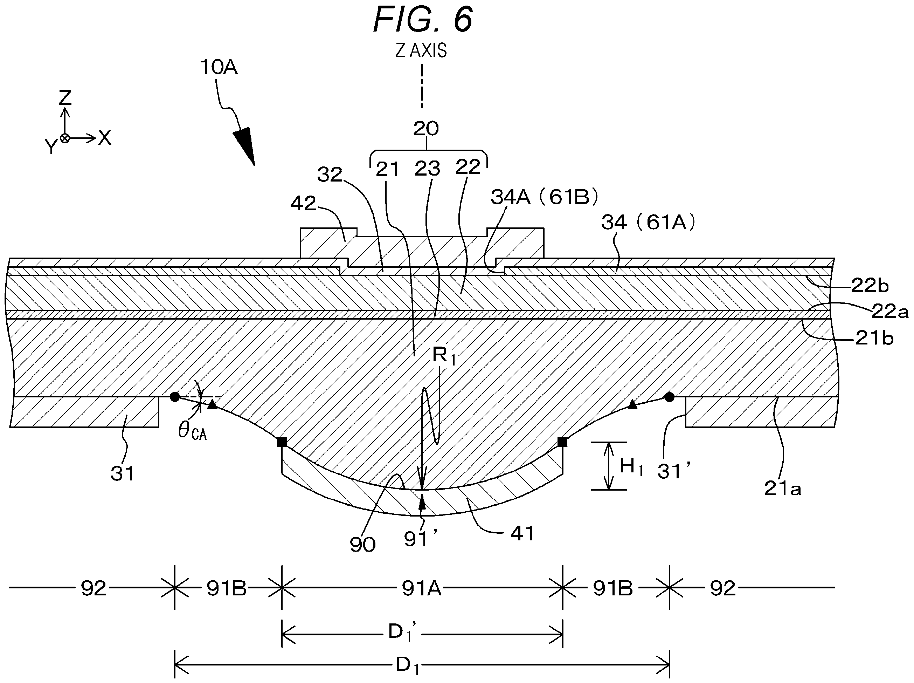

Alternatively, a schematic partial cross-sectional view of Modification-4 of the light emitting element 10A of Example 1 is illustrated in Fig. 6. In Modification-4 corresponding to the case of (4) described above, the second curve is configured by a combination of a downwardly convex curve and a line segment. A connection portion (indicated by a black square) between the first curve and the second curve is continuous and smooth in terms of analysis (that is, it can be differentiated). Alternatively, the connection portion between the first curve and the second curve is not continuous or smooth in terms of analysis (that is, it is not differentiable). Furthermore, the connection portion (indicated by a black triangle) between the downwardly convex curve and the line segment constituting the second curve is continuous and smooth in terms of analysis (that is, it can be differentiated). Alternatively, the connection portion between the downwardly convex curve and the line segment constituting the second curve is not continuous or smooth in terms of analysis (that is, it is not differentiable).

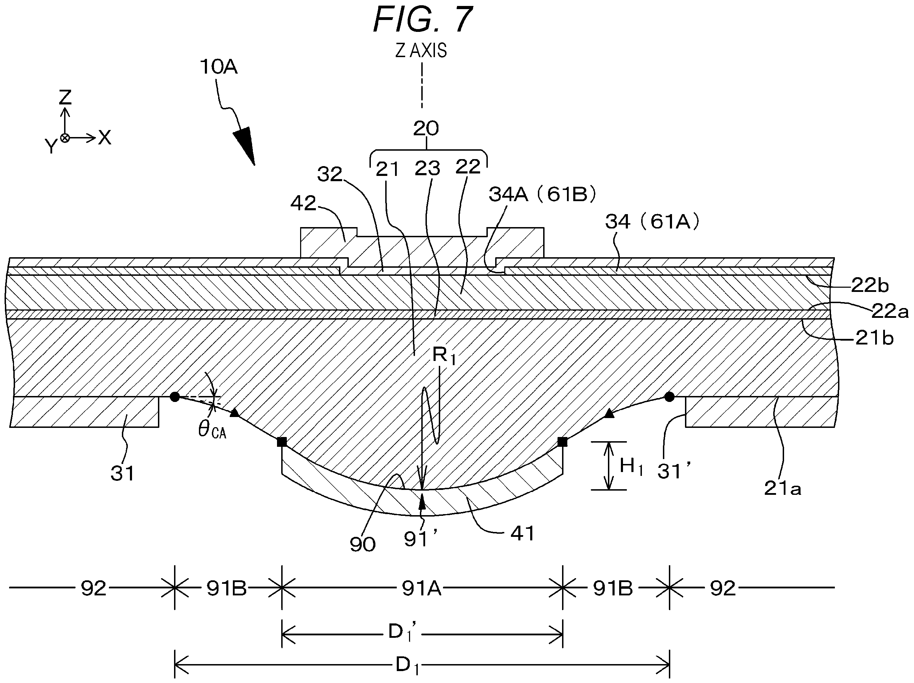

Alternatively, Fig. 7 illustrates a schematic partial cross-sectional view of Modification-5 of the light emitting element 10A of Example 1. In Modification-5 corresponding to the case of (4) described above, the second curve is configured by a combination of a line segment and a downwardly convex curve. A connection portion (indicated by a black square) between the first curve and the second curve is continuous and smooth in terms of analysis (that is, it can be differentiated). Alternatively, the connection portion between the first curve and the second curve is not continuous or smooth in terms of analysis (that is, it is not differentiable). Furthermore, the connection portion (indicated by a black triangle) between the line segment and the downwardly convex curve constituting the second curve is continuous and smooth in terms of analysis (that is, it can be differentiated). Alternatively, the connection portion between the downwardly convex curve and the line segment constituting the second curve is not continuous or smooth in terms of analysis (that is, it is not differentiable).

The configuration example of the second curve illustrated in Fig. 5, Fig. 6, or Fig. 7 is an example, and can be appropriately changed as long as the second curve is constituted by at least one type of figure selected from the group consisting of a combination of a downwardly convex curve, a line segment, and an arbitrary curve.

A value of thermal conductivity of the laminated structure 20 is higher than a value of thermal conductivity of the first light reflecting layer 41. The value of the thermal conductivity of the dielectric material constituting the first light reflecting layer 41 is about 10 watts/(m·K) or less. Meanwhile, the value of the thermal conductivity of the GaN-based compound semiconductor constituting the laminated structure 20 is about 50 watts/(m·K) to 100 watts/(m·K).

In the light emitting element array in which the plurality of light emitting elements of Example 1 illustrated in Figs. 8 and 9 is arranged, the parameters of the light emitting element 10A are as illustrated in Table 1 below. Furthermore, the specifications of the light emitting element 10A of Example 1 illustrated in Figs. 8 and 9 illustrating the arrangement of the light emitting elements are illustrated in the following Tables 2 and 3. Note that the "number of light emitting elements" is the number of light emitting elements constituting one light emitting element array.

<Table 1>

|  | See arrangement state in Fig. 8 | See arrangement state in Fig. 9 |
|---|---|---|
| Formation pitch $P_0$ | 25 $\mu$m | 20 $\mu$m |
| Curvature radius $R_1$ | 30 $\mu$m | 30 $\mu$m |
| Diameter $D_1$ | 20 $\mu$m | 20 $\mu$m |
| Height $H_1$ | 2 $\mu$m | 2 $\mu$m |

<Table 2> See arrangement state in Fig. 8

| Second light reflecting layer 42 | $SiO_2/Ta_2O_5$ (11.5 pairs) |
|---|---|
| Second electrode 32 | ITO (thickness: 22 nm) |
| Second compound semiconductor layer 22 | p-GaN |
| Active layer 23 | InGaN (multiple quantum well structure) |
| First compound semiconductor layer 21 | n-GaN |
| First light reflecting layer 41 | $SiO_2/Ta_2O_5$ (14 pairs) |
| Resonator length $L_{OR}$ | 25 $\mu$m |
| Oscillation wavelength (emission wavelength) $\lambda_0$ | 445 nm |
| Number of light emitting elements | 100 $\times$ 100 |

<Table 3> See arrangement state in Fig. 9

| Second light reflecting layer 42 | $SiO_2/SiN$ (9 pairs) |
|---|---|
| Second electrode 32 | ITO (thickness: 22 nm) |
| Second compound semiconductor layer 22 | p-GaN |
| Active layer 23 | InGaN (multiple quantum well structure) |
| First compound semiconductor layer 21 | n-GaN |
| First light reflecting layer 41 | $SiO_2/Ta_2O_5$ (14 pairs) |
| Resonator length $L_{OR}$ | 25 $\mu$m |
| Oscillation wavelength (emission wavelength) $\lambda_0$ | 488 nm |
| Number of light emitting elements | 1000 $\times$ 1000 |

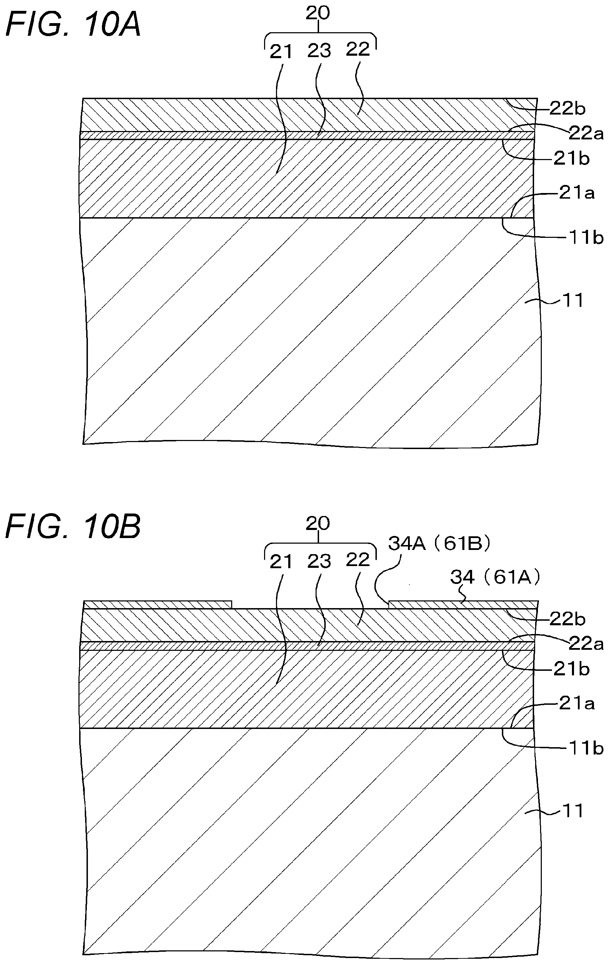

Hereinafter, a method for manufacturing a light emitting element of Example 1 will be described with reference to Figs. 10A, 10B, 11, 12, 13A, 13B, 14A, 14B, and 15 which are schematic partial end views of a first compound semiconductor layer and the like, a method for manufacturing a light emitting element of Example 1 or Example 2 described later including a laminated structure 20 in which a first compound semiconductor layer 21 having a first surface 21a and a second surface 21b facing the first surface 21a, an active layer (light emitting layer) 23 facing the second surface 21b of the first compound semiconductor layer 21, and a second compound semiconductor layer 22 having a first surface 22a facing the active layer 23 and a second surface 22b facing the first surface 22a are laminated, a first light reflecting layer 41, and a second light reflecting layer 42 formed on a side of the second surface of the second compound semiconductor layer 22 and having a flat shape, in which a base surface 90 located on a side of the first surface of the first compound semiconductor layer 21 has a first region 91 including a protruding portion protruding in a direction away from the active layer 23, and a second region 92 surrounding the first region 91 and having a flat surface. Then, the first light reflecting layer 41 is formed at least on the top portion 91' of the first region 91, and at the intersection of a curve formed by the first region 91 and a straight line formed by the second region 92 in the cross-sectional shape of the base surface 90 when the base surface 90 is cut along the virtual plane (XZ plane) including a lamination direction of the laminated structure 20, a complementary angle $\theta_{CA}$ of the angle formed by this curve and this straight line exceeds 0°.

First, after the laminated structure 20 is formed, the second light reflecting layer 42 is formed on a side of the second surface of the second compound semiconductor layer 22.

[Step-100]

Specifically, the laminated structure 20 including a GaN-based compound semiconductor is formed on the second surface 11b of the compound semiconductor substrate 11 having a thickness of about 0.4 mm, in which the first compound semiconductor layer 21 having the first surface 21a and the second surface 21b facing the first surface 21a, the active layer (light emitting layer) 23 facing the second surface 21b of the first compound semiconductor layer 21, and the second compound semiconductor layer 22 having the first surface 22a facing the active layer 23 and the second surface 22b facing the first surface 22a are laminated in the laminated structure. More specifically, the laminated structure 20 can be obtained by sequentially forming the first compound semiconductor layer 21, the active layer 23, and the second compound semiconductor layer 22 on the second surface 11b of the compound semiconductor substrate 11 based on an epitaxial growth method by a known MOCVD method (see Fig. 10A).

[Step-110]

Next, on the second surface 22b of the second compound semiconductor layer 22, the insulating layer (current confinement layer) 34 having the opening portion 34A and containing $SiO_2$ is formed based on a combination of a film forming method such as a CVD method, a sputtering method, or a vacuum vapor deposition method and a wet etching method or a dry etching method (see Fig. 10B). The current confinement region (current injection region 61A and current non-injection region 61B) is defined by the insulating layer 34 having the opening portion 34A. That is, the current injection region 61A is defined by the opening portion 34A.

In order to obtain the current confinement region, the insulating layer (current confinement layer) 34 including an insulating material (for example, SiOx, $SiN_x$, or AlOx) may be formed between the second electrode 32 and the second compound semiconductor layer 22, and the insulating layer (current confinement layer) 34 is provided with the opening portion 34A for injecting a current into the second compound semiconductor layer 22. Alternatively, in order to obtain the current confinement region, the second compound semiconductor layer 22 may be etched by a RIE method and the like to form a mesa structure. Alternatively, a part of the laminated second compound semiconductor layer 22 may be partially oxidized from the lateral direction to form the current confinement region. Alternatively, an impurity (for example, boron) may be ion-implanted into the second compound semiconductor layer 22 to form a current confinement region including a region with reduced conductivity. Alternatively, these may be appropriately combined. However, the second electrode 32 needs to be electrically connected to a portion (current injection region) of the second compound semiconductor layer 22 through which a current flows due to current confinement.

[Step-120]

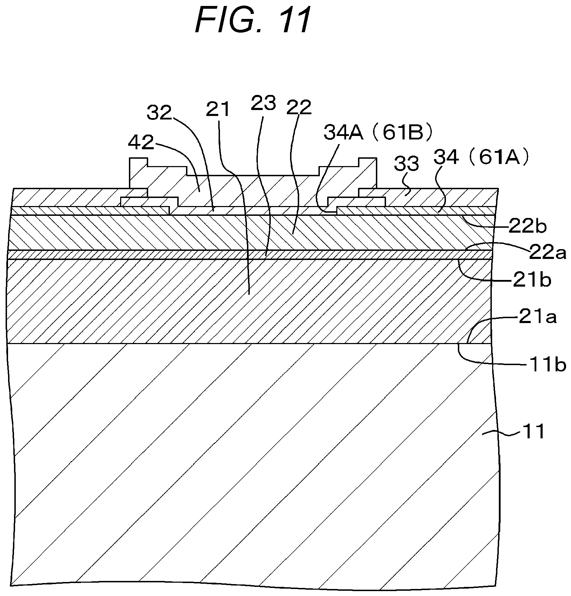

Thereafter, the second electrode 32 and the second light reflecting layer 42 are formed on the second compound semiconductor layer 22. Specifically, the second electrode 32 is formed from the second surface 22b of the second compound semiconductor layer 22 exposed on the bottom surface of the opening portion 34A (current injection region 61A) to the top of the insulating layer 34, for example, based on a lift-off method, and moreover, as desired, the second pad electrode 33 is formed based on a combination of a film forming method such as a sputtering method or a vacuum vapor deposition method and a patterning method such as a wet etching method or a dry etching method. Next, the second light reflecting layer 42 is formed from the top of the second electrode 32 to the top of the second pad electrode 33 based on a combination of a film forming method such as a sputtering method or a vacuum vapor deposition method and a patterning method such as a wet etching method or a dry etching method. The second light reflecting layer 42 on the second electrode 32 has a flat shape. In this way, the structure illustrated in Fig. 11 can be obtained. Thereafter, as desired, the bump 35 may be disposed in a portion on a side of the second surface of the second compound semiconductor layer 22 facing the top portion (center portion) 91' of the first region 91 of the base surface 90. Specifically, as illustrated in Fig. 4, a bump 35 may be formed on the second pad electrode 33 formed on the second electrode 32 so as to cover the second light reflecting layer 42, and the second electrode 32 is connected to an external circuit and the like via the bump 35.

[Step-130]

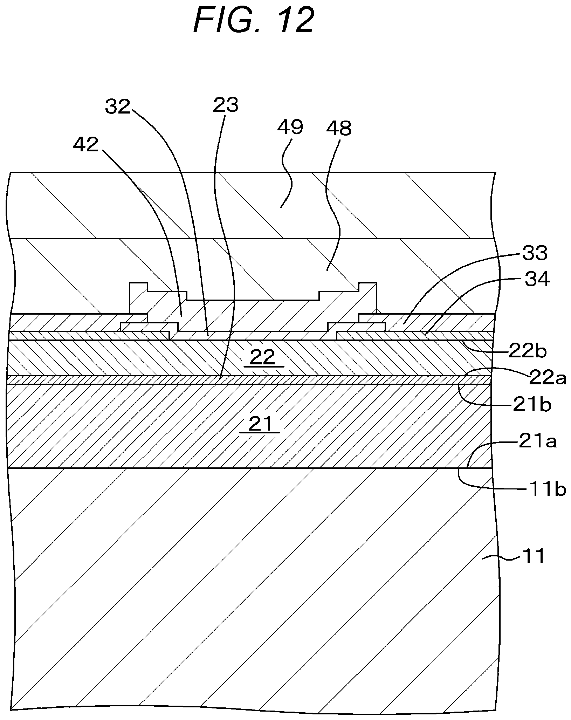

Next, the second light reflecting layer 42 is fixed to the support substrate 49 via a bonding layer 48 (see Fig. 12). Specifically, the second light reflecting layer 42 (or the bump 35) is fixed to the support substrate 49 including a sapphire substrate using the bonding layer 48 including an adhesive.

[Step-140]

Next, the compound semiconductor substrate 11 is thinned based on a mechanical polishing method or a CMP method, and is further etched to remove the compound semiconductor substrate 11.

[Step-150]

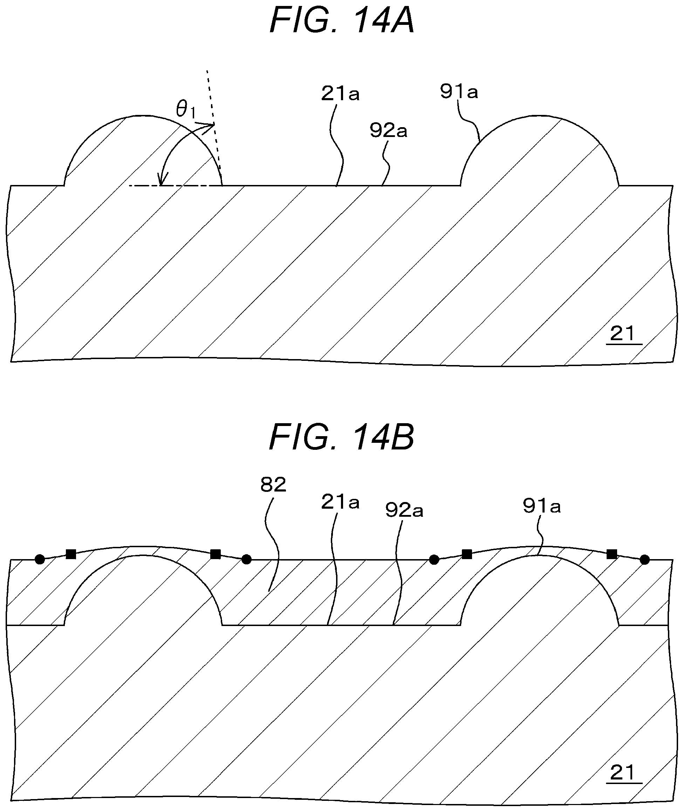

Thereafter, a protrusion forming step of forming a protrusion in a region where the first region 91 of the base surface 90 is to be formed and forming a flat surface in a region where the second region 92 of the base surface 90 is to be formed is executed. Specifically, the first sacrificial layer 81 (specifically, the first sacrificial layer 81 having a convex surface) is formed in the region where the first region 91 of the base surface 90 (more specifically, the first surface 21a of the first compound semiconductor layer 21) where the first light reflecting layer 41 is to be formed is to be formed. More specifically, a first resist material layer (first sacrificial layer/formation layer) is formed on the first surface 21a of the first compound semiconductor layer 21, and the first resist material layer is patterned so as to leave the first resist material layer on the first region 91, thereby obtaining the first sacrificial layer 81 illustrated in Fig. 13A, and then the first sacrificial layer 81 is subjected to heat treatment, whereby the structure illustrated in Fig. 13B can be obtained. That is, the first sacrificial layer 81 having a convex surface can be formed in the region where the first region 91 of the base surface 90 is to be formed. Then, by etching back from the base surface 90 toward the inside thereof (that is, from the first surface 21a of the first compound semiconductor layer 21 to the inside of the first compound semiconductor layer 21) using the first sacrificial layer 81 as an etching mask, it is possible to form the protrusion 91a in the first region 91 of the base surface 90 and form the flat surface 92a in the second region 92 of the base surface 90 with respect to the second surface 21b of the first compound semiconductor layer 21 (see Fig. 14A). Etch back can be performed based on a dry etching method such as a RIE method, or can be performed based on a wet etching method using hydrochloric acid, nitric acid, hydrofluoric acid, phosphoric acid, a mixture thereof, and the like. At the completion of [Step-150], the specifications of the protrusion 91a of the first region 91 were as illustrated in Table 4 below. Note that a surface roughness Rq is defined in JIS B-610:2001, and specifically, can be measured based on observation based on AFM or cross-sectional TEM.

Note that, in manufacturing the conventional light emitting element, the first light reflecting layer 41 is formed on the protrusion 91a of the formed first region 91.

<Table 4>

Diameter: 53 $\mu$m

Height: 3.9 $\mu$m

Curvature radius: 87 $\mu$m

$\theta_1$: 8.2°

Surface roughness Rq: 0.5 nm

In some cases, after the first sacrificial layer 81 illustrated in Fig. 13A is obtained, etch-back processing is performed from the base surface 90 toward the inside thereof (that is, from the first surface 21a of the first compound semiconductor layer 21 to the inside of the first compound semiconductor layer 21) using the first sacrificial layer 81 as an etching mask while maintaining the shape of the first sacrificial layer 81, and thus, the protrusion 91a may be formed in the first region 91 of the base surface 90 with respect to the second surface 21b of the first compound semiconductor layer 21, and the flat surface 92a may be formed in the second region 92 of the base surface 90.

Furthermore, in some cases, in [Step-150], the protrusion 91a can be formed in the first region 91 of the base surface 90 based on the nanoimprint method, and the flat surface can be formed in the second region of the base surface 90. Alternatively, the first sacrificial layer 81 may be formed based on a nanoimprint method. That is, the method of forming the protrusion 91a in the first region 91 of the base surface 90 is not particularly limited.

Here, at the intersection of the curve (the curve may also include line segment) configured by the first region 91 and the straight line configured by the second region 92 in the cross-sectional shape of the base surface 90 obtained in the protrusion forming step, a complementary angle of an angle formed by this curve and this straight line is $\theta_1$.

[Step-160]

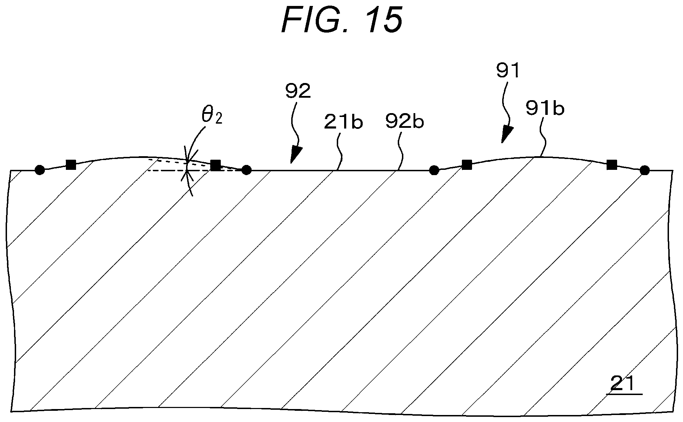

Thereafter, the second sacrificial layer 82 is formed on the entire surface (see Fig. 14B), and then, etch-back processing is performed from the base surface 90 toward the inside thereof (that is, from the first surface 21a of the first compound semiconductor layer 21 to the inside of the first compound semiconductor layer 21) using the second sacrificial layer 82 as an etching mask, and thus, the protrusion 91b is formed in the first region 91 of the base surface 90 with respect to the second surface 21b of the first compound semiconductor layer 21, and the flat surface 92b is formed in the second region 92 of the base surface 90 (see Fig. 15). The above [Step-160] is referred to as an etch-back step. Etch back can be performed based on a dry etching method such as a RIE method, or can be performed based on a wet etching method using hydrochloric acid, nitric acid, hydrofluoric acid, phosphoric acid, a mixture thereof, and the like.

More specifically, the second sacrificial layer 82 including, for example, a photoresist (viscosity: 15 mPa) is formed on the entire surface based on a spin coating method. A film thickness of the second sacrificial layer 82 needs to be thinner than the film thickness at which the surface of the second sacrificial layer 82 including the upper portion of the protrusion 91a of the first region 91 is flat. A rotation speed in the spin coating method is 10 rpm or more, and for example, 6000 rpm is preferable. As a result, the second sacrificial layer 82 is accumulated at the boundary between the protrusion 91a and the flat portion of the first region 91. Thereafter, baking processing is performed on the second sacrificial layer 82. A baking temperature is 90°C or higher, and for example, 120°C is preferable. Through the steps so far, it is possible to obtain the second sacrificial layer 82 that reflects at least a part of the shape of the protrusion 91a of the first region 91 and widens above the hem portion of the first region 91. Thereafter, by etching back from the base surface 90 toward the inside thereof (that is, from the first surface 21a of the first compound semiconductor layer 21 to the inside of the first compound semiconductor layer 21) using the second sacrificial layer 82 as an etching mask based on the RIE method using a $SiCl_4$ gas and a $Cl_2$ gas as etching gases, the protrusion 91b can be formed in the first region 91 of the base surface 90 and the flat surface 92b can be formed in the second region 92 of the base surface 90 with respect to the second surface 21b of the first compound semiconductor layer 21. In a case where the second sacrificial layer 82 is formed such that the value of the surface roughness Rq of the second sacrificial layer 82 is smaller than the value of the surface roughness Rq of the protrusion 91a of the first region 91, the value of the surface roughness Rq of the protrusion 91b of the first region 91 after etch-back can be made smaller than that before etch-back, the scattering loss can be suppressed, and the performance as a resonator can be improved. Then, it is possible to reduce the threshold current of the laser oscillation of the light emitting element, reduce the power consumption, improve the output structure, the light emission efficiency, and improve the reliability. Note that etching rates of the second sacrificial layer 82 and the base surface 90 are preferably the same.

In [Step-160], the specifications of the second sacrificial layer 82 after performing the baking processing on the second sacrificial layer 82 were as illustrated in Table 5 below. Note that, at the intersection of the curve formed by the second sacrificial layer 82 and the straight line formed by the flat portion of the second sacrificial layer 82 on the XZ plane, a complementary angle of an angle formed by this curve and this straight line is $\theta_2$". Furthermore, at the intersection of the curve formed by the first region 91 and the straight line formed by the second region 92 in the cross-sectional shape of the base surface 90, a complementary angle of an angle formed by this curve and this straight line is $\theta_2$.

<Table 5>

Diameter: 59 $\mu$m
Height: 3.1 $\mu$m
Curvature radius of region 15 $\mu$m to right and left from vertex of protrusion 91a: 87 $\mu$m
$\theta_2$": 5.6°
Surface roughness Rq: 0.3 nm

Furthermore, at the completion of [Step-160], the specifications of the protrusion 91b of the first region 91 were as illustrated in Table 6 below. Then, as a result, it has been confirmed that etch-back can be performed without changing the curvature radius of the protrusion 91b of the first region 91, and it has been found that the curvature radius as designed can be obtained. Note that the height of the protrusion 91b of the first region 91 formed by the conventional method was 3.9 $\mu$m.

<Table 6>

Diameter $D_1$: 59 $\mu$m
Height $H_1$: 3.1 $\mu$m
Curvature radius $R_1$ of region 15 $\mu$m to right and left from vertex of protrusion 91b: 87 $\mu$m
$\theta_2$: 5.6°
Surface roughness Rq: 0.3 nm

Furthermore, for example, in a case where the second sacrificial layer 82 included a photoresist (viscosity: 140 mPa) on the entire surface, in [Step-160], the specifications of the second sacrificial layer 82 after the baking processing was performed on the second sacrificial layer 82 were as illustrated in Table 7 below. Furthermore, at the completion of [Step-160], the specifications of the protrusion 91b of the first region 91 were as illustrated in Table 8 below.

<Table 7>

Diameter: 58 $\mu$m
Height: 2.7 $\mu$m

(continued)

Curvature radius of region 15 $\mu$m to right and left from vertex of protrusion 91a: 150 $\mu$m

$\theta_2$": 4.2°

Surface roughness Rq: 0.3 nm

<Table 8>

Diameter $D_1$: 58 $\mu$m

Height $H_1$: 2.7 $\mu$m

Curvature radius $R_1$ of region 15 $\mu$m to right and left from vertex of protrusion 91b: 150 $\mu$m

$\theta_2$: 4.2°

Surface roughness Rq: 0.3 nm

Here, $\theta_2$ satisfies $\theta_2 < \theta_1$ after completion of the etch-back step.

As described above, the curvature radius $R_1$ at the vertex of the protrusion 91b can be controlled by the viscosity of the photoresist constituting the second sacrificial layer 82.

The material constituting the first sacrificial layer 81 and the second sacrificial layer 82 is not limited to the resist material, and an appropriate material for the first compound semiconductor layer 21 may be selected, such as an oxide material (for example, $SiO_2$, SiN, $TiO_2$, and the like), a semiconductor material (for example, Si, GaN, InP, GaAs, and the like), or a metal material (for example, Ni, Au, Pt, Sn, Ga, In, Al, and the like). Furthermore, by using a resist material having an appropriate viscosity as a resist material constituting the first sacrificial layer 81 and the second sacrificial layer 82, and by appropriately setting and selecting the thickness of the first sacrificial layer 81, the thickness of the second sacrificial layer 82, the diameter of the first sacrificial layer 81, and the like, the value of the curvature radius of the base surface 90, the convex shape of the base surface 90 (for example, the diameter $D_1$ and the height $H_1$), and the cross-sectional shapes of the first region 91 and the second region 92 can be set to desired values and shapes. The above similarly applies to Example 2 described later.

Note that, in the etch-back step ([Step-160]), as necessary, that is, after the second sacrificial layer 82 is formed a plurality of times so as to obtain a desired $\theta_{CA}$, etch-back processing may be performed from the base surface 90 toward the inside using the second sacrificial layer 82 as an etching mask. Alternatively, after the completion of the etch-back step, $\theta_2 < \theta_1$ is satisfied, but in a case where $\theta_2$ has not reached the desired value $\theta_{CA}$, the etch-back step ([Step-160]) may be repeated to set $\theta_{CA} = \theta_2$.

[Step-170]

Next, the first light reflecting layer 41 is formed on at least the top portion of the first region 91 of the base surface 90. Specifically, the first light reflecting layer 41 is formed on the entire surface of the base surface 90 based on a film forming method such as a sputtering method or a vacuum vapor deposition method, and then the first light reflecting layer 41 is patterned, whereby the first light reflecting layer 41 can be obtained on the first region 91 of the base surface 90. Thereafter, the first electrode 31 common to the light emitting elements is formed on the second region 92 of the base surface 90. As described above, the light emitting element array or the light emitting element 10A of Example 1 can be obtained. When the first electrode 31 protrudes from the first light reflecting layer 41, the first light reflecting layer 41 can be protected.

[Step-180]

Thereafter, the support substrate 49 is peeled off, and the light emitting element arrays are individually separated. Then, the light emitting element may be electrically connected to an external electrode or circuit (circuit for driving the light emitting element array). Specifically, the first compound semiconductor layer 21 may be connected to an external circuit and the like via the first electrode 31 and a first pad electrode (not illustrated), and furthermore, the second compound semiconductor layer 22 may be connected to an external circuit and the like via the second pad electrode 33 or the bump 35. Next, the light emitting element array of Example 1 is completed by packaging or sealing.

In the light emitting element of Example 1, the complementary angle $\theta_{CA}$ has a value exceeding 0°, and the second curve on the base surface includes at least one kind of figure selected from the group consisting of a combination of a downwardly convex curve, a line segment, and an arbitrary curve. Alternatively, the value of the complementary angle $\theta_{CA}$ is defined. Therefore, even in a case where a strong external force is applied to the light emitting element for some reason, it is possible to reliably avoid problems in the conventional technique such as stress concentration on the rising portion of the base surface, and there is no possibility that damage occurs in the first compound semiconductor layer and the like. In particular, in the light emitting element array, the light emitting element array is connected to and bonded to an external circuit and the like using a bump, but it is necessary to apply a large load (for example, about 50 MPa) to the light emitting element array at the time of bonding. However, in the light emitting element array of Example 1, even when such a large load is applied, there is no possibility that the light emitting element array is damaged. Moreover, since the surface of the obtained first region (and second region) is extremely smooth, a smooth first light reflecting layer can be formed. Specifically, the surface roughness of the obtained first region (and second region) surface can achieve a root mean square roughness Rq of less than 1 nm, and as a result, it is possible to achieve a reduction in threshold current of laser oscillation and a reduction in power consumption, an improvement in output structure and luminous efficiency, and an improvement in reliability.

In a case where the light emitting elements are arranged at a narrow pitch in the light emitting element array, the pitch cannot exceed the footprint diameter of the first sacrificial layer. Therefore, in order to narrow the pitch of the light emitting element array, it is necessary to reduce the footprint diameter. By the way, the curvature radius $R_1$ of the top portion (center portion) of the first region of the base surface has a positive correlation with the footprint diameter. That is, when the footprint diameter decreases as the pitch decreases, as a result, the curvature radius $R_1$ tends to decrease. For example, a curvature radius $R_1$ of about 30 $\mu$m is reported for a footprint diameter of 24 $\mu$m. Furthermore, a radiation angle of the light emitted from the light emitting element has a negative correlation with the footprint diameter. That is, when the footprint diameter decreases as the pitch decreases, as a result, the curvature radius $R_1$ decreases, and a Far Field Pattern (FFP) tends to expand. At a curvature radius $R_1$ of less than 30 $\mu$m, the radiation angle may be several degrees or more. Depending on the application field of the light emitting element array, light emitted from the light emitting element may be required to have a narrow radiation angle of 2 to 3 or less.

In Example 1, since the first region is formed on the base surface based on the first sacrificial layer and the second sacrificial layer, a large curvature radius $R_1$ can be achieved even in a case where the light emitting elements are disposed at a narrow pitch. Therefore, the radiation angle of the light emitted from the light emitting element can be set to a narrow radiation angle of 2 to 3° or less or a narrow radiation angle as much as possible, a light emitting element having a narrow FFP can be provided, and the light output of the light emitting element can be increased and the efficiency can be improved.

In addition, since the height (thickness) of the first region can be reduced (thinned), when the light emitting element array is connected to and bonded to the external circuit and the like using a bump, a cavity (void) is hardly generated in the bump, and thermal conductivity can be improved.

Furthermore, in the light emitting element of Example 1, since the first light reflecting layer also functions as a concave mirror, the light can be diffracted and spread from the active layer as a starting point, and then, the light incident on the first light reflecting layer can be reliably reflected toward the active layer and condensed on the active layer. Therefore, an increase in diffraction loss can be avoided, laser oscillation can be reliably performed, and a problem of thermal saturation can be avoided since a long resonator is provided. Furthermore, since the resonator length can be increased, tolerance of the manufacturing process of the light emitting element is increased, and as a result, yield can be improved. Note that, in general, the "diffraction loss" refers to a phenomenon in which a laser beam reciprocating in a resonator is gradually dissipated to the outside of the resonator because light tends to spread due to a diffraction effect. Furthermore, stray light can be suppressed, and optical crosstalk between light emitting elements can be suppressed. Here, when light emitted from a certain light emitting element flies to an adjacent light emitting element and is absorbed by an active layer of the adjacent light emitting element or coupled to a resonance mode, the light affects a light emitting operation of the adjacent light emitting element and causes noise generation. Such a phenomenon is referred to as optical crosstalk. Moreover, since the top portion of the first region is, for example, a spherical surface, the effect of lateral light confinement is reliably exhibited.

Furthermore, except for Example 6 to be described later, a GaN substrate is used in a process of manufacturing a light emitting element, but a GaN-based compound semiconductor is not formed based on a method of epitaxially growing in a lateral direction such as an ELO method. Therefore, as the GaN substrate, not only a polar GaN substrate but also a semi-polar GaN substrate or a non-polar GaN substrate can be used. When a polar GaN substrate is used, the light emission efficiency tends to decrease due to the effect of the piezo electric field in the active layer, but when a non-polar GaN substrate or a semi-polar GaN substrate is used, such a problem can be solved or alleviated.

[Example 2]

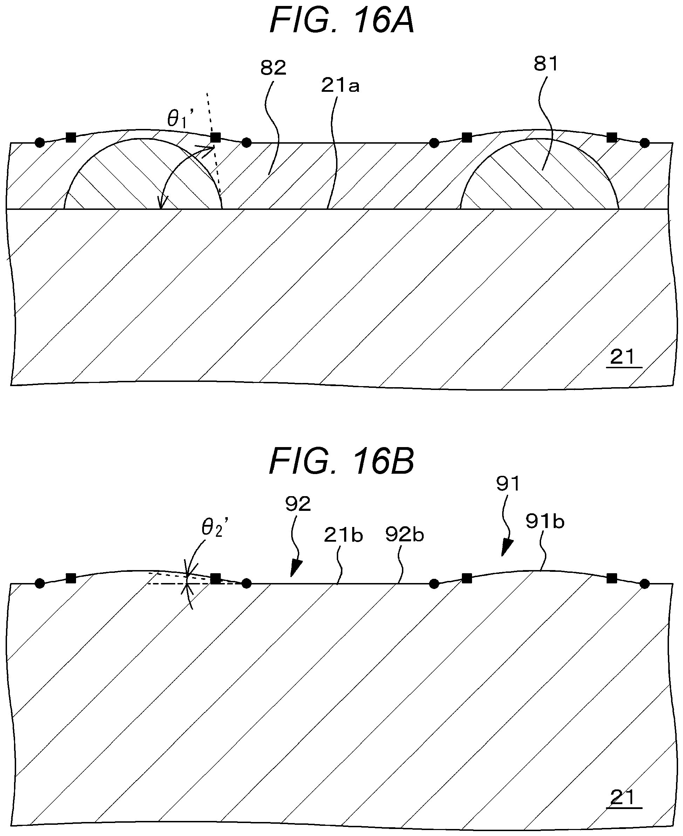

Example 2 is a method for manufacturing a light emitting element according to the second aspect of the present disclosure. The method for manufacturing a light emitting element of Example 2 will be described with reference to Figs. 13A, 13B, 16A, and 16B which are schematic partial end views of the first compound semiconductor layer and the like.

[Step-200]

In the method for manufacturing a light emitting element of Example 2, after the laminated structure 20 is formed, the second light reflecting layer 42 is formed on a side of the second surface of the second compound semiconductor layer 22. Specifically, first, steps similar to [Step-100] to [Step-140] of Example 1 are executed.

[Step-210]

Next, the first sacrificial layer 81 (specifically, the first sacrificial layer 81 having a convex surface) is formed on the first region 91 of the base surface 90 where the first light reflecting layer 41 is to be formed. More specifically, a first resist material layer is formed on the first surface 21a of the first compound semiconductor layer 21, and the first resist material layer is patterned so as to leave the first resist material layer on the first region 91 of the base surface 90 on which the first light reflecting layer 41 is to be formed, whereby the first sacrificial layer 81 illustrated in Fig. 13A is obtained, and then the first sacrificial layer 81 is subjected to heat treatment, and thus, the structure illustrated in Fig. 13B can be obtained. Next, ashing processing is applied to the surface of the first sacrificial layer 81 (plasma irradiation processing is applied) to alter the surface of the first sacrificial layer 81', and when the second sacrificial layer 82 is formed in the next step, occurrence of damage, deformation, and the like in the first sacrificial layer 81' is prevented. Note that such a first sacrificial layer before the ashing processing is represented by the first sacrificial layer 81, and the first sacrificial layer after ashing processing is represented by the first sacrificial layer 81'.

Here, at an intersection of a curve formed by the cross-sectional shape of the first sacrificial layer 81' when the first sacrificial layer 81' is cut along the virtual plane (XZ plane) described above and a straight line formed by the flat portion, a complementary angle of an angle formed by the curve and the straight line is $\theta_1'$ (see Fig. 16A). Furthermore, at an intersection of a curve formed by the first region 91 and a straight line formed by the second region 92 in the cross-sectional shape of the base surface 90 obtained by the etch-back step ([Step-220]), a complementary angle of an angle formed by this curve and this straight line is $\theta_2'$.

At the completion of [Step-210], the specifications of the first sacrificial layer 81' were as illustrated in Table 9 below.

<Table 9>
Diameter: 53 $\mu$m
Height: 3.9 $\mu$m
Curvature radius: 87 $\mu$m
$\theta_1'$: 8.2°
Surface roughness Rq: 0.3 nm

[Step-220]

Thereafter, the second sacrificial layer 82 is formed on the entire surface (see Fig. 16A), and then, etch-back processing is performed from the base surface 90 toward the inside thereof (that is, from the first surface 21a of the first compound semiconductor layer 21 to the inside of the first compound semiconductor layer 21) using the second sacrificial layer 82 and the first sacrificial layer 81' as an etching mask, so that the protrusion 91b is formed in the first region 91 of the base surface 90 with respect to the second surface 21b of the first compound semiconductor layer 21, and the flat surface 92b is formed in the second region 92 of the base surface 90 (see Fig. 16B). The above [Step-220] is referred to as an etch-back step. Etch back can be performed based on a dry etching method such as a RIE method, or can be performed based on a wet etching method using hydrochloric acid, nitric acid, hydrofluoric acid, phosphoric acid, a mixture thereof, and the like. In a case where the second sacrificial layer 82 is formed such that the value of the surface roughness Rq of the second sacrificial layer 82 is smaller than the value of the surface roughness Rq of the first sacrificial layer 81', the value of the surface roughness Rq of the protrusion 91b of the first region 91 after etch-back can be made smaller than that before etch-back, scattering loss can be suppressed, and performance as a resonator can be improved. Then, it is possible to reduce the threshold current of the laser oscillation of the light emitting element, reduce the power consumption, improve the output structure, the light emission efficiency, and improve the reliability. Note that the etching rates of the second sacrificial layer 82, the first sacrificial layer 81', and the base surface 90 are preferably the same.

Specifically, when the second sacrificial layer 82 is formed on the entire surface, a material having such a viscosity that the curvature radius of the protrusion (top portion) of the second sacrificial layer 82 above the first sacrificial layer 81' is larger than the curvature radius of the protrusion (top portion) of the first sacrificial layer 81' is selected as the second resist material constituting the second sacrificial layer 82. For example, a photoresist having a viscosity of 15 mPa can be exemplified as the second resist material. Furthermore, the value of the surface roughness Rq of the second sacrificial layer 82 is preferably 0.3 nm or less.

More specifically, the second sacrificial layer 82 including, for example, a photoresist (viscosity: 15 mPa) is formed on the entire surface based on a spin coating method. The film thickness of the second sacrificial layer 82 needs to be thinner than the film thickness at which the surface of the second sacrificial layer 82 including the top portion of the first sacrificial layer 81' becomes flat. A rotation speed in the spin coating method is 10 rpm or more, and for example, 6000 rpm is preferable. As a result, the second sacrificial layer 82 is accumulated at the boundary between the protrusion and the flat portion of the first sacrificial layer 81'. Thereafter, baking processing is performed on the second sacrificial layer 82. A baking temperature is 90°C or higher, and for example, 120°C is preferable. Through the steps so far, it is possible to obtain the second sacrificial layer 82 that reflects at least a part of the shape of the protrusion of the first sacrificial layer 81' and widens above a hem portion of the first sacrificial layer 81'. Thereafter, etch-back processing is performed from the base surface 90 toward the inside thereof (that is, from the first surface 21a of the first compound semiconductor layer 21 to the inside of the first compound semiconductor layer 21) by using the second sacrificial layer 82 and the first sacrificial layer 81' as etching masks based on the RIE method using a $SiCl_4$ gas and a $Cl_2$ gas as etching gases, whereby the protrusion 91b can be formed in the first region 91 of the base surface 90 and the flat surface 92b can be formed in the second region 92 of the base surface 90 with respect to the second surface 21b of the first compound semiconductor layer 21.

Here, after completion of the etch-back step, $\theta_2' < \theta_1'$ is satisfied.

In [Step-220], the specifications of the second sacrificial layer 82 after performing the baking processing on the second sacrificial layer 82 were as illustrated in Table 10 below. Note that, at the intersection of the curve formed by the second sacrificial layer 82 and the straight line formed by the flat portion of the second sacrificial layer 82 on the XZ plane, a complementary angle of an angle formed by this curve and this straight line is $\theta_2''$. Furthermore, at the completion of [Step-220], the specifications of the protrusion 91b of the first region 91 were as illustrated in Table 11 below.

<Table 10>

Diameter: 59 $\mu$m

Height: 3.1 $\mu$m

Curvature radius of region 15 $\mu$m to right and left from

vertex of protrusion of second sacrificial layer 82: 87 $\mu$m

$\theta_2''$: 5.6°

Surface roughness Rq: 0.3 nm

<Table 11>

Diameter $D_1$: 59 $\mu$m

Height $H_1$: 3.1 $\mu$m

Curvature radius $R_1$ of region 15 $\mu$m to right and left from vertex of protrusion 91b: 87 $\mu$m

$\theta_2$: 5.6°

Surface roughness Rq: 0.3 nm

[Step-230]

Thereafter, steps similar to [Step-170] to [Step-180] of Example 1 may be executed.

Note that, in [Step-220], after completion of the etch-back step, $\theta_2' < \theta_1'$ is satisfied, but in a case where $\theta_2'$ has not reached the desired value $\theta_{CA}$, a step of forming the second sacrificial layer 82 on the entire surface and then performing etch-back processing from the base surface 90 toward the inside thereof (that is, from the first surface 21a of the first compound semiconductor layer 21 to the inside of the first compound semiconductor layer 21) thereof using the second sacrificial layer 82 as an etching mask is repeated, and thus, $\theta_{CA} = \theta_2'$ may be satisfied. Alternatively, in the etch-back step, the second sacrificial layer 82 may be formed a plurality of times, and then the second sacrificial layer 82 and etch-back processing may be performed from the base surface 90 toward the inside using the second sacrificial layer 82 and the first sacrificial layer 81 as etching masks.

[Example 3]

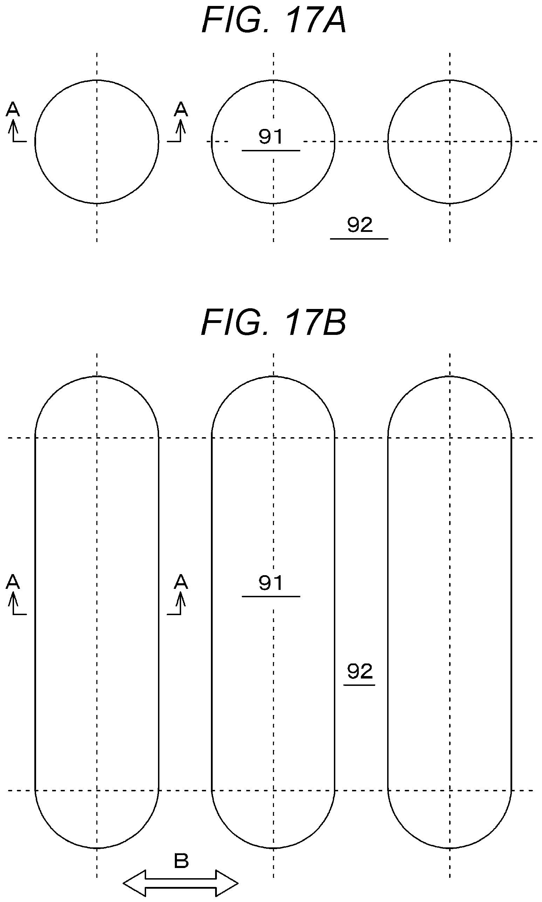

Example 3 is a modification of Example 1. Figs. 17A and 17B are schematic plan views illustrating the arrangement of the first region and the second region of the base surface in the light emitting element array of Example 3 including the plurality of light emitting elements of Example 1. In the example illustrated in Fig. 17A, in the light emitting element array, for example, the light emitting elements of Example 1 are arranged in a line. A schematic partial end view taken along an arrow A-A in Fig. 17A is similar to that illustrated in Figs. 1 to 7. In the example illustrated in Fig. 17B, in the light emitting element array, for example, light emitting elements having a planar shape longer than that of the light emitting element of Example 1 are arranged in a line. A schematic partial end view taken along the arrow A-A in Fig. 17B is similar to that illustrated in Figs. 1 to 7. In the light emitting element array of Example 3 illustrated in Fig. 17A, the parameters of the light emitting elements are as illustrated in Table 12 below, and the specifications of the light emitting elements are illustrated in Table 13 below. Furthermore, in the light emitting element array of Example 3 illustrated in Fig. 17B, the parameters of the light emitting elements are as illustrated in Table 14 below, and the specifications of the light emitting elements are illustrated in Table 15 below. Note that the shape of the base surface illustrated in Fig. 17B is a part of a cylindrical shape or a part of a semicylindrical shape.

<Table 12>

| See arrangement state in Fig. 17A | |
|---|---|
| Formation pitch $P_0$ | 25 $\mu$m |
| curvature radius $R_1$ | 30 $\mu$m |
| Diameter $D_1$ | 20 $\mu$m |
| Height $H_1$ | 2 $\mu$m |

<Table 13> See the arrangement state in Fig. 17A.

| | |
|---|---|
| Second light reflecting layer 42 | $SiO_2/Ta_2O_5$ (11.5 pairs) |
| Second electrode 32 | ITO (thickness: 22 nm) |
| Second compound semiconductor layer 22 | p-GaN |
| Active layer 23 | InGaN (multiple quantum well structure) |
| First compound semiconductor layer 21 | n-GaN |
| First light reflecting layer 41 | $SiO_2/Ta_2O_5$ (14 pairs) |
| Resonator length $L_{OR}$ | 25 $\mu$m |
| Oscillation wavelength (emission wavelength) $\lambda_0$ | 445 nm |
| Number of light emitting elements | 1000 $\times$ 1 |

<Table 14>

| See arrangement state in Fig. 17B | |
|---|---|
| Formation pitch $P_0$ | 25 $\mu$m (pitch along arrow B in Fig. 17B) |
| curvature radius $R_1$ | 100 $\mu$m (curvature radius in direction of arrow B in Fig. 17B) |
| Size of first region | length 400 $\mu$m $\times$ width 20 $\mu$m |
| Height $H_1$ | 2 $\mu$m |

<Table 15> See arrangement state in Fig. 17B

| | |
|---|---|
| Second light reflecting layer 42 | $SiO_2/Ta_2O_5$ (11.5 pairs) |
| Second electrode 32 | ITO (thickness: 22 nm) |
| Second compound semiconductor layer 22 | p-GaN |
| Active layer 23 | InGaN (multiple quantum well structure) |
| First compound semiconductor layer 21 | n-GaN |
| First light reflecting layer 41 | $SiO_2/Ta_2O_5$ (14 pairs) |
| Resonator length $L_{OR}$ | 25 $\mu$m |
| Oscillation wavelength (emission wavelength) $\lambda_0$ | 445 nm |
| Number of light emitting elements | 512 $\times$ 1 |

[Example 4]

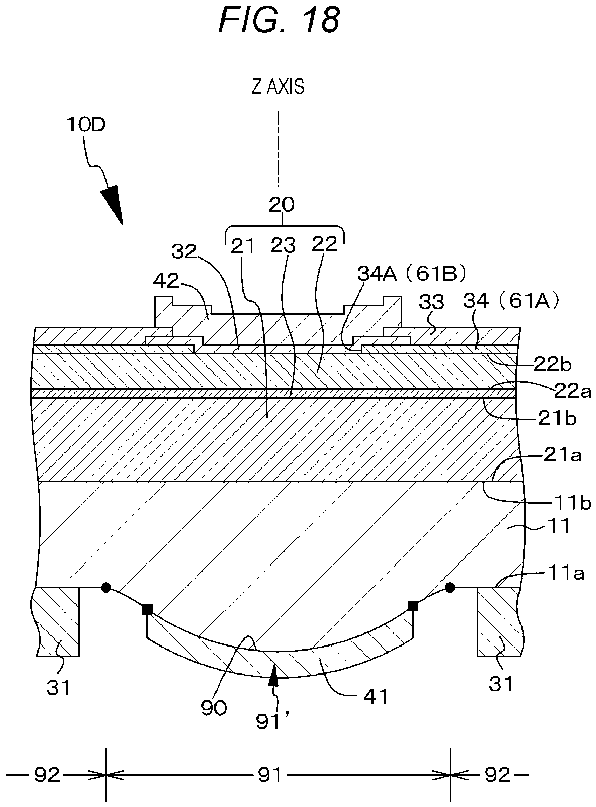

Example 4 is a modification of Examples 1 and 2, and relates to the light emitting element of the second configuration. In a light emitting element 10D of Example 4 in which a schematic partial end view is illustrated in Fig. 18, the compound semiconductor substrate 11 is disposed (left) between the first surface 21a of the first compound semiconductor layer 21 and the first light reflecting layer 41, and the base surface 90 is constituted by the surface (first surface 11a) of the compound semiconductor substrate 11.

In the light emitting element 10D of Example 4, the compound semiconductor substrate 11 is thinned and mirror-finished in a step similar to [Step-140] of Example 1. The value of the surface roughness Rq of the first surface 11a of the compound semiconductor substrate 11 is preferably 10 nm or less. Thereafter, steps similar to [Step-150] to [Step-180] of Example 1 or [Step-210] and [Step-220] of Example 2 are performed on the first surface 11a of the compound semiconductor substrate 11, and the base surface 90 including the first region 91 and the second region 92 may be provided on the compound semiconductor substrate 11 instead of the first compound semiconductor layer 21 in Example 1 to complete the light emitting element or the light emitting element array.

Except for the above points, the configuration and structure of the light emitting element of Example 4 can be similar to those of the light emitting elements of Examples 1 and 2, and thus the detailed description thereof will be omitted.

[Example 5]

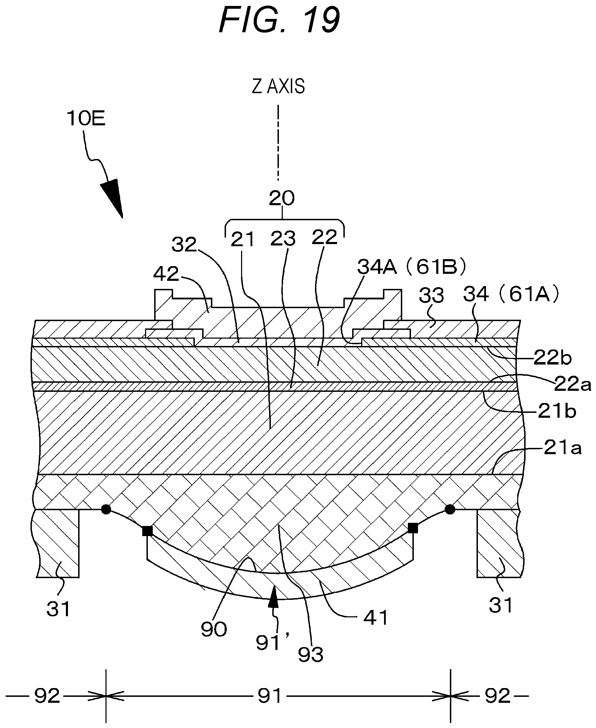

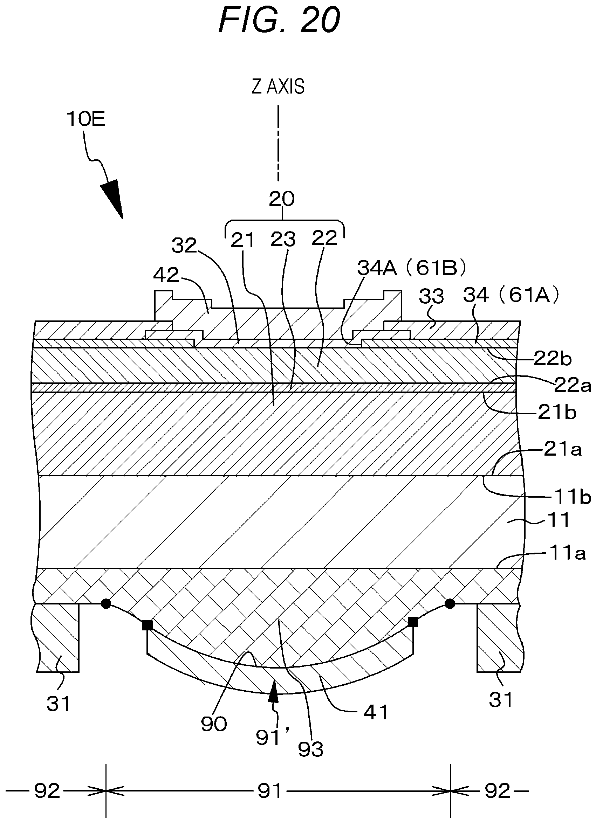

Example 5 is also a modification of Examples 1 and 2, and relates to the light emitting element of the third configuration. In a light emitting element 10E of Example 5 in which a schematic partial end view is illustrated in Fig. 19, a base material 93 is disposed between the first surface 21a of the first compound semiconductor layer 21 and the first light reflecting layer 41, and the base surface 90 is constituted by a surface of the base material 93. Alternatively, in a modification of the light emitting element 10E of Example 5 in which a schematic partial end view is illustrated in Fig. 20, the compound semiconductor substrate 11 and the base material 93 are disposed between the first surface 21a of the first compound semiconductor layer 21 and the first light reflecting layer 41, and the base surface 90 is constituted by the surface of the base material 93. Examples of the material constituting the base material 93 can include transparent dielectric materials such as $TiO_2$, $Ta_2O_5$, and $SiO_2$, silicone-based resins, and epoxy-based resins.

In the light emitting element 10E of Example 5 illustrated in Fig. 19, the compound semiconductor substrate 11 is removed in the step similar to [Step-140] of Example 1, and the base material 93 having the base surface 90 is formed on the first surface 21a of the first compound semiconductor layer 21. Specifically, for example, a $TiO_2$ layer or a $Ta_2O_5$ layer is formed on the first surface 21a of the first compound semiconductor layer 21. Then, steps similar to [Step-150] to [Step-180] of Example 1 or [Step-210] and [Step-220] of Example 2 are performed on the $TiO_2$ layer or the $Ta_2O_5$ layer, and instead of the first compound semiconductor layer 21 in Example 1, the base surface 90 including the first region 91 and the second region 92 may be provided on the base material 93 ($TiO_2$ layer or $Ta_2O_5$ layer) to complete the light emitting element or the light emitting element array.

Alternatively, in the light emitting element 10E of Example 5 illustrated in Fig. 20, the base material 93 having the base surface 90 is formed on the exposed surface (first surface 11a) of the compound semiconductor substrate 11 after thinning the compound semiconductor substrate 11 and performing mirror finishing in the step similar to [Step-140] of Example 1. Specifically, for example, a $TiO_2$ layer or a $Ta_2O_5$ layer is formed on the exposed surface (first surface 11a) of the compound semiconductor substrate 11. Then, steps similar to [Step-150] to [Step-180] of Example 1 or [Step-210] and [Step-220] of Example 2 are performed on the $TiO_2$ layer or the $Ta_2O_5$ layer, and instead of the first compound semiconductor layer 21 in Example 1, the base surface 90 including the first region 91 and the second region 92 may be provided on the base material 93 ($TiO_2$ layer or $Ta_2O_5$ layer) to complete the light emitting element or the light emitting element array.

Except for the above points, the configuration and structure of the light emitting element of Example 5 can be similar to those of the light emitting elements of Examples 1 and 2, and thus the detailed description thereof will be omitted.

[Example 6]

Example 6 is a modification of Example 5. A schematic partial end view of the light emitting element of Example 6 is substantially similar to Fig. 20, and the configuration and structure of the light emitting element of Example 6 can be substantially similar to the configuration and structure of the light emitting element of Example 5, so that the detailed description will be omitted.

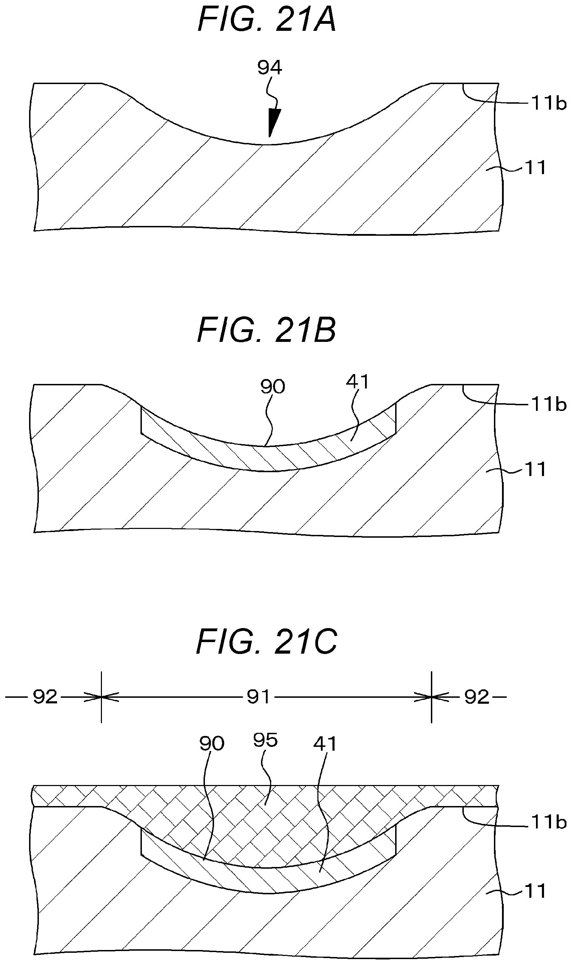

In Example 6, first, an uneven portion 94 for forming the base surface 90 is formed on the second surface 11b of the substrate 11 for manufacturing a light emitting element (see Fig. 21A). Then, after the first light reflecting layer 41 including a multi-layer film is formed on the second surface 11b of the substrate 11 for manufacturing a light emitting element (see Fig. 21B), a planarization film 95 is formed on the first light reflecting layer 41 and the second surface 11b, and the planarization film 95 is subjected to planarization processing (see Fig. 21C).

Next, the laminated structure 20 is formed on the planarization film 95 of the substrate 11 for manufacturing a light emitting element including the first light reflecting layer 41 based on lateral growth using a method of epitaxially growing in the lateral direction such as an ELO method. Thereafter, [Step-110] and [Step-120] of Example 1 are executed. Then, the substrate 11 for manufacturing a light emitting element is removed, and the first electrode 31 is formed on the exposed planarization film 95. Alternatively, the first electrode 31 is formed on the first surface 11a of the substrate 11 for manufacturing a light emitting element without removing the substrate 11 for manufacturing a light emitting element.

[Example 7]

Example 7 is a modification of Examples 1 to 6. In Examples 1 to 6, the laminated structure 20 includes a GaN-based compound semiconductor. Meanwhile, in Example 7, the laminated structure 20 includes an InP-based compound semiconductor or a GaAs-based compound semiconductor.

The plurality of light emitting elements of Examples 1 to 6 is provided, and the parameters of the light emitting elements in the light emitting element array (however, the laminated structure 20 includes an InP-based compound semiconductor) of Example 7 illustrated in Figs. 8 and 9 as the arrangement state are as illustrated in Table 16 below, and the specifications of the light emitting elements are illustrated in Tables 17 and 18 below.

<Table 16>

| | See arrangement state in Fig. 8 | see arrangement state in Fig. 9 |
|---|---|---|
| Formation pitch $P_0$ | 25 $\mu$m | 20 $\mu$m |
| Curvature radius $R_1$ | 30 $\mu$m | 30 $\mu$m |
| Diameter $D_1$ | 20 $\mu$m | 20 $\mu$m |
| Height $H_1$ | 2 $\mu$m | 2 $\mu$m |
| Curvature radius $R_2$ | 4 $\mu$m | 5 $\mu$m |

<Table 17> See arrangement state in Fig. 8.

| | |
|---|---|
| Second light reflecting layer 42 | $SiO_2/Ta_2O_5$ (11.5 pairs) |
| Second electrode 32 | ITO (thickness: 22 nm) |
| Second compound semiconductor layer 22 | p-InP |
| Active layer 23 | InGaAs (multiple quantum well structure), or AlInGaAsP (multiple quantum well structure), or InAs quantum dot |
| First compound semiconductor layer 21 | n-InP |
| First light reflecting layer 41 | $SiO_2/Ta_2O_5$ (14 pairs) |
| Resonator length $L_{OR}$ | 25 $\mu$m |
| Oscillation wavelength (emission wavelength) $\lambda_0$ | 1.6 $\mu$m |
| Number of light emitting elements | 100 $\times$ 100 |

<Table 18> See arrangement state in Fig. 9

| | |
|---|---|
| Second light reflecting layer 42 | $SiO_2/SiN$ (9 pairs) |
| Second electrode 32 | ITO (thickness: 22 nm) |
| Second compound semiconductor layer 22 | p-InP |
| Active layer 23 | InGaAs (multiple quantum well structure), or AlInGaAsP (multiple quantum well structure), or InAs quantum dot |
| First compound semiconductor layer 21 | n-InP |
| First light reflecting layer 41 | $SiO_2/Ta_2O_5$ (14 pairs) |
| Resonator length $L_{OR}$ | 25 $\mu$m |
| Oscillation wavelength (emission wavelength) $\lambda_0$ | 1.6 $\mu$m |
| Number of light emitting elements | 1000 $\times$ 1000 |

Furthermore, a plurality of the light emitting elements of Examples 1 to 6 is provided, the parameters of the light emitting elements in the light emitting element array (however, the laminated structure 20 includes a GaAs-based compound semiconductor) of Example 7 illustrated in Figs. 8 and 9 as the arrangement state are as illustrated in Table 19 below, and the specifications of the light emitting elements are illustrated in Tables 20 and 21 below.

<Table 19>

| | See arrangement state in Fig. 8 | see arrangement state in Fig. 9 |
|---|---|---|
| Formation pitch $P_0$ | 25 $\mu$m | 20 $\mu$m |
| Curvature radius $R_1$ | 30 $\mu$m | 30 $\mu$m |
| Diameter $D_1$ | 20 $\mu$m | 20 $\mu$m |
| Height $H_1$ | 2 $\mu$m | 2 $\mu$m |
| Curvature radius $R_2$ | 5 $\mu$m | 10 $\mu$m |

<Table 20> See arrangement state in Fig. 8.

| | |
|---|---|
| Second light reflecting layer 42 | $SiO_2/Ta_2O_5$ (11.5 pairs) |
| Second electrode 32 | ITO (thickness: 22 nm) |
| Second compound semiconductor layer 22 | p-GaAs |
| Active layer 23 | InGaAs (multiple quantum well structure), or GaInNAs (multiple quantum well structure), or InAs quantum dot |
| First compound semiconductor layer 21 | n-GaAs |
| First light reflecting layer 41 | $SiO_2/Ta_2O_5$ (14 pairs) |
| Resonator length $L_{OR}$ | 25 $\mu$m |
| Oscillation wavelength (emission wavelength) $\lambda_0$ | 0.94 $\mu$m |
| Number of light emitting elements | 100 $\times$ 100 |

<Table 21> See arrangement state in Fig. 9

| | |
|---|---|
| Second light reflecting layer 42 | $SiO_2/SiN$ (9 pairs) |
| Second electrode 32 | ITO (thickness: 22 nm) |
| Second compound semiconductor layer 22 | p-GaAs |
| Active layer 23 | InGaAs (multiple quantum well structure), or GaInNAs (multiple quantum well structure), or InAs quantum dot |
| First compound semiconductor layer 21 | n-GaAs |
| First light reflecting layer 41 | $SiO_2/Ta_2O_5$ (14 pairs) |
| Resonator length $L_{OR}$ | 25 $\mu$m |
| Oscillation wavelength (emission wavelength) $\lambda_0$ | 0.94 $\mu$m |
| Number of light emitting elements | 1000 $\times$ 1000 |

Hereinafter, various modifications of the light emitting elements of Examples 1 to 7, the light emitting element of the present disclosure including the above-described preferred form and configuration, and the like will be described, and then Examples 8 to 19 will be described.

In the light emitting element and the like of the present disclosure including the preferable form and configuration described above,

the second compound semiconductor layer is provided with a current injection region and a current non-injection region surrounding the current injection region, and

the shortest distance $D_{CI}$ from an area centroid point of the current injection region to a boundary between the current injection region and the current non-injection region can be configured to satisfy the following expression. Here, the light emitting element having such a configuration is referred to as a "light emitting element of the fourth configuration" for convenience. Note that, for derivation of the following expression, see, for example, H. Kogelnik and T. Li, "Laser Beams and Resonators", Applied Optics/Vol. 5, No. 10/October 1966. Furthermore, $\omega_0$ is also

called a beam waist radius.

$$D_{CI} \geq \omega_0/2 \qquad (1-1)$$

Here,

$$\omega_0^2 \equiv (\lambda_0/\pi) \{L_{OR}(R_1 - L_{OR})\}^{1/2} \qquad (1-2)$$

where:

$\lambda_0$: wavelength (oscillation wavelength) of desired light mainly emitted from light emitting element
$L_{OR}$: resonator length
$R_1$: curvature radius (that is, curvature radius of first light reflecting layer) of top portion (center portion) of first region of base surface

Here, in the light emitting element and the like of the present disclosure, only the first light reflecting layer has a concave mirror shape, but considering the symmetry of the second light reflecting layer with respect to the flat mirror, the resonator can be expanded to a Fabry-Perot resonator sandwiched between two concave mirror portions having the same curvature radius (see the schematic diagram of Fig. 49). At this time, the resonator length of the virtual Fabry-Perot resonator is twice the resonator length $L_{OR}$. Figs. 50 and 51 are graphs illustrating a relationship among the value of $\omega_0$, the value of the resonator length $L_{OR}$, and the value of the curvature radius $R_1$ of the first light reflecting layer. Note that, in Figs. 50 and 51, the curvature radius $R_1$ is indicated by "$R_{DBR}$". The value of $\omega_0$ being "positive" indicates that the laser beam is schematically in the state of Fig. 52A, and the value of $\omega_0$ being "negative" indicates that the laser beam is schematically in the state of Fig. 52B. The state of the laser beam may be the state illustrated in Fig. 52A or the state illustrated in Fig. 52B. However, in the virtual Fabry-Perot resonator having the two concave mirror portions, when the curvature radius $R_1$ becomes smaller than the resonator length $L_{OR}$, the state illustrated in Fig. 52B is obtained, and thus, confinement becomes excessive and a diffraction loss occurs. Therefore, the state illustrated in Fig. 52A in which the curvature radius $R_1$ is larger than the resonator length $L_{OR}$ is preferable. Note that, when the active layer is disposed close to the flat light reflecting layer of the two light reflecting layers, specifically, the second light reflecting layer, a light field is more condensed in the active layer. That is, light field confinement in the active layer is enhanced, and laser oscillation is facilitated. The position of the active layer, that is, the distance from the surface of the second light reflecting layer facing the second compound semiconductor layer to the active layer is not limited, but $\lambda_0/2$ to $10\lambda_0$ can be exemplified.

By the way, in a case where the region where the light reflected by the first light reflecting layer is collected is not included in the current injection region corresponding to the region where the active layer has a gain by current injection, there is a possibility that stimulated emission of light from the carrier is inhibited, and eventually laser oscillation is inhibited. When the above expressions (1-1) and (1-2) are satisfied, it is possible to ensure that the region where the light reflected by the first light reflecting layer is collected is included in the current injection region, and the laser oscillation can be reliably achieved.

Then, the light emitting element of the fourth configuration further includes:

a mode loss action site provided on the second surface of the second compound semiconductor layer and constituting a mode loss action region acting to increase or decrease an oscillation mode loss;
a second electrode formed over the mode loss action site from the second surface of the second compound semiconductor layer; and
a first electrode electrically connected to the first compound semiconductor layer,
in which the second light reflecting layer is formed on the second electrode,
a current injection region, a current non-injection/inner region surrounding the current injection region, and a current non-injection/outer region surrounding the current non-injection/inner region are formed in the laminated structure, and
an orthogonal projection image of the mode loss action region and an orthogonal projection image of the current non-injection/outer region may overlap each other.

Then, in the light emitting element of the fourth configuration including such a preferable configuration, a radius $r_1 (= D_1'/2)$ of a light reflection effective region of the first light reflecting layer can be configured to satisfy $\omega_0 \leq r_1 \leq 20 \cdot \omega_0$, preferably $\omega_0 \leq r_1 \leq 10 \cdot \omega_0$. Alternatively, $r_1 \leq 1 \times 10^{-4}$ m, preferably $r_1 \leq 5 \times 10^{-5}$ m can be exemplified as the value of

$r_1$. Furthermore, $h_1 \leq 5 \times 10^{-5}$ m can be exemplified as the height (thickness and height of first region of base surface) $h_1$ of the base surface. Furthermore, the light emitting element of the fourth configuration including such a preferable configuration can be configured to satisfy $D_{CI} \geq \omega_0$. Furthermore, in the light emitting element of the fourth configuration including such a preferable configuration, a configuration satisfying $R_1 \leq 1 \times 10^{-3}$ m, preferably $1 \times 10^{-5}$ m $\leq R_1 \leq 1 \times 10^{-3}$ m, and more preferably $1 \times 10^{-5}$ m $\leq R_1 \leq 1 \times 10^{-4}$ m can be adopted.

Furthermore, the light emitting element and the like of the present disclosure including the preferable form and configuration described above further include:

a mode loss action site provided on the second surface of the second compound semiconductor layer and constituting a mode loss action region acting to increase or decrease an oscillation mode loss;
a second electrode formed over the mode loss action site from the second surface of the second compound semiconductor layer; and
a first electrode electrically connected to the first compound semiconductor layer,
in which the second light reflecting layer is formed on the second electrode,
a current injection region, a current non-injection/inner region surrounding the current injection region, and a current non-injection/outer region surrounding the current non-injection/inner region are formed in the laminated structure, and
an orthogonal projection image of the mode loss action region and an orthogonal projection image of the current non-injection/outer region may overlap each other. Here, the light emitting element having such a configuration is referred to as a "light emitting element of fifth configuration" for convenience.

Alternatively, the light emitting element and the like of the present disclosure including the preferable form and configuration described above further include:

a second electrode formed on the second surface of the second compound semiconductor layer;
a second light reflecting layer formed on the second electrode;
a mode loss action site provided on the first surface of the first compound semiconductor layer and constituting a mode loss action region acting to increase or decrease an oscillation mode loss; and
a first electrode electrically connected to the first compound semiconductor layer,
the first light reflecting layer is formed over a region from the first surface of the first compound semiconductor layer to the mode loss action site,
a current injection region, a current non-injection/inner region surrounding the current injection region, and a current non-injection/outer region surrounding the current non-injection/inner region are formed in the laminated structure, and
an orthogonal projection image of the mode loss action region and an orthogonal projection image of the current non-injection/outer region may overlap each other. Here, the light emitting element having such a configuration is referred to as a "light emitting element of the sixth configuration" for convenience. Note that the definition of the light emitting element of the sixth configuration can be applied to the light emitting element of the fourth configuration.

In the light emitting element of the fifth configuration or the light emitting element of the sixth configuration, the current non-injection region (the generic name of the current non-injection/inner region and the current non-injection/outer region) is formed in the laminated structure, but specifically, the current non-injection region may be formed in a region on the second electrode side of the second compound semiconductor layer in the thickness direction, may be formed in the entire second compound semiconductor layer, may be formed in the second compound semiconductor layer and the active layer, or may be formed from the second compound semiconductor layer to a part of the first compound semiconductor layer. Although the orthogonal projection image of the mode loss action region and the orthogonal projection image of the current non-injection/outer region overlap each other, in a region sufficiently away from the current injection region, the orthogonal projection image of the mode loss action region and the orthogonal projection image of the current non-injection/outer region may not overlap each other.

In the light emitting element of the fifth configuration, the current non-injection/outer region may be located below the mode loss action region.

In the light emitting element of the fifth configuration including the above preferable configuration, when an area of the orthogonal projection image of the current injection region is $S_1$ and an area of the orthogonal projection image of the current non-injection/inner region is $S_2$,
it is possible to achieve a configuration satisfying

$$0.01 \leq S_1/(S_1 + S_2) \leq 0.7.$$

Furthermore, in the light emitting element of the sixth configuration, when an area of an orthogonal projection image of the current injection region is $S_1'$, and an area of an orthogonal projection image of the current non-injection/inner region is denoted by $S_2'$,
it is possible to achieve a configuration satisfying

$$0.01 \leq S_1'/(S_1' + S_2') \leq 0.7.$$

However, the range of $S_1/(S_1' + S_2)$ and the range of $S_1'/(S_1' + S_2')$ are not limited or limited to the above ranges.

In the light emitting element of the fifth configuration or the light emitting element of the sixth configuration including the preferable configuration described above, the current non-injection/inner region and the current non-injection/outer region can be formed by ion injection into the laminated structure. The light emitting element having such a configuration is referred to as a "light emitting element of configuration 5-A" and a "light emitting element of configuration 6-A" for convenience. Then, in this case, the ion species may be at least one ion (that is, one type of ion or two or more types of ions) selected from the group consisting of boron, proton, phosphorus, arsenic, carbon, nitrogen, fluorine, oxygen, germanium, zinc, and silicon.

Alternatively, in the light emitting element of the fifth configuration or the light emitting element of the sixth configuration including the preferable configuration described above, the current non-injection/inner region and the current non-injection/outer region may be formed by plasma irradiation on the second surface of the second compound semiconductor layer, ashing processing on the second surface of the second compound semiconductor layer, or reactive ion etching processing on the second surface of the second compound semiconductor layer. The light emitting element having such a configuration is referred to as a "light emitting element of configuration 5-B" or a "light emitting element of configuration 6-B" for convenience. In these processes, since the current non-injection/inner region and the current non-injection/outer region are exposed to the plasma particles, the conductivity of the second compound semiconductor layer is deteriorated, and the current non-injection/inner region and the current non-injection/outer region are in a high resistance state. That is, the current non-injection/inner region and the current non-injection/outer region can be formed by exposure of the second surface of the second compound semiconductor layer to the plasma particles. Specific examples of the plasma particles include argon, oxygen, and nitrogen.

Alternatively, in the light emitting element of the fifth configuration or the light emitting element of the sixth configuration including the preferable configuration described above, the second light reflecting layer may have a region that reflects or scatters the light from the first light reflecting layer toward the outside of the resonator structure configured by the first light reflecting layer and the second light reflecting layer. The light emitting element having such a configuration is referred to as a "light emitting element of configuration 5-C" or a "light emitting element of configuration 6-C" for convenience. Specifically, the region of the second light reflecting layer located above a side wall (side wall of an opening portion provided in the mode loss action site) of the mode loss action site has a forward tapered inclination, or has a region curved convexly toward the first light reflecting layer. Alternatively, in the light emitting element of the fifth configuration or the light emitting element of the sixth configuration including the preferable configuration described above, the first light reflecting layer may have a region that reflects or scatters the light from the second light reflecting layer toward the outside of the resonator structure configured by the first light reflecting layer and the second light reflecting layer. Specifically, the forward tapered inclination may be formed in a partial region of the first light reflecting layer, or a convex curved portion may be formed toward the second light reflecting layer, or a region of the first light reflecting layer located above the side wall (side wall of the opening portion provided in the mode loss action site) of the mode loss action site may have a forward tapered inclination, or may have the region curved convexly toward the second light reflecting layer. Furthermore, by scattering light at the boundary (side wall edge portion) between the top surface of the mode loss action site and the side wall of the opening portion provided in the mode loss action site, light can be scattered toward the outside of the resonator structure configured by the first light reflecting layer and the second light reflecting layer.

In the light emitting element of configuration 5-A, the light emitting element of configuration 5-B, or the light emitting element of configuration 5-C described above, when an optical distance from the active layer to the second surface of the second compound semiconductor layer in the current injection region is $OL_2$, and an optical distance from the active layer to the top surface of the mode loss action site in the mode loss action region is $OL_0$,

it is possible to achieve a configuration satisfying $OL_0 > OL_2$. Furthermore, in the light emitting element of the configuration 6-A, the light emitting element of the configuration 6-B, or the light emitting element of the configuration 6-C described above, when an optical distance from the active layer in the current injection region to the first surface of the first compound semiconductor layer is $OL_1'$, and an optical distance from the active layer in the mode loss action region to the top surface of the mode loss action site is $OL_0'$,
it is possible to achieve a configuration satisfying $OL_0' > OL_1'$. Furthermore, in the light emitting element of the configuration 5-A, the light emitting element of the configuration 6-A, the light emitting element of the configuration 5-B, the light emitting element of the configuration 6-B, the light emitting element of the configuration 5-C, or the light emitting element of the configuration 6-C described above including these configurations, the generated light having the higher mode is dissipated toward the outside of the resonator structure configured by the first light reflecting layer and the second light reflecting layer by the mode loss action region, and thus, the oscillation mode loss can be increased. That is, a light field intensity of the generated fundamental mode and higher mode decreases as the distance from the Z-axis increases in the orthogonal projection image of the mode loss action region due to the presence of the mode loss action region that acts to increase or decrease the oscillation mode loss, but the mode loss of the higher mode is larger than the decrease in the light field intensity of the fundamental mode, the fundamental mode can be further stabilized, the mode loss can be suppressed as compared with the case where the current injection/inner region does not exist, and thus, the threshold current can be reduced. Note that, for convenience, an axis (perpendicular line with respect to laminated structure passing through center of first light reflecting layer) passing through the center of the resonator formed by the two light reflecting layers is the Z axis, and a virtual plane orthogonal to the Z axis is the XY plane.

Furthermore, in the light emitting element of the configuration 5-A, the light emitting element of the configuration 6-A, the light emitting element of the configuration 5-B, the light emitting element of the configuration 6-B, the light emitting element of the configuration 5-C, or the light emitting element of the configuration 6-C described above, the mode loss action site can include a dielectric material, a metal material, or an alloy material. Examples of the dielectric material include $SiO_x$, $SiN_x$, $AlN_x$, $AlO_x$, $TaO_x$, and $ZrO_x$, and examples of the metal material or the alloy material include titanium, gold, platinum, and an alloy thereof, but are not limited to these materials. Light can be absorbed by the mode loss action site including these materials, and the mode loss can be increased. Alternatively, the mode loss can be controlled by disturbing the phase without directly absorbing light. In this case, the mode loss action site may include a dielectric material, and an optical thickness to of the mode loss action site may be a value deviating from an integral multiple of 1/4 of the wavelength $\lambda_0$ of the light generated in the light emitting element. That is, it is possible to destroy the standing wave by disturbing the phase of the light circulating in the resonator and forming the standing wave at the mode loss action site and to give a corresponding mode loss. Alternatively, the mode loss action site may include a dielectric material, and the optical thickness to of the mode loss action site (refractive index is no) may be an integral multiple of 1/4 of the wavelength $\lambda_0$ of light generated in the light emitting element. That is, the optical thickness to of the mode loss action site can be configured to have a thickness that does not disturb the phase of the light generated in the light emitting element and does not destroy the standing wave. However, it is not necessary to strictly be an integral multiple of 1/4 as long as $(\lambda_0/4n_0) \times m - (\lambda_0/8n_0) \leq to \leq (\lambda_0/4n_0) \times 2m + (\lambda_0/8n_0)$ is satisfied. Alternatively, by configuring the mode loss action site to include a dielectric material, a metal material, or an alloy material, light passing through the mode loss action site can be disturbed in phase or absorbed by the mode loss action site. Then, by adopting these configurations, the oscillation mode loss can be controlled with a higher degree of freedom, and the degree of freedom in designing the light emitting element can be further increased.
Alternatively, in the light emitting element of the fifth configuration including the above preferable configuration,

a protrusion is formed on a side of the second surface of the second compound semiconductor layer, and
the mode loss action site may be formed in a region of the second surface of the second compound semiconductor layer surrounding the protrusion. The light emitting element having such a configuration is referred to as a "light emitting element of configuration 5-D" for convenience. The protrusion occupies a current injection region and a current non-injection/inner region. Then, in this case, when an optical distance from the active layer to the second surface of the second compound semiconductor layer in the current injection region is $OL_2$, and an optical distance from the active layer to the top surface of the mode loss action site in the mode loss action region is $OL_0$,
it is possible to achieve a configuration satisfying $OL_0 < OL_2$, and furthermore, in these cases, the generated light having the higher mode is confined in the current injection region and the current non-injection/inner region by the mode loss action region, and thus, the oscillation mode loss can be reduced. That is, the light field intensity of the generated fundamental mode and higher mode increases in the orthogonal projection images of the current injection region and the current non-injection/inner region due to the presence of the mode loss action region that acts to increase or decrease the oscillation mode loss. Furthermore, in these cases, the mode loss action site may include a dielectric material, a metal material, or an alloy material. Here, examples of the dielectric material, the metal material, or the alloy material can include the above-described various materials.

Alternatively, in the light emitting element of the sixth configuration including the above preferable configuration,

a protrusion is formed on a side of the first surface of the first compound semiconductor layer, and
the mode loss action site may be formed in a region of the first surface of the first compound semiconductor layer surrounding the protrusion, or the mode loss action site may include a region of the first compound semiconductor layer surrounding the protrusion. The light emitting element having such a configuration is referred to as a "light emitting element of configuration 6-D" for convenience. The protrusion coincides with the orthogonal projection images of the current injection region and the current non-injection/inner region. Then, in this case, when an optical distance from the active layer to the first surface of the first compound semiconductor layer in the current injection region is $OL_1'$, and an optical distance from the active layer to the top surface of the mode loss action site in the mode loss action region is $OL_0'$,

it is possible to achieve a configuration satisfying $OL_0' < OL_1'$, and furthermore, in these cases, the generated light having a higher mode can be confined in the current injection region and the current non-injection region by the mode loss action region, and thus, the oscillation mode loss can be reduced. Moreover, in these cases, the mode loss action site can include a dielectric material, a metal material, or an alloy material. Here, examples of the dielectric material, the metal material, or the alloy material can include the above-described various materials.

Furthermore, in the light emitting element and the like of the present disclosure including the preferable form and configuration described above, at least two light absorbing material layers may be formed in the laminated structure including the second electrode in parallel to a virtual plane (XY plane) occupied by the active layer. Here, the light emitting element having such a configuration is referred to as "light emitting element of seventh configuration" for convenience.

In the light emitting element of the seventh configuration, it is preferable that at least four light absorbing material layers are formed.

In the light emitting element of the seventh configuration including the preferable configuration described above, when an oscillation wavelength (is a wavelength of light mainly emitted from the light emitting element, and is a desired oscillation wavelength) is $\lambda_0$, an equivalent refractive index of the whole of two light absorbing material layers and a portion of the laminated structure located between the light absorbing material layers is $n_{eq}$, and a distance between the light absorbing material layers is represented by $L_{Abs}$,

$$0.9 \times \{(m \cdot \lambda_0)/(2 \cdot n_{eq})\} \leq L_{Abs} \leq 1.1 \times \{(m \cdot \lambda_0)/(2 \cdot n_{eq})\}$$

is preferably satisfied. Here, m is 1 or an arbitrary integer of 2 or more including 1. When the thickness of each of the two light absorbing material layers and each of the layers constituting the portion of the laminated structure located between the light absorbing material layers is ti and the refractive index thereof is represented by $n_i$, the equivalent refractive index $n_{eq}$ is represented by $n_{eq} = \Sigma(t_i \times n_i)/\Sigma(t_i)$. However, i = 1, 2, 3,..., I, and "I" is the total number of layers constituting the two light absorbing material layers and the portion of the laminated structure located between the light absorbing material layers, and "$\Sigma$" means a sum of i = 1 to i = I. The equivalent refractive index $n_{eq}$ may be calculated based on a known refractive index and a thickness obtained by observation for each constituent material by observing the constituent material by electron microscope observation and the like of the cross section of the light emitting element. In a case where m is 1, in all the plurality of light absorbing material layers, the distance between adjacent light absorbing material layers satisfies that $0.9 \times \{\lambda_0/(2 \cdot n_{eq})\} \leq L_{Abs} \leq 1.1 \times \{\lambda_0/(2 \cdot n_{eq})\}$. Furthermore, when m is an arbitrary integer of 2 or more including 1, as an example, if m = 1, 2, in some light absorbing material layers, the distance between adjacent light absorbing material layers satisfies that $0.9 \times \{\lambda_0/(2 \cdot n_{eq})\} \leq L_{Abs} \leq 1.1 \times \{\lambda_0/(2 \cdot n_{eq})\}$,

and in the remaining light absorbing material layers, the distance between adjacent light absorbing material layers satisfies that $0.9 \times \{(2 \cdot \lambda_0)/(2 \cdot n_{eq})\} \leq L_{Abs} \leq 1.1 \times \{(2 \cdot \lambda_0)/(2 \cdot n_{eq})\}$. Broadly, in some light absorbing material layers, the distance between adjacent light absorbing material layers satisfies that $0.9 \times \{\lambda_0/(2 \cdot n_{eq})\} \leq L_{Abs} \leq 1.1 \times \{\lambda_0/(2 \cdot n_{eq})\}$,

and in the various remaining light absorbing material layers, the distance between adjacent light absorbing material layers satisfies that $0.9 \times \{(m' \cdot \lambda_0)/(2 \cdot n_{eq})\} \leq L_{Abs} \leq 1.1 \times \{(m' \cdot \lambda_0)/(2 \cdot n_{eq})\}$. Here, m' is an arbitrary integer of 2 or more. Furthermore, the distance between the adjacent light absorbing material layers is a distance between centers of gravity of the adjacent light absorbing material layers. That is, the distance is actually a distance between the centers of light absorbing material layers when cut along the virtual plane (XZ plane) along the thickness direction of the active layer.

Furthermore, in the light emitting element of the seventh configuration including the various preferable configurations described above, the thickness of the light absorbing material layer is preferably $\lambda_0/(4 \cdot n_{eq})$ or less. A lower limit value of the thickness of the light absorbing material layer may be 1 nm, for example.

Furthermore, in the light emitting element of the seventh configuration including the various preferable configurations described above, the light absorbing material layer may be located in a minimum amplitude portion generated in a standing wave of light formed inside the laminated structure.

Furthermore, in the light emitting element of the seventh configuration including the above-described various preferable configurations, the active layer may be located in a maximum amplitude portion generated in the standing wave of light formed inside the laminated structure.

Furthermore, in the light emitting element of the seventh configuration including the various preferred configurations described above, the light absorbing material layer may have a light absorption coefficient that is twice or more the light absorption coefficient of the compound semiconductor constituting the laminated structure. Here, the light absorption coefficient of the light absorbing material layer and the light absorption coefficient of the compound semiconductor constituting the laminated structure can be obtained by observing the constituent material by electron microscope observation and the like of the cross section of the light emitting element, and analogizing from known evaluation results observed for each constituent material.

Furthermore, in the light emitting element of the seventh configuration including the various preferable configurations described above, the light absorbing material layer may include at least one material selected from the group consisting of a compound semiconductor material having a narrower band gap than the compound semiconductor constituting the laminated structure, a compound semiconductor material doped with impurities, a transparent conductive material, and a light reflecting layer constituting material having light absorption characteristics. Here, as a compound semiconductor material having a narrower band gap than a compound semiconductor constituting the laminated structure, for example, in a case where the compound semiconductor constituting the laminated structure is GaN, InGaN can be exemplified, as a compound semiconductor material doped with impurities, n-GaN doped with Si and n-GaN doped with B can be exemplified, as a transparent conductive material, a transparent conductive material constituting an electrode to be described later can be exemplified, and as a light reflecting layer constituting material having light absorption characteristics, a material (for example, $SiO_x$, $SiN_x$, $TaO_x$, and the like) constituting a light reflecting layer to be described later can be exemplified. All of the light absorbing material layers may include one of these materials. Alternatively, each of the light absorbing material layers may include various materials selected from these materials, but it is preferable that one light absorbing material layer includes one kind of material from the viewpoint of simplification of formation of the light absorbing material layer. The light absorbing material layer may be formed in the first compound semiconductor layer, may be formed in the second compound semiconductor layer, may be formed in the first light reflecting layer, may be formed in the second light reflecting layer, or any combination thereof. Alternatively, the light absorbing material layer can also be used as an electrode including a transparent conductive material to be described later.

[Example 8]

Example 8 is a modification of Examples 1 to 7, and relates to the light emitting element of the fourth configuration. As described above, the current confinement region (the current injection region 61A and the current non-injection region 61B) is defined by the insulating layer 34 having the opening portion 34A. That is, the current injection region 61A is defined by the opening portion 34A. That is, in the light emitting element of Example 8, the current injection region 61A and the current non-injection region 61B surrounding the current injection region 61A is provided in the second compound semiconductor layer 22, and the shortest distance $D_{CI}$ from the area centroid point of the current injection region 61A to the boundary between the current injection region 61A and the current non-injection region 61B satisfies the above-described expressions (1-1) and (1-2).

In the light emitting element of Example 8, the radius $r_1$ of the light reflection effective region of the first light reflecting layer 41 satisfies that $\omega_0 \leq r_1 \leq 20 \cdot \omega_0$. Furthermore, the radius $r_1$ satisfies that $D_{CI} \geq \omega_0$. Further, the radius $r_1$ satisfies that $R_1 \leq 1 \times 10^{-3}$ m. Specifically,

$D_{CI} = 4 \ \mu m$
$\omega_0 = 1.5 \ \mu m$
$L_{OR} = 50 \ \mu m$
$R_1 = 60 \ \mu m$
$\lambda_0 = 525 \ nm$

can be exemplified. Furthermore, the diameter of the opening portion 34A can be 8 $\mu m$, for example. As the GaN substrate, a substrate whose main surface is a surface obtained by inclining a c-plane by about 75° in the m-axis direction is used. That is, the GaN substrate has a {20-21} plane which is a semipolar plane as a main surface. Note that such a GaN substrate can also be used in other examples.

The deviation between the central axis (Z axis) of the first region 91 of the base surface 90 and the current injection region 61A in the XY plane direction causes deterioration of the characteristics of the light emitting element. A lithography technique is often used for both the patterning for forming the first region 91 and the patterning for forming the opening portion 34A. In this case, a positional relationship between both patterning is often shifted in the XY plane depending on performance of an exposure machine. In particular, the opening portion 34A (current injection region 61A) is positioned by performing alignment from the side of the second compound semiconductor layer 22. Meanwhile, the first region 91 is positioned by performing alignment from the compound semiconductor substrate 11 side. Therefore, in the light emitting element of Example 8, by forming the opening portion 34A (current injection region 61) to be larger than the region where the light is narrowed by the first region 91, a structure is realized in which the oscillation characteristics are not affected even when a deviation occurs between the central axis (Z axis) of the first region 91 and the current injection region 61A in the XY plane direction.

That is, in a case where the region where the light reflected by the first light reflecting layer is collected is not included in the current injection region corresponding to the region where the active layer has a gain by current injection, there is a possibility that stimulated emission of light from the carrier is inhibited, and eventually laser oscillation is inhibited. However, when the above expressions (1-1) and (1-2) are satisfied, it is possible to ensure that the region where the light reflected by the first light reflecting layer is collected is included in the current injection region, and laser oscillation can be reliably achieved.

[Example 9]

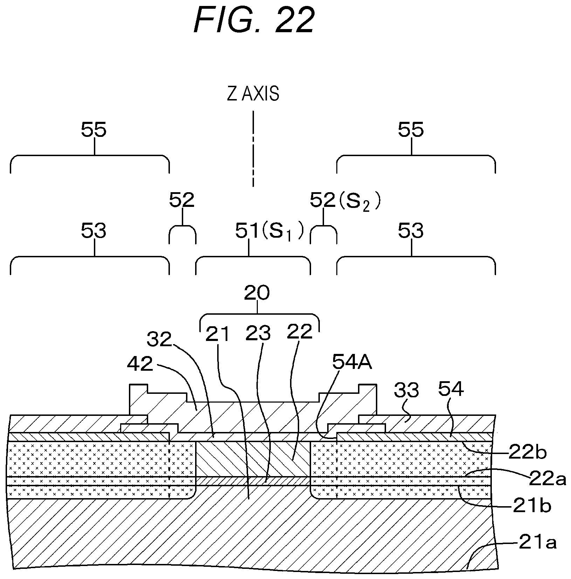

Example 9 is a modification of Examples 1 to 8, and relates to the light emitting element of the fifth configuration, specifically, the light emitting element of the configuration 5-A. Fig. 22 illustrates a schematic partial end view of a light emitting element of Example 9.

Meanwhile, in order to control a flow path (current injection region) of a current flowing between the first electrode and the second electrode, the current non-injection region is formed so as to surround the current injection region. In a GaAs-based surface emitting laser element (a surface emitting laser element including a GaAs-based compound semiconductor), the current non-injection region surrounding the current injection region can be formed by oxidizing the active layer from the outside along the XY plane. An oxidized region (current non-injection region) of the active layer has a refractive index lower than that of the non-oxidized region (current injection region). As a result, an optical path length (represented by the product of the refractive index and the physical distance) of the resonator is shorter in the current non-injection region than in the current injection region. Then, as a result, a kind of "lens effect" occurs, and a function of confining the laser beam in the central portion of the surface emitting laser element is brought about. In general, since light tends to spread due to a diffraction effect, a laser beam reciprocating in a resonator is gradually dissipated to the outside of the resonator (diffraction loss), and adverse effects such as an increase in threshold current occur. However, since the lens effect compensates for this diffraction loss, an increase in threshold current and the like can be suppressed.

However, in the light emitting element including the GaN-based compound semiconductor, it is difficult to oxidize the active layer from the outside along the XY plane (from the lateral direction) due to the characteristics of the material. Therefore, as described in Examples 1 to 8, the insulating layer 34 including $SiO_2$ having an opening portion is formed on the second compound semiconductor layer 22, the second electrode 32 including a transparent conductive material is formed from the second compound semiconductor layer 22 exposed at the bottom of the opening portion 34A to the insulating layer 34, and the second light reflecting layer 42 having a laminated structure of an insulating material is formed on the second electrode 32. In this manner, the current non-injection region 61B is formed by forming the insulating layer 34. Then, a portion of the second compound semiconductor layer 22 located in the opening portion 34A provided in the insulating layer 34 becomes the current injection region 61A.

In a case where the insulating layer 34 is formed on the second compound semiconductor layer 22, the resonator length in the region (current non-injection region 61B) where the insulating layer 34 is formed is longer than the resonator length in the region (current injection region 61A) where the insulating layer 34 is not formed by the optical thickness of the insulating layer 34. Therefore, a laser beam reciprocating in a resonator formed by the two light reflecting layers 41 and 42 of the surface emitting laser element (light emitting element) is diverged and dissipated to the outside of the resonator. Such an action is referred to as an "inverse lens effect" for convenience. Then, as a result, an oscillation mode loss occurs in the laser beam, and there is a possibility that the threshold current increases or the slope efficiency deteriorates. Here, the "oscillation mode loss" is a physical quantity that increases or decreases the light field intensity of the fundamental mode and the higher mode in the oscillating laser beam, and different oscillation mode losses are defined for individual modes. Note that the "light field intensity" is a light field intensity with the distance L from the Z axis on the XY plane as a function. In general, the "light field intensity" monotonously decreases as the distance L increases in the fundamental mode, but decreases while increasing and decreasing once or a plurality of times as the distance L increases in the higher mode (see the conceptual diagram of (A) of Fig. 24). Note that, in Fig. 24, a solid line indicates a light field intensity distribution of the fundamental mode, and a broken line indicates a light field intensity distribution of the higher mode. Furthermore, in Fig. 24, the first light reflecting layer 41 is displayed in a flat state for convenience, but actually has a concave mirror shape.

The light emitting element of Example 9 or the light emitting elements of Examples 10 to 13 described later include:

(A) the laminated structure 20 including a GaN-based compound semiconductor in which the first compound semiconductor layer 21 having the first surface 21a and the second surface 21b facing the first surface 21a, the active layer (light emitting layer) 23 facing the second surface 21b of the first compound semiconductor layer 21, and the second compound semiconductor layer 22 having the first surface 22a facing the active layer 23 and the second surface 22b facing the first surface 22a are laminated;

(B) the mode loss action site (mode loss action layer) 54 that is provided on the second surface 22b of the second compound semiconductor layer 22 and constitutes the mode loss action region 55 acting to increase or decrease an oscillation mode loss;

(C) the second electrode 32 formed from above the second surface 22b of the second compound semiconductor layer 22 to above the mode loss action site 54;

(D) the second light reflecting layer 42 formed on the second electrode 32;

(E) the first light reflecting layer 41 provided on a side of the first surface of the first compound semiconductor layer 21; and

(F) the first electrode 31 electrically connected to the first compound semiconductor layer 21.

Then, in the laminated structure 20, the current injection region 51, the current non-injection/inner region 52 surrounding the current injection region 51, and the current non-injection/outer region 53 surrounding the current non-injection/inner region 52 are formed, and the orthogonal projection image of the mode loss action region 55 and the orthogonal projection image of the current non-injection/outer region 53 overlap each other. That is, the current non-injection/outer region 53 is located below the mode loss action region 55. Note that, in a region sufficiently away from the current injection region 51 into which the current is injected, the orthogonal projection image of the mode loss action region 55 and the orthogonal projection image of the current non-injection/outer region 53 may not overlap each other. Here, the current non-injection regions 52 and 53 into which no current is injected are formed in the laminated structure 20, but in the illustrated example, the current non-injection regions are formed from the second compound semiconductor layer 22 to a part of the first compound semiconductor layer 21 in the thickness direction. However, the current non-injection regions 52 and 53 may be formed in a region on the second electrode side of the second compound semiconductor layer 22 in the thickness direction, may be formed in the entire second compound semiconductor layer 22, or may be formed in the second compound semiconductor layer 22 and the active layer 23.

The mode loss action site (mode loss action layer) 54 includes a dielectric material such as $SiO_2$, and is formed between the second electrode 32 and the second compound semiconductor layer 22 in the light emitting element of Example 9 or Examples 10 to 13 described later. The optical thickness of the mode loss action site 54 can be a value deviating from an integral multiple of 1/4 of the wavelength $\lambda_0$ of the light generated in the light emitting element. Alternatively, the optical thickness to of the mode loss action site 54 can be an integral multiple of 1/4 of the wavelength $\lambda_0$ of the light generated in the light emitting element. That is, the optical thickness to of the mode loss action site 54 can be set to a thickness that does not disturb the phase of the light generated in the light emitting element and does not destroy the standing wave. However, it is not necessary to strictly be an integral multiple of 1/4 as long as $(\lambda_0/4n_0) \times m - (\lambda_0/8n_0) \leq to \leq (\lambda_0/4n_0) \times 2m + (\lambda_0/8n_0)$ is satisfied. Specifically, the optical thickness to of the mode loss action site 54 is preferably about 25 to 250 when a value of 1/4 of the wavelength of light generated in the light emitting element is set to "100". Then, by adopting these configurations, the phase difference between the laser beam passing through the mode loss action site 54 and the laser beam passing through the current injection region 51 can be changed (the phase difference can be controlled), the oscillation mode loss can be controlled with a higher degree of freedom, and the degree of freedom in designing the light emitting element can be further increased.

In Example 9, the shape of the boundary between the current injection region 51 and the current non-injection/inner region 52 was circular (diameter: 8 $\mu$m), and the shape of the boundary between the current non-injection/inner region 52 and the current non-injection/outer region 53 was circular (diameter: 12 $\mu$m). That is, when the area of the orthogonal projection image of the current injection region 51 is $S_1$ and the area of the orthogonal projection image of the current non-injection/inner region 52 is $S_2$,

$0.01 \leq S_1/(S_1 + S_2) \leq 0.7$ is satisfied. Specifically,

$$S_1/(S_1 + S_2) = 8^2/12^2 = 0.44.$$

In the light emitting element of Example 9 or Examples 10 to 11 and Example 13 described later, when an optical distance from the active layer 23 to the second surface of the second compound semiconductor layer 22 in the current injection region 51 is $OL_2$, and an optical distance from the active layer 23 to the top surface (surface facing the second electrode 32) of the mode loss action site 54 in the mode loss action region 55 is $OL_0$,

$OL_0 > OL_2$ is satisfied. Specifically,

$OL_0/OL_2 = 1.5$. Then, the generated laser beam having the higher mode is dissipated toward the outside of the resonator structure configured by the first light reflecting layer 41 and the second light reflecting layer 42 by the mode loss action region 55, and thus, the oscillation mode loss increases. That is, the light field intensity of the generated fundamental mode and higher mode decreases as the distance from the Z-axis increases in the orthogonal projection image of the mode loss action region 55 due to the presence of the mode loss action region 55 that acts to increase or decrease the oscillation mode loss (see the conceptual diagram of (B) of Fig. 24). However, the decrease in the light field intensity of the higher mode is larger than the decrease in the light field intensity of the fundamental mode, the fundamental mode can be further stabilized, the threshold current can be reduced, and the relative light field intensity of the fundamental mode can be increased. Moreover, since the hem portion of the light field intensity of the higher mode is located farther from the current injection region than the conventional light emitting element (see (A) of Fig. 24), the influence of the inverse lens effect can be reduced. Note that, in a case where the mode loss action site 54 including $SiO_2$ is not provided in the first place, the oscillation mode mixture occurs.

The first compound semiconductor layer 21 includes an n-GaN layer, the active layer 23 includes a five-layered multiple quantum well structure in which an $In_{0.04}Ga_{0.96}N$ layer (barrier layer) and an $In_{0.16}Ga_{0.84}N$ layer (well layer) are laminated, and the second compound semiconductor layer 22 includes a p-GaN layer. Furthermore, the first electrode 31 includes Ti/Pt/Au, and the second electrode 32 includes a transparent conductive material, specifically, ITO. A circular opening portion 54A is formed in the mode loss action site 54, and the second compound semiconductor layer 22 is exposed at the bottom of the opening portion 54A. A first pad electrode (not illustrated) including, for example, Ti/Pt/Au or V/Pt/Au for electrical connection with an external circuit and the like is formed or connected on the edge portion of the first electrode 31. On the edge portion of the second electrode 32, a second pad electrode 33 including, for example, Ti/Pd/Au or Ti/Ni/Au for electrical connection with an external circuit and the like is formed or connected. The first light reflecting layer 41 and the second light reflecting layer 42 have a laminated structure of a SiN layer and a $SiO_2$ layer (total number of laminated dielectric films: 20 layers).

In the light emitting element of Example 9, the current non-injection/inner region 52 and the current non-injection/outer region 53 are formed by ion injection into the laminated structure 20. For example, boron was selected as the ion species, but the ion species is not limited to boron ions.

Hereinafter, an outline of a method for manufacturing a light emitting element of Example 9 will be described.

[Step-900]

In the manufacture of the light emitting element of Example 9, first, a step similar to [Step-100] of Example 1 is executed.

[Step-910]

Next, the current non-injection/inner region 52 and the current non-injection/outer region 53 are formed in the laminated structure 20 based on an ion injection method using boron ions.

[Step-920]

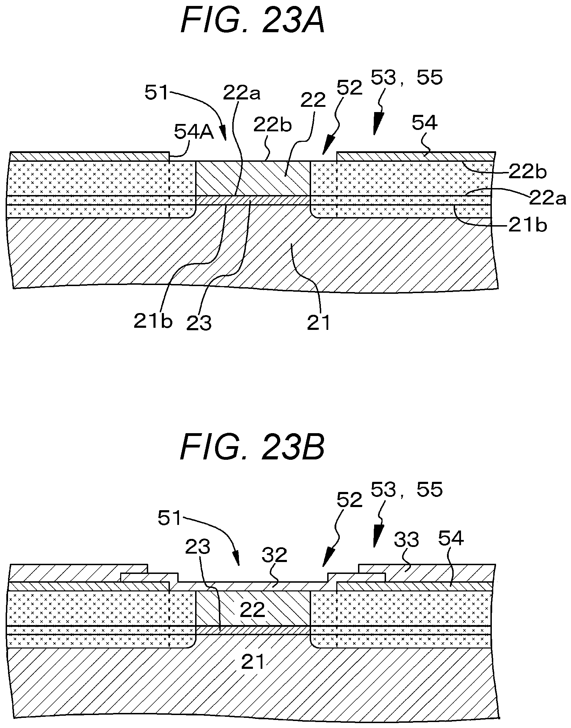

Thereafter, in a step similar to [Step-110] of Example 1, the mode loss action site (mode loss action layer) 54 having an opening portion 54A and containing $SiO_2$ is formed on the second surface 22b of the second compound semiconductor layer 22 based on a known method (see Fig. 23A).

[Step-930]

Thereafter, the light emitting element of Example 9 can be obtained by executing steps similar to the steps after [Step-120] of Example 1. Note that Fig. 23B illustrates a structure obtained in the middle of a step similar to [Step-120].

In the light emitting element of Example 9, the current injection region, the current non-injection/inner region surrounding the current injection region, and the current non-injection/outer region surrounding the current non-injection/inner region are formed in the laminated structure, and the orthogonal projection image of the mode loss action region and the orthogonal projection image of the current non-injection/outer region overlap each other. That is, the current injection region and the mode loss action region are separated (separated) by the current non-injection/inner region. Therefore, as illustrated in the conceptual diagram of (B) of Fig. 24, it is possible to set the increase or decrease (specifically, it is increased in Example 9) of the oscillation mode loss to a desired state. Alternatively, by appropriately determining the positional relationship between the current injection region and the mode loss action region, the thickness of the mode loss action site constituting the mode loss action region, and the like, it is possible to set the increase or decrease of the oscillation mode loss to a desired state. Then, as a result, it is possible to solve problems in the conventional light emitting element, such as an increase in threshold current and deterioration in slope efficiency. For example, the threshold current can be reduced by reducing the oscillation mode loss in the fundamental mode. Moreover, since the region to which the oscillation mode loss is applied and the region to which the current is injected and which contributes to light emission can be controlled independently, that is, since the control of the oscillation mode loss and the control of the light emitting state of the light emitting element can be performed independently, the degree of freedom in control and the degree of freedom in designing the light emitting element can be increased. Specifically, by setting the current injection region, the current non-injection region, and the mode loss action region to have the above-described predetermined arrangement relationship, it is possible to control a magnitude relationship of the oscillation mode loss given by the mode loss action region to the fundamental mode and the higher-order mode, and it is possible to further stabilize the fundamental mode by relatively increasing the oscillation mode loss given to the higher-order mode with respect to the oscillation mode loss given to the fundamental mode. Moreover, note that, since the light emitting element of Example 9 has the first region 91 (more specifically, the first-A region 91A), occurrence of diffraction loss can be more reliably suppressed.

[Example 10]

Example 10 is a modification of Example 9, and relates to the light emitting element of the configuration 5-B. As illustrated in the schematic partial cross-sectional view in Fig. 25, in the light emitting element of Example 10, the current non-injection/inner region 52 and the current non-injection/outer region 53 are formed by plasma irradiation to the second surface of the second compound semiconductor layer 22, ashing processing to the second surface of the second compound semiconductor layer 22, or reactive ion etching (RIE) processing to the second surface of the second compound semiconductor layer 22. Then, since the current non-injection/inner region 52 and the current non-injection/outer region 53 are exposed to the plasma particles (specifically, argon, oxygen, nitrogen, and the like) in this manner, the conductivity of the second compound semiconductor layer 22 is deteriorated, and the current non-injection/inner region 52 and the current non-injection/outer region 53 are in a high resistance state. That is, the current non-injection/inner region 52 and the current non-injection/outer region 53 are formed by exposure of the second surface 22b of the second compound semiconductor layer 22 to plasma particles.

Also in Example 10, the shape of the boundary between the current injection region 51 and the current non-injection/inner region 52 was circular (diameter: 10 $\mu$m), and the shape of the boundary between the current non-injection/inner region 52 and the current non-injection/outer region 53 was circular (diameter: 15 $\mu$m). That is, when the area of the orthogonal projection image of the current injection region 51 is $S_1$ and the area of the orthogonal projection image of the current non-injection/inner region 52 is $S_2$,

$$0.01 \leq S_1/(S_1 + S_2) \leq 0.7$$

is satisfied. Specifically,

$$S_1/(S_1 + S_2) = 10^2/15^2 = 0.44.$$

In Example 10, instead of [Step-910] of Example 9, the current non-injection/inner region 52 and the current non-injection/outer region 53 may be formed in the laminated structure 20 based on plasma irradiation to the second surface of the second compound semiconductor layer 22, ashing processing to the second surface of the second compound semiconductor layer 22, or reactive ion etching processing to the second surface of the second compound semiconductor layer 22.

Except for the above points, the configuration and structure of the light emitting element of Example 10 can be similar to those of the light emitting element of Example 9, and thus the detailed description thereof will be omitted.

Even in the light emitting element of Example 10 or Example 11 described later, by setting the current injection region, the current non-injection region, and the mode loss action region to have the above-described predetermined arrangement relationship, it is possible to control the magnitude relationship of the oscillation mode loss given by the mode loss action region to the fundamental mode and the higher-order mode, and it is possible to further stabilize the fundamental mode by relatively increasing the oscillation mode loss given to the higher-order mode with respect to the oscillation mode loss given to the fundamental mode.

[Example 11]

Example 11 is a modification of Examples 9 and 10, and relates to the light emitting element of the configuration 5-C. As illustrated in a schematic partial cross-sectional view in Fig. 26, in the light emitting element of Example 11, the second light reflecting layer 42 has a region that reflects or scatters the light from the first light reflecting layer 41 toward the outside of the resonator structure (that is, toward the mode loss action region 55) configured by the first light reflecting layer 41 and the second light reflecting layer 42. Specifically, the portion of the second light reflecting layer 42 located above the side wall (side wall of the opening portion 54B) of the mode loss action site (mode loss action layer) 54 has the forward tapered inclined portion 42A or has a region curved convexly toward the first light reflecting layer 41.

In Example 11, the shape of the boundary between the current injection region 51 and the current non-injection/inner region 52 was circular (diameter: 8 $\mu$m), and the shape of the boundary between the current non-injection/inner region 52 and the current non-injection/outer region 53 was circular (diameter: 10 $\mu$m to 20 $\mu$m).

In Example 11, in a step similar to [Step-920] of Example 9, when the opening portion 54B is provided and the mode loss action site (mode loss action layer) 54 containing $SiO_2$ is formed, the opening portion 54B having the forward tapered sidewall may be formed. Specifically, a resist layer is formed on the mode loss action layer formed on the second surface 22b of the second compound semiconductor layer 22, and an opening portion is provided in a portion of the resist layer where the opening portion 54B is to be formed based on a photolithography technique. According to a known method, a side wall of the opening portion is formed in a forward tapered shape. Then, by performing etch-back, the opening portion 54B having the forward tapered sidewall can be formed in the mode loss action site (mode loss action layer) 54. Furthermore, by forming the second electrode 32 and the second light reflecting layer 42 on such a mode loss action site (mode loss action layer) 54, the forward tapered inclined portion 42A can be provided to the second light reflecting layer 42.

Except for the above points, the configuration and structure of the light emitting element of Example 11 can be similar to those of the light emitting elements of Examples 9 and 10, and thus the detailed description thereof is omitted.

[Example 12]

Example 12 is a modification of Examples 9 to 11, and relates to the light emitting element of the configuration 5-D. As Fig. 27A illustrates a schematic partial cross-sectional view of a light emitting element of Example 12, and Fig. 27B illustrates a schematic partial cross-sectional view obtained by cutting out a main part, a protrusion 22A is formed on a side of the second surface of the second compound semiconductor layer 22. Then, as illustrated in Figs. 27A and 27B, the mode loss action site (mode loss action layer) 54 is formed in a region 22B of the second surface 22b of the second compound semiconductor layer 22 surrounding the protrusion 22A. The protrusion 22A occupies the current injection region 51, the current injection region 51, and the current non-injection/inner region 52. The mode loss action site (mode loss action layer) 54 includes a dielectric material such as $SiO_2$, for example, in a similar manner to Example 9. In the region 22B, a current non-injection/outer region 53 is provided. When an optical distance from the active layer 23 to the second surface of the second compound semiconductor layer 22 in the current injection region 51 is $OL_2$ and an optical distance from the active layer 23 to the top surface (surface facing the second electrode 32) of the mode loss action site 54 in the mode loss action region 55 is $OL_0$,
$OL_0 < OL_2$ is satisfied. Specifically,
$OL_2/OL_0 = 1.5$. As a result, a lens effect is generated in the light emitting element.

In the light emitting element of Example 12, the generated laser beam having the higher mode is confined in the current injection region 51 and the current non-injection/inner region 52 by the mode loss action region 55, and thus, the oscillation mode loss decreases. That is, the light field intensity of the generated fundamental mode and higher mode increases in the orthogonal projection images of the current injection region 51 and the current non-injection/inner region 52 due to the presence of the mode loss action region 55 that acts to increase or decrease the oscillation mode loss.

In Example 12, the shape of the boundary between the current injection region 51 and the current non-injection/inner region 52 was circular (diameter: 8 $\mu$m), and the shape of the boundary between the current non-injection/inner region 52 and the current non-injection/outer region 53 was circular (diameter: 30 $\mu$m).

In Example 12, the protrusion 22A may be formed by removing a part of the second compound semiconductor layer 22 from a side of the second surface between [Step-910] and [Step-920] of Example 9.

Except for the above points, the configuration and structure of the light emitting element of Example 12 can be similar to those of the light emitting element of Example 9, and thus the detailed description thereof will be omitted. In the light emitting element of Example 12, it is possible to suppress the oscillation mode loss caused by the mode loss action region for various modes, to perform multimode oscillation in the lateral mode, and to reduce the threshold of laser oscillation. Furthermore, as illustrated in the conceptual diagram in (C) of Fig. 24, the light field intensity of the generated fundamental mode and higher mode can be increased in the orthogonal projection images of the current injection region and the current non-injection/inner region by the presence of the mode loss action region acting on the increase/decrease (specifically, in Example 12, a decrease) of the oscillation mode loss.

[Example 13]

Example 13 is a modification of Examples 9 to 12. More specifically, the light emitting element of Example 13 or Example 14 described later includes a surface emitting laser element (light emitting element) (Vertical Cavity Laser, VCSEL) that emits a laser beam from the first surface 21a of the first compound semiconductor layer 21 via the first light reflecting layer 41.

In the light emitting element of Example 13, as illustrated in a schematic partial cross-sectional view in Fig. 28, the second light reflecting layer 42 is fixed to the support substrate 49 including a silicon semiconductor substrate via the bonding layer 48 including a gold (Au) layer or a solder layer containing tin (Sn) based on a solder bonding method. In manufacturing the light emitting element of Example 13, for example, steps similar to [Step-900] to [Step-930] of Example 9 may be executed except for the removal of the support substrate 49, that is, without removing the support substrate 49.

Even in the light emitting element of Example 13, by setting the current injection region, the current non-injection region, and the mode loss action region to have the above-described predetermined arrangement relationship, it is possible to control the magnitude relationship of the oscillation mode loss given by the mode loss action region to the fundamental mode and the higher-order mode, and it is possible to further stabilize the fundamental mode by relatively increasing the oscillation mode loss given to the higher-order mode with respect to the oscillation mode loss given to the fundamental mode.

In the example of the light emitting element described above and illustrated in Fig. 28, an end portion of the first electrode 31 is separated from the first light reflecting layer 41. However, the present invention is not limited to such a structure, and the end portion of the first electrode 31 may be in contact with the first light reflecting layer 41, or the end portion of the first electrode 31 may be formed over the edge portion of the first light reflecting layer 41.

Furthermore, for example, after the steps similar to [Step-900] to [Step-930] of Example 9 are executed, the substrate 11 for manufacturing a light emitting element may be removed to expose the first surface 21a of the first compound semiconductor layer 21, and then the first light reflecting layer 41 and the first electrode 31 may be formed on the first surface 21a of the first compound semiconductor layer 21.

[Example 14]

Example 14 is a modification of Examples 1 to 13, but relates to the light emitting element of configuration 6, specifically, the light emitting element of configuration 6-A. More specifically, the light emitting element of Example 14 includes a surface emitting laser element (light emitting element) (Vertical Cavity Laser, VCSEL) that emits a laser beam from the first surface 21a of the first compound semiconductor layer 21 via the first light reflecting layer 41.

The light emitting element of Example 14 illustrated in a schematic partial end view in Fig. 29 includes:

(a) the laminated structure 20 in which the first compound semiconductor layer 21 including a GaN-based compound semiconductor and having the first surface 21a and the second surface 21b facing the first surface 21a, the active layer (light emitting layer) 23 including a GaN-based compound semiconductor and in contact with the second surface 21b of the first compound semiconductor layer 21, and the second compound semiconductor layer 22 including a GaN-based compound semiconductor, having the first surface 22a and a second surface 22b facing the first surface 22a, the first surface 22a being in contact with the active layer 23 are laminated;
(b) the second electrode 32 formed on the second surface 22b of the second compound semiconductor layer 22;
(c) the second light reflecting layer 42 formed on the second electrode 32;
(d) the mode loss action site 64 provided on the first surface 21a of the first compound semiconductor layer 21 and constituting the mode loss action region 65 acting to the increase or decrease the oscillation mode loss;
(e) the first light reflecting layer 41 formed from above the first surface 21a of the first compound semiconductor layer 21 to above the mode loss action site 64; and
(f) the first electrode 31 electrically connected to the first compound semiconductor layer 21. Note that, in the light emitting element of Example 14, the first electrode 31 is formed on the first surface 21a of the first compound semiconductor layer 21.

Then, in the laminated structure 20, the current non-injection region 61, the current non-injection/inner region 62 surrounding the current injection region 61, and the current non-injection/outer region 63 surrounding the current non-injection/inner region 62 are formed, and the orthogonal projection image of the mode loss action region 65 and the orthogonal projection image of the current non-injection/outer region 63 overlap each other. Here, the current non-injection regions 62 and 63 are formed in the laminated structure 20, but are formed in the thickness direction from the second compound semiconductor layer 22 to a part of the first compound semiconductor layer 21 in the illustrated example. However, the current non-injection regions 62 and 63 may be formed in a region on the second electrode side of the second compound semiconductor layer 22 in the thickness direction, may be formed in the entire second compound semiconductor layer 22, or may be formed in the second compound semiconductor layer 22 and the active layer 23.

The configurations of the laminated structure 20, the second pad electrode 33, the first light reflecting layer 41, and the second light reflecting layer 42 can be similar to those in Example 9, and the configurations of the bonding layer 48 and the support substrate 49 can be similar to those in Example 13. A circular opening portion 64A is formed in the mode loss action site 64, and the first surface 21a of the first compound semiconductor layer 21 is exposed at the bottom of the opening portion 64A.

The mode loss action site (mode loss action layer) 64 includes a dielectric material such as $SiO_2$, and is formed on the first surface 21a of the first compound semiconductor layer 21. The optical thickness to of the mode loss action site 64 can be a value deviating from an integral multiple of 1/4 of the wavelength $\lambda_0$ of the light generated in the light emitting element. Alternatively, the optical thickness to of the mode loss action site 64 can be an integral multiple of 1/4 of the wavelength $\lambda_0$ of the light generated in the light emitting element. That is, the optical thickness to of the mode loss action site 64 can be set to a thickness that does not disturb the phase of the light generated in the light emitting element and does not destroy the standing wave. However, it is not necessary to strictly be an integral multiple of 1/4 as long as

$$(\lambda_0/4n_0) \times m - (\lambda_0/8n_0) \leq t_0 \leq (\lambda_0/4n_0) \times 2m + (\lambda_0/8n_0)$$

is satisfied. Specifically, the optical thickness to of the mode loss action site 64 is preferably about 25 to 250 when a value of 1/4 of the wavelength $\lambda_0$ of the light generated in the light emitting element is set to "100". Then, by adopting these configurations, the phase difference between the laser beam passing through the mode loss action site 64 and the laser beam passing through the current injection region 61 can be changed (the phase difference can be controlled), the oscillation mode loss can be controlled with a higher degree of freedom, and the degree of freedom in designing the light emitting element can be further increased.

In Example 14, the shape of the boundary between the current injection region 61 and the current non-injection/inner region 62 was circular (diameter: 8 $\mu$m), and the shape of the boundary between the current non-injection/inner region 62 and the current non-injection/outer region 63 was circular (diameter: 15 $\mu$m). That is, when the area of the orthogonal projection image of the current injection region 61 is $S_1'$ and the area of the orthogonal projection image of the current non-injection/inner region 62 is $S_2'$,

$$0.01 \leq S_1'/(S_1' + S_2') \leq 0.7$$

is satisfied. Specifically,

$$S_1'/(S_1' + S_2') = 8^2/15^2 = 0.28.$$

In the light emitting element of Example 14, when an optical distance from the active layer 23 to the first surface of the first compound semiconductor layer 21 in the current injection region 61 is $OL_1'$, and an optical distance from the active layer 23 to the top surface (surface facing the first electrode 31) of the mode loss action site 64 in the mode loss action region 65 is $OL_0'$,
$OL_0' > OL_1'$
is satisfied. Specifically,

$$OL_0'/OL_1' = 1.01.$$

Then, the generated laser beam having the higher mode is dissipated toward the outside of the resonator structure configured by the first light reflecting layer 41 and the second light reflecting layer 42 by the mode loss action region 65, and thus, the oscillation mode loss increases. That is, the light field intensity of the generated fundamental mode and higher mode decreases as the distance from the Z-axis increases in the orthogonal projection image of the mode loss action region 65 due to the presence of the mode loss action region 65 that acts to increase or decrease the oscillation mode loss (see the conceptual diagram of (B) of Fig. 24). However, the decrease in the light field intensity of the higher mode is larger than the decrease in the light field intensity of the fundamental mode, the fundamental mode can be further stabilized, the threshold current can be reduced, and the relative light field intensity of the fundamental mode can be increased.

In the light emitting element of Example 14, the current non-injection/inner region 62 and the current non-injection/outer region 63 are formed by ion injection into the laminated structure 20 in a similar manner to Example 9. For example, boron was selected as the ion species, but the ion species is not limited to boron ions.

Hereinafter, a method for manufacturing a light emitting element of Example 14 will be described.

[Step-1400]

First, the laminated structure 20 can be obtained by executing a step similar to [Step-900] of Example 9. Next, by executing a step similar to [Step-910] of Example 9, the current non-injection/inner region 62 and the current non-injection/outer region 63 can be formed in the laminated structure 20.

[Step-1410]

Next, the second electrode 32 is formed on the second surface 22b of the second compound semiconductor layer 22 based on, for example, a lift-off method, and the second pad electrode 33 is further formed based on a known method. Thereafter, the second light reflecting layer 42 is formed from the top of the second electrode 32 to the top of the second pad electrode 33 based on a known method.

[Step-1420]

Thereafter, the second light reflecting layer 42 is fixed to the support substrate 49 via the bonding layer 48.

[Step-1430]

Next, the substrate 11 for manufacturing a light emitting element is removed to expose the first surface 21a of the first compound semiconductor layer 21. Specifically, first, the thickness of the substrate 11 for manufacturing a light emitting element is reduced based on a mechanical polishing method, and then the remaining portion of the substrate 11 for manufacturing a light emitting element is removed based on a CMP method. In this way, the first surface 21a of the first compound semiconductor layer 21 is exposed, and then the base surface 90 having the first region 91 and the second region 92 is formed on the first surface 21a of the first compound semiconductor layer 21.

[Step-1440]

Thereafter, on the first surface 21a of the first compound semiconductor layer 21 (specifically, on the second region 92 of the base surface 90,), the mode loss action site (mode loss action layer) 64 having the opening portion 64A and containing $SiO_2$ is formed based on a known method.

[Step-1450]

Next, the first light reflecting layer 41 is formed on the first region 91 of the first surface 21a of the first compound semiconductor layer 21 exposed at the bottom of the opening portion 64A of the mode loss action site 64, and the first electrode 31 is further formed. Note that a part of the first electrode 31 penetrates the mode loss action site (mode loss action layer) 64 and reaches the first compound semiconductor layer 21 in a region (not illustrated). In this way, the light emitting element of Example 14 having the structure illustrated in Fig. 29 can be obtained.

Even in the light emitting element of Example 14, the current injection region, the current non-injection/inner region surrounding the current injection region, and the current non-injection/outer region surrounding the current non-injection/inner region are formed in the laminated structure, and the orthogonal projection image of the mode loss action region and the orthogonal projection image of the current non-injection/outer region overlap each other. Therefore, as illustrated in the conceptual diagram of (B) of Fig. 24, it is possible to set the increase or decrease of the oscillation mode loss (specifically, it is increased in Example 14) to a desired state. Moreover, since the control of the oscillation mode loss and the control of the light emitting state of the light emitting element can be performed independently, the degree of freedom in control and the degree of freedom in designing the light emitting element can be increased. Specifically, by setting the current injection region, the current non-injection region, and the mode loss action region to have the above-described predetermined arrangement relationship, it is possible to control the magnitude relationship of the oscillation mode loss given by the mode loss action region to the fundamental mode and the higher-order mode, and it is possible to further stabilize the fundamental mode by relatively increasing the oscillation mode loss given to the higher-order mode with respect to the oscillation mode loss given to the fundamental mode. Furthermore, the influence of the inverse lens effect can be reduced. Moreover, note that, since the light emitting element of Example 14 has the first region 91 (more specifically, the first-A region 91A), occurrence of diffraction loss can be more reliably suppressed.

Also in Example 14, in a similar manner to Example 10, the current non-injection/inner region 62 and the current non-injection/outer region 63 can be formed by plasma irradiation to the second surface of the second compound semiconductor layer 22, ashing processing to the second surface of the second compound semiconductor layer 22, or reactive ion etching (RIE) processing to the second surface of the second compound semiconductor layer 22 (light emitting element of configuration 6-B). By exposing the current non-injection/inner region 62 and the current non-injection/outer region 63 to the plasma particles in this manner, the conductivity of the second compound semiconductor layer 22 is deteriorated, and the current non-injection/inner region 62 and the current non-injection/outer region 63 are in a high resistance state. That is, the current non-injection/inner region 62 and the current non-injection/outer region 63 are formed by exposure of the second surface 22b of the second compound semiconductor layer 22 to plasma particles.

Furthermore, in a similar manner to Example 11, the second light reflecting layer 42 may have a configuration having a region that reflects or scatters the light from the first light reflecting layer 41 toward (that is, toward the mode loss action region 65) the outside of the resonator structure configured by the first light reflecting layer 41 and the second light reflecting layer 42 (light emitting element of configuration 6-C).

Furthermore, in a similar manner to Example 12, the mode loss action site (mode loss action layer) 64 may be formed (light emitting element of configuration 6-D). The mode loss action site (mode loss action layer) 64 may be formed in the region of the first surface 21a of the first compound semiconductor layer 21 surrounding the protrusion. The protrusion occupies the current injection region 61, the current injection region 61, and the current non-injection/inner region 62. Then, as a result, the generated laser beam having the higher mode is confined in the current injection region 61 and the current non-injection/inner region 62 by the mode loss action region 65, and thus, the oscillation mode loss decreases. That is, the light field intensity of the generated fundamental mode and higher mode increases in the orthogonal projection images of the current injection region 61 and the current non-injection/inner region 62 due to the presence of the mode loss action region 65 that acts to increase or decrease the oscillation mode loss. Even in the modification of the light emitting element of Example 14 having such a configuration, it is possible to suppress the oscillation mode loss provided by the mode loss action region 65 for various modes, to perform the multimode oscillation in the lateral mode, and to reduce the threshold current of the laser oscillation. Furthermore, as illustrated in the conceptual diagram in (C) of Fig. 24, the light field intensity of the generated fundamental mode and higher mode can be increased in the orthogonal projection images of the current injection region and the current non-injection/inner region by the presence of the mode loss action region 65 acting on the increase/decrease (specifically, in a modified example of the light emitting element of Example 14, the amount is reduced) of the oscillation mode loss.

[Example 15]

Example 15 is a modification of Examples 1 to 14, and relates to the light emitting element of the seventh configuration.

Meanwhile, when the equivalent refractive index of the entire laminated structure is $n_{eq}$, and the wavelength of the laser beam to be emitted from a surface emitting laser element (light emitting element) is $\lambda_0$, a resonator length $L_{OR}$ in the laminated structure constituted by the two DBR layers and the laminated structure formed therebetween is represented by

$$L = (m \cdot \lambda_0) / (2 \cdot n_{eq}).$$

Here, m is a positive integer. Then, in the surface emitting laser element (light emitting element), the oscillatable wavelength is determined by the resonator length $L_{OR}$. Each oscillatable oscillation mode is called a vertical mode. Then, among the vertical modes, a mode that matches the gain spectrum determined by the active layer can cause laser oscillation. When the effective refractive index is $n_{eff}$, the interval $\Delta\lambda$ between the vertical modes is represented by

$$\lambda_0{}^2 / (2n_{eff} \cdot L).$$

That is, the longer the resonator length $L_{OR}$, the narrower the interval $\Delta\lambda$ between the vertical modes. Therefore, in a case where the resonator length $L_{OR}$ is long, a plurality of vertical modes may exist in the gain spectrum, and thus a plurality of vertical modes may oscillate. Note that the equivalent refractive index $n_{eq}$ and the effective refractive index $n_{eff}$ have the following relationship when the oscillation wavelength is $\lambda_0$.

$$n_{eff} = n_{eq} - \lambda_0 \cdot (dn_{eq} / d\lambda_0)$$

Here, in a case where the laminated structure includes a GaAs-based compound semiconductor layer, the resonator length $L_{OR}$ is usually as short as 1 μm or less, and one type (one wavelength) of laser beam in the vertical mode is emitted from the surface emitting laser element (see the conceptual diagram of Fig. 53A). Therefore, it is possible to accurately control the oscillation wavelength of the laser beam in the vertical mode emitted from the surface emitting laser element. Meanwhile, in a case where the laminated structure includes a GaN-based compound semiconductor layer, the resonator length $L_{OR}$ is usually as long as several times the wavelength of the laser beam emitted from the surface emitting laser element. Therefore, there is a plurality of types of laser beam in the vertical mode that can be emitted from the surface emitting laser element (see the conceptual diagram of Fig. 53B), and it becomes difficult to accurately control the oscillation wavelength of the laser beam that can be emitted from the surface emitting laser element.

As illustrated in a schematic partial cross-sectional view in Fig. 30, in the light emitting element of Example 15 or the light emitting elements of Examples 16 to 18 described later, at least two light absorbing material layers 71, preferably at least four light absorbing material layers 71, and specifically 20 light absorbing material layers 71 in Example 15 are formed in the laminated structure 20 including the second electrode 32 in parallel with the virtual plane (XY plane) occupied by the active layer 23. Note that, in order to simplify the drawing, only the two light absorbing material layers 71 are illustrated in the drawing.

In Example 15, the oscillation wavelength (desired oscillation wavelength emitted from the light emitting element) $\lambda_0$ is 450 nm. The 20 light absorbing material layers 71 include a compound semiconductor material having a band gap narrower than that of the compound semiconductor constituting the laminated structure 20, specifically, n-$In_{0.2}Ga_{0.8}N$, and are formed inside the first compound semiconductor layer 21. The thickness of the light absorbing material layer 71 is $\lambda_0/(4 \cdot n_{eq})$ or less, specifically, 3 nm. Furthermore, the light absorption coefficient of the light absorbing material layer 71 is 2 times or more, specifically, $1 \times 10^3$ times the light absorption coefficient of the first compound semiconductor layer 21 including the n-GaN layer.

Furthermore, the light absorbing material layer 71 is located at a minimum amplitude portion generated in a standing wave of light formed inside the laminated structure, and the active layer 23 is located at a maximum amplitude portion generated in a standing wave of light formed inside the laminated structure. A distance between a center of the active layer 23 in the thickness direction and a center of the light absorbing material layer 71 adjacent to the active layer 23 in the thickness direction is 46.5 nm. Furthermore, when an equivalent refractive index of the whole of the two light absorbing material layers 71 and a portion (specifically, in Example 15, the first compound semiconductor layer 21) of the laminated structure located between the light absorbing material layers 71 and 71 is $n_{eq}$, and a distance between the light absorbing material layers 71 and 71 is $L_{Abs}$,

$$0.9 \times \{(m \cdot \lambda_0)/(2 \cdot n_{eq})\} \le L_{Abs} \le 1.1 \times \{(m \cdot \lambda_0)/(2 \cdot n_{eq})\}$$

is satisfied. Here, m is 1 or an arbitrary integer of 2 or more including 1. However, in Example 15, m was 1. Therefore, in all the plurality of light absorbing material layers 71 (20 light absorbing material layers 71), the distance between the adjacent light absorbing material layers 71 satisfies that

$$0.9 \times \{\lambda_0/(2 \cdot n_{eq})\} \le L_{Abs} \le 1.1 \times \{\lambda_0/(2 \cdot n_{eq})\}.$$

The value of the equivalent refractive index $n_{eq}$ is specifically 2.42, and when m = 1, specifically,

$$L_{Abs} = 1 \times 450/(2 \times 2.42)$$
$$= 93.0 \text{ nm}.$$

Note that, in some light absorbing material layers 71 of the 20 light absorbing material layers 71, m may be an arbitrary integer of 2 or more.

In the manufacture of the light emitting element of Example 15, the laminated structure 20 is formed in the step similar to [Step-100] of Example 1, and at this time, 20 light absorbing material layers 71 are also formed inside the first compound semiconductor layer 21. Except for this point, the light emitting element of Example 15 can be manufactured based on the method similar to the light emitting element of Example 1.

In a case where a plurality of vertical modes occurs in the gain spectrum determined by the active layer 23, this is schematically illustrated in Fig. 31. Note that Fig. 31 illustrates two vertical modes, a vertical mode A and a vertical mode B. Then, in this case, it is assumed that the light absorbing material layer 71 is located in the minimum amplitude portion of the vertical mode A and is not located in the minimum amplitude portion of the vertical mode B. Then, the mode loss of the vertical mode A is minimized, but the mode loss of the vertical mode B is large. In Fig. 31, the mode loss component of the vertical mode B is schematically indicated by a solid line. Therefore, the vertical mode A is more likely to oscillate than the vertical mode B. Therefore, by using such a structure, that is, by controlling the position and period of the light absorbing material layer 71, a specific vertical mode can be stabilized and oscillation can be facilitated. Meanwhile, since it is possible to increase the mode loss with respect to the other undesirable vertical modes, it is possible to suppress the oscillation of the other undesirable vertical modes.

As described above, in the light emitting element of Example 15, since at least two light absorbing material layers are formed inside the laminated structure, it is possible to suppress oscillation of undesired laser beam in a vertical mode among a plurality of types of laser beam in a vertical mode that can be emitted from the surface emitting laser element. As a result, the oscillation wavelength of the emitted laser beam can be accurately controlled. Moreover, note that since the light emitting element of Example 15 has the first region 91 (more specifically, the first-A region 91A), occurrence of diffraction loss can be reliably suppressed.

[Example 16]

Example 16 is a modification of Example 15. In Example 15, the light absorbing material layer 71 included a compound semiconductor material having a band gap narrower than that of the compound semiconductor constituting the laminated structure 20. Meanwhile, in Example 16, ten light absorbing material layers 71 included a compound semiconductor material doped with impurities, specifically, a compound semiconductor material (specifically, n-GaN: Si) having an impurity concentration (impurity: Si) of $1 \times 10^{19}/cm^3$. Furthermore, in Example 16, the oscillation wavelength $\lambda_0$ was 515 nm. Note that the composition of the active layer 23 is $In_{0.3}Ga_{0.7}N$. In Example 16, m = 1, the value of $L_{Abs}$ is 107 nm, the distance between the center of the active layer 23 in the thickness direction and the center of the light absorbing material layer 71 adjacent to the active layer 23 in the thickness direction is 53.5 nm, and the thickness of the light absorbing material layer 71 is 3 nm. Except for the above points, the configuration and structure of the light emitting element of Example 16 can be similar to the configuration and structure of the light emitting element of Example 15, and thus detailed description is omitted. Note that, in some light absorbing material layers 71 of the ten light absorbing material layers 71, m may be an arbitrary integer of 2 or more.

[Example 17]

Example 17 is also a modification of Example 15. In Example 17, the five light absorbing material layers (referred to as a "first light absorbing material layer" for convenience) were configured similarly to the light absorbing material layer 71 of Example 15, that is, included $n-In_{0.3}Ga_{0.7}N$. Furthermore, in Example 17, one light absorbing material layer (referred to as a "second light absorbing material layer" for convenience) included a transparent conductive material. Specifically, the second light absorbing material layer was also used as the second electrode 32 including ITO. In Example 17, the oscillation wavelength $\lambda_0$ was set to 450 nm. Furthermore, m was set to 1 and 2. For m = 1, the value of $L_{Abs}$ is 93.0 nm, the distance between the center of the active layer 23 in the thickness direction and the center of the first light absorbing material layer adjacent to the active layer 23 in the thickness direction is 46.5 nm, and the thickness of the five first light absorbing material layers is 3 nm. That is, in the five first light absorbing material layers,

$$0.9 \times \{\lambda_0/(2 \cdot n_{eq})\} \leq L_{Abs} \leq 1.1 \times \{\lambda_0/(2 \cdot n_{eq})\}$$

is satisfied. Furthermore, the first light absorbing material layer and the second light absorbing material layer adjacent to the active layer 23 had m = 2. That is,

$$0.9 \times \{(2 \cdot \lambda_0)/(2 \cdot n_{eq})\} \leq L_{Abs} \leq 1.1 \times \{(2 \cdot \lambda_0)/(2 \cdot n_{eq})\}$$

is satisfied. One second light absorbing material layer also serving as the second electrode 32 has a light absorption coefficient of 2000 cm$^{-1}$ and a thickness of 30 nm, and a distance from the active layer 23 to the second light absorbing material layer is 139.5 nm. Except for the above points, the configuration and structure of the light emitting element of Example 17 can be similar to the configuration and structure of the light emitting element of Example 15, and thus detailed description is omitted. Note that, in some first light absorbing material layers of the five first light absorbing material layers, m may be an arbitrary integer of 2 or more. Note that, unlike Example 15, the number of the light absorbing material layers 71 may be 1. Also in this case, the positional relationship between the second light absorbing material layer also serving as the second electrode 32 and the light absorbing material layer 71 needs to satisfy the following expression.

$$0.9 \times \{(m \cdot \lambda_0)/(2 \cdot n_{eq})\} \leq L_{Abs} \leq 1.1 \times \{(m \cdot \lambda_0)/(2 \cdot n_{eq})\}$$

[Example 18]

Example 18 is a modification of Examples 15 to 17. More specifically, the light emitting element of Example 18 includes a surface emitting laser element (Vertical Cavity Laser, VCSEL) that emits laser beam from the first surface 21a of the first compound semiconductor layer 21 via the first light reflecting layer 41.

In the light emitting element of Example 18, as illustrated in a schematic partial cross-sectional view in Fig. 32, the second light reflecting layer 42 is fixed to the support substrate 49 including a silicon semiconductor substrate via the bonding layer 48 including a gold (Au) layer or a solder layer containing tin (Sn) based on a solder bonding method.

The light emitting element of Example 18 can be manufactured based on a method similar to the light emitting element of Example 1 except that 20 light absorbing material layers 71 are also formed inside the first compound semiconductor layer 21 and the support substrate 49 is not removed.

[Example 19]

Example 19 is a modification of Examples 1 to 18. In a light emitting element in which the first light reflecting layer functions as a kind of concave mirror, there is a possibility that optical crosstalk may occur in which stray light generated in a certain light emitting element enters an adjacent light emitting element, depending on the structure. The light emitting element of Example 19 has a configuration and a structure capable of preventing occurrence of such optical crosstalk.

Schematic partial cross-sectional views of the light emitting element of Example 19 are illustrated in Figs. 33, 34, 36, 38, 39, and 40, a schematic partial cross-sectional view of a light emitting element array including Modification-1 of the light emitting element of Example 19 is illustrated in Fig. 35, and a schematic partial cross-sectional view of a light emitting element array including Modification-2 of the light emitting element of Example 19 is illustrated in Fig. 37. Furthermore, Figs. 41, 43, 45, 46, 47, and 48 are schematic plan views illustrating the arrangement of the first light reflecting layer and the partition wall in the light emitting element array including Modification-1 of the light emitting element of Example 19, and Figs. 42 and 44 are schematic plan views illustrating the arrangement of the first light reflecting layer and the first electrode in the light emitting element array including Modification-1 of the light emitting element of Example 19. Note that Figs. 41, 42, 45, and 47 illustrate a case where the light emitting element is positioned on the vertex (intersection) of the square lattice, and Figs. 43, 44, 46, and 48 illustrate a case where the light emitting element is positioned on the vertex (intersection) of the equilateral triangle lattice. Furthermore, in Figs. 35 and 37, the end portion of the facing surface of the first light reflecting layer facing the first surface of the first compound semiconductor layer is indicated by "A".

Specifically, in the light emitting element of Example 19, as illustrated in a schematic partial cross-sectional view in Fig. 33, a partition wall 96 extending in the lamination direction of the laminated structure 20 is formed so as to surround the first light reflecting layer 41.

Specifically, the orthogonal projection image of the first-A region or the orthogonal projection image of the top portion of the first region is included in the orthogonal projection image of the side surface (hereinafter, it may be simply referred to as a "side surface 96' of the partition wall 96") of the partition wall 96 facing the first light reflecting layer 41. Alternatively, the orthogonal projection image of the side surface 96' of the partition wall 96 may be included in the orthogonal projection image of a portion (non-effective region of the first light reflecting layer 41) not contributing to light reflection of the first light reflecting layer 41. The side surface 96' of the partition wall 96 may be a continuous surface or may be a discontinuous surface partially cut out. Note that, in the present specification, the "orthogonal projection image" means an orthogonal projection image obtained when orthographic projection is performed on the laminated structure 20.

The partition wall 96 extends from a side of the first surface of the first compound semiconductor layer 21 to the middle of the first compound semiconductor layer 21 in the thickness direction in the first compound semiconductor layer 21. That is, an upper end portion 96b of the partition wall 96 is located in the middle of the first compound semiconductor layer 21 in the thickness direction. A lower end portion 96a of the partition wall 96 is exposed to the first surface of the light emitting element 10F. Here, the "first surface of the light emitting element" refers to the exposed surface of the light emitting element 10F on the side on which the first light reflecting layer 41 is provided, and the "second surface of the light emitting element" refers to the exposed surface of the light emitting element 10F on the side on which the second light reflecting layer 42 is provided.

Alternatively, as Fig. 34 illustrates a schematic partial cross-sectional view of Modification-1 of the light emitting element of Example 19, and Fig. 35 illustrates a schematic partial cross-sectional view of a light emitting element array including a plurality of Modification-1 of the light emitting element, the partition wall 96 is not exposed on the first surface of the light emitting element 10F, and the lower end portion 96a of the partition wall 96 is covered with the first electrode 31.

Then, in the light emitting element array including the light emitting element of Example 19 or Modification-1 of the light emitting element of Example 19, it is desirable that a relationship among $L_0$, $L_1$, and $L_3$

satisfies the following expression (1), preferably expression (1'), or
satisfies the following expression (2), preferably expression (2'), or
satisfies the following expressions (1) and (2), or
satisfies the following expressions (1') and (2').

$$0.01 \times L_0 \leq L_0 - L_1 \quad (1)$$

$$0.05 \times L_0 \leq L_0 - L_1 \quad (1')$$

$$0.01 \times L_3 \leq L_1 \quad (2)$$

$$0.05 \times L_3 \leq L_1 \quad (2')$$

here,

$L_0$ is a distance from the end portion of the facing surface of the first light reflecting layer facing the first surface of the first compound semiconductor layer to the active layer,

$L_1$ is a distance from the active layer to an end portion (the upper end portion of the partition wall, the end portion facing the active layer) of the partition wall extending to the middle of the first compound semiconductor layer in the thickness direction in the first compound semiconductor layer, and

$L_3$ is a distance from axis of first light reflecting layer constituting light emitting element to the orthogonal projection image (more specifically, the orthogonal projection image of the upper end portion of the partition wall) of partition wall on laminated structure. Note that an upper limit value of $(L_0 - L_1)$ is less than $L_0$, but in a case where a short circuit does not occur between the active layer and the first electrode due to the partition wall, the upper limit value of $(L_0 - L_1)$ may be $L_0$ or more.

Alternatively, as Fig. 36 illustrates a schematic partial cross-sectional view of Modification-2 of the light emitting element of Example 19, and Fig. 37 illustrates a schematic partial cross-sectional view of a light emitting element array including a plurality of Modification-2 of the light emitting element, the partition wall 97 extends in the second compound semiconductor layer 22 and the active layer 23 from a side of the second surface of the second compound semiconductor layer 22, and further extends to the middle of the first compound semiconductor layer 21 in the thickness direction in the first compound semiconductor layer 21. That is, the lower end portion 97a of the partition wall 97 is located in the middle of the first compound semiconductor layer 21 in the thickness direction. An upper end portion 97b of the partition wall 97 is exposed to the second surface of the light emitting element 10F.

Alternatively, as illustrated in a schematic partial cross-sectional view of Modification-3 of the light emitting element of Example 19 in Fig. 38, the upper end portion 97b of the partition wall 97 is not exposed on the second surface of the light emitting element 10F. Specifically, the upper end portion 97b of the partition wall 97 is covered with an insulating layer (current confinement layer) 34 and the second electrode 32.

Alternatively, as illustrated in a schematic partial cross-sectional view of Modification-4 of the light emitting element of Example 19 in Fig. 39, the side surface 97' of the partition wall 97 is tapered along a direction from a side the first surface of the first compound semiconductor layer 21 toward a side of the second surface of the second compound semiconductor layer 22. That is, the shape of the side surface 97' of the partition wall 97 when the light emitting element 10F is cut along a virtual plane (XZ plane) including the lamination direction of the laminated structure 20 is trapezoidal. Specifically, the second compound semiconductor layer side is an isosceles trapezoid having a short side, and the first compound semiconductor layer 21 side is an isosceles trapezoid having a long side. Then, stray light can be returned to the light emitting element itself more efficiently.

Alternatively, as illustrated in a schematic partial cross-sectional view of Modification-5 of the light emitting element of Example 19 in Fig. 40, the partition wall 97 includes a solder material, and a part of the partition wall 97 is exposed on the outer surface of the light emitting element 10F. A part of the partition wall 97 exposed on the outer surface of the light emitting element 10F can form a kind of bump. Specific examples of the material constituting the partition wall 97 include a material constituting the bump described above, and more specific examples thereof include Au-Sn eutectic solder. A part of the partition wall 97 is formed on the outer surface of the light emitting element 10F, and can be connected to an external circuit and the like via a part of the partition wall 97 exposed from the second surface of the light emitting element 10F.

Then, in the light emitting element array configured of Modification-2, Modification-3, Modification-4, and Modification-5 of the light emitting element of Example 19, it is desirable that the relationship among $L_0$, $L_2$, and $L_3'$

satisfies the following expression (3), preferably expression (3'), or
satisfies the following expression (4), preferably expression (4'), or
satisfies the following expressions (3) and (4), or
satisfies the following expressions (3') and (4').

$$0.01 \times L_0 \leq L_2 \quad (3)$$

$$0.05 \times L_0 \leq L_2 \quad (3')$$

$$0.01 \times L_3' \leq L_2 \quad (4)$$

$$0.05 \times L_3' \leq L_2 \quad (4')$$

here,

$L_0$ is the distance from the end portion of the facing surface of the first light reflecting layer facing the first surface of the first compound semiconductor layer to the active layer,

$L_2$ is a distance from the active layer to the end portion (the lower end portion of the partition wall, the end portion facing the first electrode) of the partition wall extending to the middle of the first compound semiconductor layer in the thickness direction in the first compound semiconductor layer, and

$L_3'$ is a distance from the axis of the first light reflecting layer constituting the light emitting element to the orthogonal projection image (more specifically, the orthogonal projection image of the lower end portion of the partition wall) of the partition wall on the laminated structure. Note that an upper limit value of $L_2$ is less than $L_0$, but the upper limit value of $L_2$ may be $L_0$ in a case where a short circuit does not occur between the active layer and the first electrode due to the partition wall.

Examples of these specific values are illustrated in Tables 22 and 23 below.

<Table 22>

| | |
|---|---|
| Po: | 40 μm |
| $L_0$: | 30 μm |
| $L_1$: | 28 μm |
| $L_3$: | 18 μm |

<Table 23>

| | |
|---|---|
| Po: | 20 μm |
| $L_0$: | 17 μm |
| $L_2$: | 12 μm |
| $L_3'$: | 9 μm |

The shapes of the side surfaces 96' and 97' of the partition walls 96 and 97 when the light emitting element 10F is cut along the virtual plane (in the illustrated example, for example, the XZ plane) including the lamination direction of the laminated structure 20 are line segments. Furthermore, the shapes of the side surfaces 96' and 97' of the partition walls 96 and 97 when the light emitting element 10F is cut along a virtual plane (XY plane) orthogonal to the lamination direction of the laminated structure 20 are circular. However, the present invention is not limited thereto.

In a case where the light emitting elements 10F are arranged in an array, the partition wall 96 is provided so as to surround the first light reflecting layer 41 constituting each light emitting element 10F, but a region outside the side surface 96' of the partition wall 96 may be occupied by the partition wall 96. That is, the space between the light emitting element 10F and the light emitting element 10F may be occupied by the material constituting the partition wall 96. As illustrated in Figs. 41 and 43, the partition wall 96 is provided so as to surround the first light reflecting layer 41 constituting each light emitting element 10F, and a region outside the side surface 96' of the partition wall 96 is occupied by the partition wall 96. That is, the space between the light emitting element 10F and the light emitting element 10F is occupied by the material constituting the partition wall 96.

As illustrated in Fig. 42 or 44, in a case where the partition wall 96 includes a material having no conductivity, the first electrode 31 is provided on the first surface 21a of the first compound semiconductor layer 21. Furthermore, in a case where the partition wall 96 includes a material having conductivity, or in a case where the partition wall 96 includes a material having no conductivity, the first electrode 31 may be provided on the exposed surface (lower end surface 96 a) of the partition wall 96. Specifically, a lower end portion (an end portion facing the first electrode 31) 96a of the partition wall 96 is in contact with the first electrode 31 formed on the first surface (the first surface 21a of the first compound semiconductor layer 21) of the light emitting element 10F. In a case where the partition wall 96 includes a material having conductivity, the partition wall 96 may also serve as the first electrode 31. When the partition wall 96 includes a material having high thermal conductivity, heat generated in the laminated structure 20 can be discharged (radiated) to the outside through the partition wall 96. Specifically, the heat generated in the laminated structure 20 can be effectively discharged (radiated) to the outside through the partition wall 96 and the first electrode 31 or the first pad electrode.

Alternatively, the region outside the side surface 96' of the partition wall 96 is occupied by a material (for example, the laminated structure 20) other than the material constituting the partition wall 96. In this case, the partition wall 96 is formed in, for example, a continuous groove shape or a discontinuous groove shape. That is, the space between the light emitting element 10F and the light emitting element 10F may be occupied by a material (for example, the laminated structure 20) other than the material constituting the partition wall 96. Then, for example, the partition wall 96 may be formed in a continuous groove shape (see Figs. 45 and 46), or may be formed in a discontinuous groove shape (see Figs. 47 and 48). Note that, in Figs. 45, 46, 47, and 48, portions of the partition wall 96 are hatched to clearly illustrate the partition wall 96.

The partition walls 96 and 97 can include a material that does not transmit light generated in the active layer, and thus, it is possible to prevent generation of stray light and occurrence of optical crosstalk. Specifically, examples of such a material can include a material capable of shielding light, such as titanium (Ti), chromium (Cr), tungsten (W), tantalum (Ta), aluminum (Al), or $MoSi_2$, and can be formed by, for example, a vapor deposition method including an electron beam vapor deposition method, a hot filament vapor deposition method, and a vacuum vapor deposition method, a sputtering method, a CVD method, an ion plating method, and the like. Alternatively, a black resin film (specifically, for example, a black polyimide-based resin, an epoxy-based resin, or a silicone-based resin) mixed with a black colorant and having an optical density of 1 or more can be mentioned.

Alternatively, the partition walls 96 and 97 can include a material that reflects light generated in the active layer, whereby generation of stray light and occurrence of optical crosstalk can be prevented, and stray light can be efficiently returned to the light emitting element itself, which can contribute to improvement of light emission efficiency of the light emitting element. Specifically, the partition walls 96 and 97 include a thin film filter using interference of a thin film. The thin film filter has, for example, a configuration and a structure similar to the light reflecting layer although a lamination direction (alternate arrangement direction) is different from that of the light reflecting layer. Specifically, when the partition walls 96 and 97 are cut along the virtual plane (XY plane) orthogonal to the lamination direction of the laminated structure 20, a thin film filter in which dielectric layers are alternately arrayed can be obtained by forming recesses in a part of the laminated structure 20 and sequentially filling the recesses with a material similar to that of the light reflecting layer based on, for example, a sputtering method. Alternatively, as such a material, a metal material, an alloy material, or a metal oxide material can be exemplified, and more specifically, copper (Cu) or an alloy thereof, gold (Au) or an alloy thereof, tin (Sn) or an alloy thereof, silver (Ag) or a silver alloy (for example, Ag-Pd-Cu, Ag-Sm-Cu), platinum (Pt) or an alloy thereof, palladium (Pd) or an alloy thereof, titanium (Ti) or an alloy thereof, aluminum (Al) or an aluminum alloy (for example, Al-Nd or Al-Cu), an Al/Ti laminated structure, an Al-Cu/Ti laminated structure, chromium (Cr) or an alloy thereof, ITO, and the like can be exemplified, and for example, the thin film filter can be formed by a vapor deposition method including an electron beam vapor deposition method, a hot filament vapor deposition method, and a vacuum vapor deposition method, a sputtering method, a CVD method, or an ion plating method; a plating method (electroplating method or electroless plating method); a lift-off method; a laser ablation method; a sol-gel method; a plating method, and the like.

Alternatively, when the thermal conductivity of the material constituting the first compound semiconductor layer 21 is $TC_1$ and the thermal conductivity of the material constituting the partition walls 96 and 97 is TCo,

$$1 \times 10^{-1} \leq TC_1/TC_0 \leq 1 \times 10^2$$

can be satisfied. Specific examples of the material constituting the partition walls 96 and 97 can include metals such as silver (Ag), copper (Cu), gold (Au), tin (Sn), aluminum (Al), ruthenium (Ru), rhodium (Rh), and platinum (Pt), alloys thereof, mixtures of these metals, ITO, and the like, and the partition walls can be formed by a vapor deposition method including an electron beam vapor deposition method, a hot filament vapor deposition method, and a vacuum vapor deposition method, a sputtering method, a CVD method, or an ion plating method; a plating method (electroplating method or electroless plating method); a lift-off method; a laser ablation method; a sol-gel method; a plating method, and the like. Then, by forming the partition walls 96 and 97 from a material having a high thermal conductivity as described above, heat generated in the laminated structure 20 can be discharged (radiated) to the outside through the partition walls 96 and 97. Note that, in this case, a partition wall extending portion may be formed on the outer surface (first surface or second surface) of the light emitting element 10F so that heat generated in the laminated structure 20 can be discharged (radiated) to the outside via the partition walls 96 and 97 and the partition wall extending portion, or the partition walls 96 and 97 may be connected to the first electrode 31 or the second electrode 32 or the pad electrode so that heat generated in the laminated structure 20 can be discharged (radiated) to the outside via the partition walls 96 and 97 and the first electrode 31 or the second electrode 32 or the pad electrode.

Alternatively, when a linear expansion coefficient of the material constituting the first compound semiconductor layer 21 is $CTE_1$ and a linear expansion coefficient of the material constituting the partition walls 96 and 97 is $CTE_0$,

$$|CTE_0 - CTE_1| \leq 1 \times 10^{-4}/K$$

can be satisfied. Specific examples of the material constituting the partition walls 96 and 97 include a polyimide-based resin, a silicone-based resin, an epoxy-based resin, a carbon-based material, SOG, polycrystalline GaN, and single crystal GaN. By defining the linear expansion coefficient in this manner, a thermal expansion coefficient of the entire light emitting element can be optimized, and a thermal expansion of the light emitting element 10F can be controlled (suppressed). Specifically, for example, a net thermal expansion coefficient of the laminated structure 20 can be increased, and by matching the thermal expansion coefficient with a thermal expansion coefficient of a substrate material and the like on which the light emitting element 10F is mounted, it is possible to prevent damage of the light emitting element 10F and suppress a decrease in reliability of the light emitting element 10F due to generation of stress. The partition walls 96 and 97 including a polyimide-based resin can be formed based on, for example, a spin coating method and a curing method.

Alternatively, when the partition walls 96 and 97 include an insulating material, occurrence of electrical crosstalk can be suppressed. That is, it is possible to prevent an unnecessary current from flowing between the adjacent light emitting elements 10F.

Examples of the shapes of the side surfaces 96' and 97' of the partition walls 96 and 97 when the light emitting element is cut along the virtual plane (XZ plane) including the lamination direction of the laminated structure 20 include a line segment, an arc, a part of a parabola, a part of an arbitrary curve, and the like. Furthermore, examples of the shapes of the side surfaces 96' and 97' of the partition walls 96 and 97 when the light emitting element is cut along the virtual plane (XY plane) orthogonal to the lamination direction of the laminated structure 20 include a circle, an ellipse, an oval, a rectangle including a square or a rectangle, a regular polygon (including a rounded regular polygon), and the like. Specific examples of the planar shapes of the first light reflecting layer 41 and the second light reflecting layer 42 include a circle, an ellipse, an oval, a rectangle, and a regular polygon (regular triangle, square, regular hexagon, and the like). The planar shapes of the first light reflecting layer 41 and the second light reflecting layer 42 and the shapes of the side surfaces 96' and 97' of the partition walls 96 and 97 when the light emitting element is cut along the virtual plane (XY plane) orthogonal to the lamination direction of the laminated structure 20 are desirably similar or approximate.

Then, more specifically, in Example 19, the partition walls 96 and 97 include a material that does not transmit light generated in the active layer 23, or when the thermal conductivity of the material constituting the first compound semiconductor layer 21 is $TC_1$ and the thermal conductivity of the material constituting the partition walls 96 and 97 is $TC_0$,

$$1 \times 10^{-1} \leq TC_1/TC_0 \leq 1 \times 10^2$$

is satisfied. Specifically, the material constituting the first compound semiconductor layer 21 includes GaN, and the partition walls 96 and 97 include copper (Cu). Note that

$TC_0$ is 50 Watts/(m K) to 100 Watts/(m K), and

TC$_1$ is 400 Watts/ (m K) .

For example, in a case where the partition walls 96 and 97 including a copper layer are formed by a plating method, an underlayer including an Au layer and the like having a thickness of about 0.1 $\mu$m may be formed in advance as a seed layer by a sputtering method and the like, and a copper layer may be formed thereon by a plating method. In this manner, by forming the partition walls 96 and 97 from a material having a high thermal conductivity, heat generated in the laminated structure 20 can be effectively discharged (radiated) to the outside through the partition walls 96 and 97.

Alternatively, the partition walls 96 and 97 include a material that reflects light generated in the active layer 23, for example, silver (Ag).

Alternatively, when the linear expansion coefficient of the material (GaN) constituting the first compound semiconductor layer 21 is CTE$_1$, and the linear expansion coefficient of the material (polyimide-based resin) constituting the partition walls 96 and 97 is CTE$_0$,

$$|CTE_0 - CTE_1| \leq 1 \times 10^{-4}/K$$

is satisfied. Specifically,

CTE$_0$ is 5.5 $\times$ 10$^{-6}$/K and
CTE$_1$ is 25 $\times$ 10$^{-6}$/K.

Then, by combining these materials, the net thermal expansion coefficient of the light emitting element 10F can be increased, and can be matched with the thermal expansion coefficient of the substrate material and the like on which the light emitting element 10F is mounted, and thus, it is possible to suppress damage of the light emitting element 10F and a decrease in reliability due to generation of stress in the light emitting element 10F.

Although the present disclosure has been described above based on preferred examples, the present disclosure is not limited to these examples. The configuration and structure of the light emitting element described in the embodiment are examples, and can be appropriately changed, and the method of manufacturing the light emitting element can also be appropriately changed. In some cases, by appropriately selecting the bonding layer and the support substrate, the surface emitting laser element that emits light from the second surface of the second compound semiconductor layer via the second light reflecting layer can be obtained. In some cases, a through hole reaching the first compound semiconductor layer can be formed in a region of the second compound semiconductor layer and the active layer that do not affect light emission, and a first electrode insulated from the second compound semiconductor layer and the active layer can be formed in the through hole. The first light reflecting layer may extend to the second region of the base surface. That is, the first light reflecting layer on the base surface may include a so-called solid film. Then, in this case, a through hole may be formed in the first light reflecting layer extending in the second region of the base surface, and the first electrode connected to the first compound semiconductor layer may be formed in the through hole.

A wavelength conversion material layer (color conversion material layer) may be provided in a region of the light emitting element from which light is emitted. Then, in this case, white light can be emitted via the wavelength conversion material layer (color conversion material layer). Specifically, in a case where light emitted from the active layer is emitted to the outside via the first light reflecting layer, the wavelength conversion material layer (color conversion material layer) may be formed on the light emitting side of the first light reflecting layer, and when light emitted from the active layer is emitted to the outside via the second light reflecting layer, a wavelength conversion material layer (color conversion material layer) may be formed on the light emitting side of the second light reflecting layer.

In a case where blue light is emitted from the light emitting layer, white light can be emitted via the wavelength conversion material layer by adopting the following form.

[A] By using a wavelength conversion material layer that converts blue light emitted from the light emitting layer into yellow light, white light in which blue and yellow are mixed is obtained as light emitted from the wavelength conversion material layer.

[B] By using a wavelength conversion material layer that converts blue light emitted from the light emitting layer into orange light, white light in which blue and orange are mixed is obtained as light emitted from the wavelength conversion material layer.

[C] By using a wavelength conversion material layer that converts blue light emitted from the light emitting layer into green light and a wavelength conversion material layer that converts blue light into red light, white light in which blue, green, and red are mixed is obtained as light emitted from the wavelength conversion material layer.

Alternatively, in a case where ultraviolet rays are emitted from the light emitting layer, white light can be emitted via the wavelength conversion material layer by adopting the following form.

[D] By using a wavelength conversion material layer that converts ultraviolet light emitted from the light emitting layer into blue light and a wavelength conversion material layer that converts ultraviolet light into yellow light, white light in which blue and yellow are mixed is obtained as light emitted from the wavelength conversion material layer.

[E] By using the wavelength conversion material layer that converts the ultraviolet light emitted from the light emitting layer into blue light and the wavelength conversion material layer that converts the ultraviolet light into orange light, white light in which blue and orange are mixed is obtained as the light emitted from the wavelength conversion material layer.

[F] By using a wavelength conversion material layer that converts ultraviolet light emitted from the light emitting layer into blue light, a wavelength conversion material layer that converts ultraviolet light into green light, and a wavelength conversion material layer that converts ultraviolet light into red light, white light in which blue, green, and red are mixed is obtained as light emitted from the wavelength conversion material layer.

Here, examples of a wavelength conversion material which is excited by blue light and emits red light can include, specifically, red light-emitting phosphor particles, more specifically, (ME:Eu)S [however, "ME" means at least one kind of atom selected from the group consisting of Ca, Sr, and Ba, and the above similarly applies to the following], $(M:Sm)_x(Si, Al)_{12}(O,N)_{16}$ [however, "M" means at least one atom selected from the group consisting of Li, Mg, and Ca, and the above similarly applies to the following], $ME_2Si_5N_8$:Eu, (Ca:Eu)SiN$_2$, and (Ca:Eu)AlSiN$_3$. Furthermore, specific examples of the wavelength conversion material which is excited by blue light and emits green light can include green-emitting phosphor particles, more specifically, (ME:Eu)Ga$_2$S$_4$, $(M:RE)_x(Si,Al)_{12}(O,N)_{16}$ [however, "RE" means Tb and Yb], $(M:Tb)_x(Si,Al)_{12}(O,N)_{16}$, $(M:Yb)_x(Si,Al)_{12}(O,N)_{16}$, and $Si_{6-z}Al_zO_zN_{8-z}$:Eu. Furthermore, specific examples of the wavelength conversion material that is excited by blue light and emits yellow light can include yellow emitting phosphor particles, and more specific examples thereof can include YAG (yttrium aluminum garnet)-based phosphor particles. Note that the wavelength conversion material may be used singly or in combination of two or more kinds thereof. Furthermore, by using a mixture of two or more kinds of wavelength conversion materials, emission light of colors other than yellow, green, and red can be emitted from the wavelength conversion material mixture. Specifically, for example, it may be configured to emit cyan light, and in this case, a mixture of the green-emitting phosphor particles (for example, LaPO$_4$:Ce,Tb, BaMgAl$_{10}$O$_{17}$:Eu,Mn, Zn$_2$SiO$_4$:Mn, MgAl$_{11}$O$_{19}$:Ce,Tb, Y$_2$SiO$_5$:Ce,Tb, MgAl$_{11}$O$_{19}$:CE,Tb, Mn) and the blue-emitting phosphor particles (for example, BaMgAl$_{10}$O$_{17}$: Eu, BaMg$_2$Al$_{16}$O$_{27}$:Eu, Sr$_2$P$_2$O$_7$:Eu, Sr$_5$ (PO$_4$)$_3$Cl:Eu, (Sr, Ca, Ba, Mg)$_5$(PO$_4$)$_3$Cl:Eu, CaWO$_4$, CaWO$_4$:Pb) may be used.

Furthermore, specific examples of the wavelength conversion material that is excited by ultraviolet rays and emits red light can include red light-emitting phosphor particles, more specifically, Y$_2$O$_3$:Eu, YVO$_4$:Eu, Y(P,V)O$_4$:Eu, 3.5MgO·0.5MgF$_2$·Ge$_2$:Mn, CaSiO$_3$:Pb,Mn, Mg$_6$AsO$_{11}$:Mn, (Sr,Mg)$_3$(PO$_4$)$_3$:Sn, La$_2$O$_2$S:Eu, and Y$_2$O$_2$S:Eu. Furthermore, specific examples of the wavelength conversion material that is excited by ultraviolet rays and emits green light can include green-emitting phosphor particles, more specifically, LaPO$_4$:Ce,Tb, BaMgAl$_{10}$O$_{17}$:Eu, Mn, Zn$_2$SiO$_4$:Mn, MgAl$_{11}$O$_{19}$:Ce,Tb, Y$_2$SiO$_5$:Ce,Tb, MgAl$_{11}$O$_{19}$:CE,Tb,Mn, and Si$_{6-z}$Al$_z$O$_z$N$_{8-z}$:Eu. Furthermore, examples of the wavelength conversion material that is excited by ultraviolet rays and emits blue light can include blue light emitting phosphor particles, more specifically, BaMgAl$_{10}$O$_{17}$: Eu, BaMg$_2$Al$_{16}$O$_{27}$:Eu, Sr$_2$P$_2$O$_7$:Eu, Sr$_5$(PO$_4$)$_3$Cl:Eu, (Sr,Ca,Ba,Mg)$_5$(PO$_4$)$_3$Cl:Eu, CaWO$_4$, and CaWO$_4$:Pb. Furthermore, specific examples of the wavelength conversion material that is excited by ultraviolet rays and emits yellow light can include yellow emitting phosphor particles, and more specific examples thereof include YAG-based phosphor particles. Note that the wavelength conversion material may be used singly or in combination of two or more kinds thereof. Furthermore, by using a mixture of two or more kinds of wavelength conversion materials, emission light of colors other than yellow, green, and red can be emitted from the wavelength conversion material mixture. Specifically, it may be configured to emit cyan light, and in this case, a mixture of the green light emitting phosphor particles and the blue light emitting phosphor particles may be used.

However, the wavelength conversion material (color conversion material) is not limited to phosphor particles. For example, in an indirect transition type silicon-based material, in order to efficiently convert carriers into light as in a direct transition type, light emitting particles to which a wave function of carriers is localized and a quantum well structure such as a two-dimensional quantum well structure, a one-dimensional quantum well structure (quantum fine wire), or a zero-dimensional quantum well structure (quantum dot) using a quantum effect is applied can be exemplified. Rare earth atoms added to a semiconductor material are known to sharply emit light by in-shell transition, and light emitting particles to which such a technology is applied can also be exemplified.

Examples of the wavelength conversion material (color conversion material) include quantum dots as described above. As the size (diameter) of the quantum dot decreases, the band gap energy increases, and the wavelength of light emitted from the quantum dot decreases. That is, as the size of the quantum dot is smaller, light having a shorter wavelength (light on the blue light side) is emitted, and as the size is larger, light having a longer wavelength (light on the red light side) is emitted. Therefore, it is possible to obtain a quantum dot that emits light having a desired wavelength (performs color conversion to a desired color) by using the same material constituting the quantum dot and adjusting the size of the quantum dot. Specifically, the quantum dot preferably has a core-shell structure. Examples of a material constituting the quantum dot can include Si; Se; CIGS(CuInGaSe), CIS(CuInSe$_2$), CuInS$_2$, CuAlS$_2$, CuAlSe$_2$, CuGaS$_2$, CuGaSe$_2$, AgAlS$_2$, AgAlSe$_2$, AgInS$_2$, and AgInSe$_2$ which are chalcopyrite-based compounds; Perovskite-based material; GaAs, GaP, InP, InAs, InGaAs, AlGaAs, InGaP, AlGaInP, InGaAsP, and GaN which are III-V group compounds; CdSe, CdSeS, CdS, CdTe, In$_2$Se$_3$, In$_2$S$_3$, Bi$_2$Se$_3$, Bi$_2$S$_3$, ZnSe, ZnTe, ZnS, HgTe, HgS, PbSe, PbS, TiO$_2$, and the like, but are not limited thereto.

Note that the present disclosure can also have the following configurations.

[A01] <<Light emitting element ··· first aspect>>

A light emitting element including:

a laminated structure in which
a first compound semiconductor layer having a first surface and a second surface facing the first surface,
an active layer facing the second surface of the first compound semiconductor layer, and
a second compound semiconductor layer having a first surface facing the active layer and a second surface facing to the first surface
are laminated;
a first light reflecting layer; and
a second light reflecting layer formed on a side of the second surface of the second compound semiconductor layer and having a flat shape,
in which a base surface located on a side of the first surface of the first compound semiconductor layer has a first region including a protruding portion protruding in a direction away from the active layer and a second region surrounding the first region and having a flat surface,
the first region includes a first-A region including a top portion of the protruding portion and a first-B region surrounding the first-A region,
the first light reflecting layer is formed on at least the first-A region,
a first curve formed by the first-A region in a cross-sectional shape of the base surface when the base surface is cut along a virtual plane including a lamination direction of the laminated structure is formed by an upwardly convex smooth curve,
at an intersection of a second curve formed by the first-B region and a straight line formed by the second region in the cross-sectional shape of the base surface, a complementary angle $\theta_{CA}$ of an angle formed by the second curve and the straight line has a value exceeding 0°, and
the second curve includes at least one kind of figure selected from the group consisting of a combination of a downwardly convex curve, a line segment, and an arbitrary curve.

[A02] The light emitting element according to [A01], in which the complementary angle $\theta_{CA}$ is 1° or more and 6° or less.

[A03] <<Light emitting element ··· second aspect>>

A light emitting element including:

a laminated structure in which
a first compound semiconductor layer having a first surface and a second surface facing the first surface,
an active layer facing the second surface of the first compound semiconductor layer, and
a second compound semiconductor layer having a first surface facing the active layer and a second surface facing the first surface
are laminated;
a first light reflecting layer; and
a second light reflecting layer formed on a side of the second surface of the second compound semiconductor layer and having a flat shape,
in which a base surface located on a side of the first surface of the first compound semiconductor layer has a first region including a protruding portion protruding in a direction away from the active layer and a second region surrounding the first region and having a flat surface,
the first light reflecting layer is formed at least on a top portion of the first region, and
at an intersection of a curve formed by the first region and a straight line formed by the second region in a cross-sectional shape of the base surface when the base surface is cut along a virtual plane including a lamination direction of the laminated structure, a complementary angle $\theta_{CA}$ of an angle formed by the curve and the straight line is 1° or more and 6° or less.

[A04] The light emitting element according to any one of [A01] to [A03], in which a curvature radius $R_1$ of the top portion of the first region of the base surface is $1.5 \times 10^{-5}$ m or more and $2 \times 10^{-4}$ m or less.

[A05] The light emitting element according to any one of [A01] to [A04], in which a height $H_1$ of the first region with respect to the flat surface of the second region is 1 $\mu$m or more and 5 $\mu$m or less.

[A06] The light emitting element according to any one of [A01] to [A05], in which when a curvature radius of the top portion of the first region of the base surface is $R_1$ and a resonator length of the light emitting element is $L_{OR}$,

$$1 \leq R_1/L_{OR} \leq 10$$

is satisfied.

[A07] The light emitting element according to any one of [A01] to [A06], in which a diameter $D_1$ of the first region of the base surface is $3 \times 10^{-6}$ m or more and $1 \times 10^{-4}$ m or less.

[A08] The light emitting element according to any one of [A01] to [A07], in which a figure drawn by the top portion of the first region of the base surface when the base surface is cut along a virtual plane including the lamination direction of the laminated structure is a part of a circle or a part of a parabola.

[A09] The light emitting element according to any one of [A01] to [A08], in which a bump is disposed in a portion on a side of the second surface of the second compound semiconductor layer facing the first region of the base surface.

[A10] The light emitting element according to any one of [A01] to [A09], in which the laminated structure includes at least one material selected from the group consisting of a GaN-based compound semiconductor, an InP-based compound semiconductor, and a GaAs-based compound semiconductor.

[A11] The light emitting element according to any one of [A01] to [A10], in which when a resonator length is $L_{OR}$, $1 \times 10^{-5}$ m $\leq L_{OR}$ is satisfied.

[A12] <<First configuration>>

The light emitting element according to any one of [A01] to [A11], in which the first surface of the first compound semiconductor layer constitutes the base surface.

[A13] <<Light emitting element of second configuration>>

The light emitting element according to any one of [A01] to [A11], in which a compound semiconductor substrate is disposed between the first surface of the first compound semiconductor layer and the first light reflecting layer, and the base surface includes a surface of the compound semiconductor substrate.

[A14] <<Light emitting element of third configuration>>

The light emitting element according to any one of [A01] to [A11], in which a base material is disposed between the first surface of the first compound semiconductor layer and the first light reflecting layer, or a compound semiconductor substrate and a base material are disposed between the first surface of the first compound semiconductor layer and the first light reflecting layer, and the base surface includes a surface of the base material.

[A15] The light emitting element according to [A14], in which a material constituting the base material is at least one material selected from the group consisting of a transparent dielectric material such as $TiO_2$, $Ta_2O_5$, or $SiO_2$, a silicone-based resin, and an epoxy-based resin.

[A16] The light emitting element according to any one of [A01] to [A15], in which a value of thermal conductivity of the laminated structure is higher than a value of thermal conductivity of the first light reflecting layer.

[B01] <<Light emitting element array of fourth configuration>>

The light emitting element according to any one of [A01] to [A16], in which

the second compound semiconductor layer is provided with a current injection region and a current non-injection region surrounding the current injection region, and
a shortest distance $D_{CI}$ from an area centroid point of the current injection region to a boundary between the current injection region and the current non-injection region satisfies the following expression.

$$D_{CI} \geq \omega_0/2$$

Here,

$$\omega_0{}^2 \equiv (\lambda_0/\pi) \ \{L_{OR}(R_1 - L_{OR})\}^{1/2}$$

where:

$\lambda_0$: wavelength (oscillation wavelength) of desired light mainly emitted from light emitting element
$L_{OR}$: resonator length
$R_1$: curvature radius (that is, curvature radius of first light reflecting layer) of top portion (center portion) of first region of base surface [B02] The light emitting element according to [B01], further including:
a mode loss action site provided on the second surface of the second compound semiconductor layer and constituting a mode loss action region acting to increase or decrease an oscillation mode loss;
a second electrode formed over the mode loss action site from the second surface of the second compound semiconductor layer; and
a first electrode electrically connected to the first compound semiconductor layer,
in which the second light reflecting layer is formed on the second electrode, and
a current injection region, a current non-injection/inner region surrounding the current injection region, and a current non-injection/outer region surrounding the current non-injection/inner region are formed in the laminated structure, and
an orthogonal projection image of the mode loss action region and an orthogonal projection image of the current non-injection/outer region overlap each other.

[B03] The light emitting element according to [B01] or [B02], in which a radius $r_1$ of the first region satisfies that

$$\omega_0 \leq r_1 \leq 20 \cdot \omega_0.$$

[B04] The light emitting element according to any one of [B01] to [B03], in which $D_{CI} \geq \omega_0$ is satisfied.
[B05] The light emitting element according to any one of [B01] to [B04], in which $R_1 \leq 1 \times 10^{-3}$ m is satisfied.

[C01] <<Light emitting element array of fifth configuration>>

The light emitting element according to any one of [A01] to [A16], further including:

a mode loss action site provided on the second surface of the second compound semiconductor layer and constituting a mode loss action region acting to increase or decrease an oscillation mode loss;
a second electrode formed over the mode loss action site from the second surface of the second compound semiconductor layer; and
a first electrode electrically connected to the first compound semiconductor layer,
in which the second light reflecting layer is formed on the second electrode,
a current injection region, a current non-injection/inner region surrounding the current injection region, and a current non-injection/outer region surrounding the current non-injection/inner region are formed in the laminated structure, and
an orthogonal projection image of the mode loss action region and an orthogonal projection image of the current non-injection/outer region overlap each other.

[C02] The light emitting element according to [C01], in which the current non-injection/outer region is located below the mode loss action region.
[C03] The light emitting element according to [C01] or [C02], in which when an area of the projection image of the current injection region is $S_1$ and an area of the projection image of the current non-injection/inner region is S2,

$$0.01 \leq S_1/(S_1 + S_2) \leq 0.7$$

is satisfied.

[C04] The light emitting element according to any one of [C01] to [C03], in which the current non-injection/inner region and the current non-injection/outer region are formed by ion injection into the laminated structure.

[C05] The light emitting element according to [C04], in which ion species is at least one ion selected from the group consisting of boron, proton, phosphorus, arsenic, carbon, nitrogen, fluorine, oxygen, germanium, and silicon.

[C06] <<Light emitting element array of configuration 5-B>>

The light emitting element according to any one of [C01] to [C05], in which the current non-injection/inner region and the current non-injection/outer region are formed by plasma irradiation on the second surface of the second compound semiconductor layer, ashing processing on the second surface of the second compound semiconductor layer, or reactive ion etching processing on the second surface of the second compound semiconductor layer.

[C07] <<Light emitting element array of configuration 5-C>>

The light emitting element according to any one of [C01] to [C06], in which the second light reflecting layer has a region that reflects or scatters the light from the first light reflecting layer toward the outside of a resonator structure including the first light reflecting layer and the second light reflecting layer.

[C08] The light emitting element according to any one of [C01] to [C07], in which when an optical distance from the active layer to the second surface of the second compound semiconductor layer in the current injection region is $OL_2$, and an optical distance from the active layer to the top surface of the mode loss action site in the mode loss action region is $OL_0$,

$$OL_0 > OL_2$$

is satisfied.

[C09] The light emitting element according to any one of [C01] to [C08], in which generated light having a higher mode is dissipated toward the outside of the resonator structure configured by the first light reflecting layer and the second light reflecting layer by the mode loss action region, and thus, the oscillation mode loss increases.

[C10] The light emitting element according to any one of [C01] to [C09], in which the mode loss action site includes a dielectric material, a metal material, or an alloy material.

[C11] The light emitting element according to [C10], in which

the mode loss action site includes a dielectric material, and
an optical thickness of the mode loss action site is a value deviating from an integral multiple of 1/4 of a wavelength of light generated in the light emitting element array.

[C12] The light emitting element according to [C10], in which

the mode loss action site includes a dielectric material, and
an optical thickness of the mode loss action site is an integral multiple of 1/4 of the wavelength of light generated in the light emitting element array.

[C13] <<Light emitting element array of configuration 5-D>>

The light emitting element according to any one of [C01] to [C03], in which

a protrusion is formed on a side of the second surface of the second compound semiconductor layer, and
the mode loss action site is formed in a region of the second surface of the second compound semiconductor layer surrounding the protrusion.

[C14] The light emitting element according to [C13], in which when an optical distance from the active layer to the second surface of the second compound semiconductor layer in the current injection region is $OL_2$, and an optical distance from the active layer to the top surface of the mode loss action site in the mode loss action region is $OL_0$,

$$OL_0 < OL_2$$

is satisfied.

[C15] The light emitting element according to [C13] or [C14], in which the generated light having a higher mode is confined in the current injection region and the current non-injection/inner region by the mode loss action region, and thus, an oscillation mode loss is reduced.

[C16] The light emitting element according to any one of [C13] to [C15], in which the mode loss action site includes a dielectric material, a metal material, or an alloy material.

[C17] The light emitting element according to any one of [C01] to [C16], in which the second electrode includes a transparent conductive material.

[D01] <<Light emitting element array of sixth configuration>>

The light emitting element according to any one of [A01] to [A16], further including:

a second electrode formed on the second surface of the second compound semiconductor layer;
a second light reflecting layer formed on the second electrode;
a mode loss action site provided on the first surface of the first compound semiconductor layer and constituting a mode loss action region acting to increase or decrease an oscillation mode loss; and
a first electrode electrically connected to the first compound semiconductor layer,
in which the first light reflecting layer is formed over a region from the first surface of the first compound semiconductor layer to the mode loss action site,
a current injection region, a current non-injection/inner region surrounding the current injection region, and a current non-injection/outer region surrounding the current non-injection/inner region are formed in the laminated structure, and
an orthogonal projection image of the mode loss action region and an orthogonal projection image of the current non-injection/outer region overlap each other.

[D02] The light emitting element according to [D01], in which when an area of the projection image of the current injection region is $S_1$ and an area of the projection image of the current non-injection/inner region is $S_2$,

$$0.01 \leq S_1' / (S_1' + S_2') \leq 0.7$$

is satisfied.

[D03] <<Light emitting element array of configuration 6-A>>

The light emitting element according to [D01] or [D02], in which the current non-injection/inner region and the current non-injection/outer region are formed by ion injection into the laminated structure.

[D04] The light emitting element according to [D03], in which ion species is at least one ion selected from the group consisting of boron, proton, phosphorus, arsenic, carbon, nitrogen, fluorine, oxygen, germanium, and silicon.

[D05] <<Light emitting element array of configuration 6-B>>

The light emitting element according to any one of [D01] to [D04], in which the current non-injection/inner region and the current non-injection/outer region are formed by plasma irradiation on the second surface of the second compound semiconductor layer, ashing processing on the second surface of the second compound semiconductor layer, or reactive ion etching processing on the second surface of the second compound semiconductor layer.

[D06] <<Light emitting element array of configuration 6-C>>

The light emitting element according to any one of [D01] to [D05], in which the second light reflecting layer has a region that reflects or scatters the light from the first light reflecting layer toward the outside of a resonator structure including the first light reflecting layer and the second light reflecting layer.

[D07] The light emitting element according to any one of [D01] to [D06], in which when an optical distance from the active layer to the first surface of the first compound semiconductor layer in the current injection region is $OL_1'$, and an optical distance from the active layer to the top surface of the mode loss action site in the mode loss action region is $OL_0'$,

$$OL_0' > OL_1'$$

is satisfied.

[D08] The light emitting element according to any one of [D01] to [D07], in which generated light having a higher mode is dissipated toward the outside of the resonator structure configured by the first light reflecting layer and the second light reflecting layer by the mode loss action region, and thus, the oscillation mode loss increases.

[D09] The light emitting element according to any one of [D01] to [D08], in which the mode loss action site includes a dielectric material, a metal material, or an alloy material.

[D10] The light emitting element according to [D09], in which

the mode loss action site includes a dielectric material, and
an optical thickness of the mode loss action site is a value deviating from an integral multiple of 1/4 of a wavelength of light generated in the light emitting element array.

[D11] The light emitting element according to [D09], in which

the mode loss action site includes a dielectric material, and
an optical thickness of the mode loss action site is an integral multiple of 1/4 of a wavelength of light generated in the light emitting element array.

[D12] <<Light emitting element array of configuration 6-D>>

The light emitting element according to [D01] or [D02], in which a protrusion is formed on a side of the first surface of the first compound semiconductor layer, and the mode loss action site is formed in a region of the first surface of the first compound semiconductor layer surrounding the protrusion.

[D13] The light emitting element according to [D12], in which when an optical distance from the active layer to the first surface of the first compound semiconductor layer in the current injection region is $OL_1'$, and an optical distance from the active layer to the top surface of the mode loss action site in the mode loss action region is $OL_0'$,

$$OL_0' < OL_1'$$

is satisfied.

[D14] The light emitting element according to [D01] or [D02], in which

a protrusion is formed on a side of the first surface of the first compound semiconductor layer, and
the mode loss action site includes a region of the first surface of the first compound semiconductor layer surrounding the protrusion.

[D15] The light emitting element according to any one of [D12] to [D14], in which the generated light having a higher mode is confined in the current injection region and the current non-injection/inner region by the mode loss action region, and thus, the oscillation mode loss is reduced.

[D16] The light emitting element according to any one of [D12] to [D15], in which the mode loss action site includes a dielectric material, a metal material, or an alloy material.

[D17] The light emitting element according to any one of [D01] to [D16], in which the second electrode includes a transparent conductive material.

[E01] <<Light emitting element array of seventh configuration>>

The light emitting element according to any one of [A01] to [D17], in which at least two light absorbing material layers are formed in the laminated structure including the second electrode in parallel with the virtual plane occupied by the active layer.

[E02] The light emitting element according to [E01], in which at least four light absorbing material layers are formed.

[E03] The light emitting element according to [E01] or [E02], in which when an oscillation wavelength is $\lambda_0$, an equivalent refractive index of the whole of two light absorbing material layers and a portion of the laminated structure located between the light absorbing material layers is $n_{eq}$, and a distance between the light absorbing material layers is represented by $L_{Abs}$,

$$0.9 \times \{(m \cdot \lambda_0)/(2 \cdot n_{eq})\} \leq L_{Abs} \leq 1.1 \times \{(m \cdot \lambda_0)/(2 \cdot n_{eq})\}$$

is satisfied.

Here, m is 1 or an arbitrary integer of 2 or more including 1.

[E04] The light emitting element according to any one of [E01] to [E03], in which the light absorbing material layer has a thickness of $\lambda_0/(4 \cdot n_{eq})$ or less.

[E05] The light emitting element according to any one of [E01] to [E04], in which the light absorbing material layer is located in a minimum amplitude portion generated in a standing wave of light formed inside the laminated structure.

[E06] The light emitting element according to any one of [E01] to [E05], in which the active layer is located at a maximum amplitude portion generated in a standing wave of light formed inside the laminated structure.

[E07] The light emitting element according to any one of [E01] to [E06], in which the light absorbing material layer has a light absorption coefficient that is twice or more the light absorption coefficient of the compound semiconductor constituting the laminated structure.

[E08] The light emitting element according to any one of [E01] to [E07], in which the light absorbing material layer includes at least one material selected from the group consisting of a compound semiconductor material having a band gap narrower than that of the compound semiconductor constituting the laminated structure, a compound semiconductor material doped with impurities, a transparent conductive material, and a light reflecting layer constituting material having light absorption characteristics.

[F01] The light emitting element according to any one of [A01] to [E07], in which a partition wall extending in the lamination direction of the laminated structure is formed so as to surround the first light reflecting layer.

[F02] The light emitting element according to [F01], in which the partition wall extends from a side of the first surface of the first compound semiconductor layer to the middle of the first compound semiconductor layer in the thickness direction in the first compound semiconductor layer.

[F03] The light emitting element according to [F01], in which the partition wall extends from a side of the second surface of the second compound semiconductor layer into the second compound semiconductor layer and the active layer, and further extends to the middle of the first compound semiconductor layer in the thickness direction in the first compound semiconductor layer.

[F04] The light emitting element according to any one of [F01] to [F03], in which the partition wall includes a material that does not transmit light generated in the active layer.

[F05] The light emitting element according to any one of [F01] to [F03], in which the partition wall includes a material that reflects light generated in the active layer.

[F06] The light emitting element according to any one of [F01] to [F03], in which when the thermal conductivity of the material constituting the first compound semiconductor layer is $TC_1$ and the thermal conductivity of the material constituting the partition wall is $TC_0$,

$$1 \times 10^{-1} \leq TC_1/TC_0 \leq 1 \times 10^2$$

is satisfied.

[F07] The light emitting element according to any one of [F01] to [F03], in which when a linear expansion coefficient of the material constituting the first compound semiconductor layer is $CTE_1$ and a linear expansion coefficient of the material constituting the partition wall is $CTE_0$,

$$|CTE_0 - CTE_1| \leq 1 \times 10^{-4}/K$$

is satisfied.

[F08] The light emitting element according to any one of [F01] to [F03], in which

the partition wall includes a solder material, and
a part of the partition wall is exposed on an outer surface of the light emitting element.

[F09] The light emitting element according to any one of [F01] to [F08], in which the side surface of the partition wall is tapered along a direction from a side of the first surface of the first compound semiconductor layer toward a side of the second surface of the second compound semiconductor layer.

[F10] The light emitting element according to any one of [F01] to [F09], in which

the first light reflecting layer is formed on a base surface located on a side of the first surface of the first compound semiconductor layer,
the base surface extends in a peripheral region, and
the base surface has an uneven shape and can be differentiated.

[G01] <<Method for manufacturing light emitting element ⋯ first aspect>>

A method for manufacturing a light emitting element including

a laminated structure in which
a first compound semiconductor layer having a first surface and a second surface facing the first surface,
an active layer facing the second surface of the first compound semiconductor layer, and
a second compound semiconductor layer having a first surface facing the active layer and a second surface facing the first surface
are laminated,
a first light reflecting layer, and
a second light reflecting layer formed on a side of the second surface of the second compound semiconductor layer and having a flat shape,
a base surface located on a side of the first surface of the first compound semiconductor layer having a first region including a protruding portion protruding in a direction away from the active layer and a second region surrounding the first region and having a flat surface,
the first light reflecting layer being formed at least on a top portion of the first region, and
at an intersection of a curve formed by the first region and a straight line formed by the second region in a cross-sectional shape of the base surface when the base surface is cut along a virtual plane including a lamination direction of the laminated structure, a complementary angle $\theta_{CA}$ of an angle formed by the curve and the straight line exceeding 0°, the method including:

forming the second light reflecting layer on a side of the second surface of the second compound semiconductor layer after forming the laminated structure;
after performing a protrusion forming step of forming a protrusion in a region where the first region of the base surface is to be formed and forming a flat surface in a region where the second region of the base surface is to be formed;
performing an etch-back step of forming a protrusion in a first region of the base surface and forming a flat surface in a second region of the base surface with reference to the second surface of the first compound semiconductor layer by forming a second sacrificial layer on the entire surface and then etching back the first compound semiconductor layer from the base surface toward the inside thereof using the second sacrificial layer as an etching mask; and
forming the first light reflecting layer on at least a top portion of the first region of the base surface,
in which

$$\theta_2 < \theta_1$$

is satisfied.

Here, $\theta_1$ is a complementary angle of an angle formed by a curve and a straight line at an intersection of the curve and the straight line, the curve being formed by the region in which the first region is to be formed, and the straight line being formed by the region in which the second region is to be formed, in the cross-sectional shape of the base surface obtained in the protrusion forming step, and
$\theta_2$ is a complementary angle of an angle formed by the curve and the straight line at the intersection of the curve formed by the first region and the straight line formed by the second region in the cross-sectional shape of the base surface obtained in the etch-back step.

[G02] The method for manufacturing a light emitting element according to [G01], in which in the protrusion forming step, a first sacrificial layer having a convex surface is formed on the region where the first region of the base surface is to be formed, and then etch-back processing is performed from the base surface toward the inside using the first sacrificial layer as an etching mask.

[G03] The method for manufacturing a light emitting element according to [G01] or [G02], in which in the etch-back step, after the second sacrificial layer is formed a plurality of times, etch-back processing is performed from the base surface toward the inside using the second sacrificial layer as an etching mask.

[G04] The method for manufacturing a light emitting element according to [G01] or [G02], in which $\theta_{CA} = \theta_2$ by repeating the etch-back step.

[H01] <<Method for manufacturing light emitting element ⋯ second aspect>>

A method for manufacturing a light emitting element including

a laminated structure in which
a first compound semiconductor layer having a first surface and a second surface facing the first surface,
an active layer facing the second surface of the first compound semiconductor layer, and
a second compound semiconductor layer having a first surface facing the active layer and a second surface facing the first surface
are laminated,
a first light reflecting layer, and
a second light reflecting layer formed on a side of the second surface of the second compound semiconductor layer and having a flat shape,
a base surface located on a side of the first surface of the first compound semiconductor layer having a first region including a protruding portion protruding in a direction away from the active layer and a second region surrounding the first region and having a flat surface,
the first light reflecting layer being formed at least on a top portion of the first region, and
at an intersection of a curve formed by the first region and a straight line formed by the second region in a cross-sectional shape of the base surface when the base surface is cut along a virtual plane including a lamination direction of the laminated structure, a complementary angle $\theta_{CA}$ of an angle formed by the curve and the straight line exceeding 0°, the method including:

forming the second light reflecting layer on a side of the second surface of the second compound semiconductor layer after forming the laminated structure;
forming a first sacrificial layer on the first region of the base surface on which the first light reflecting layer is to be formed;
performing an etch-back step of forming a protrusion in a first region of the base surface and forming a flat surface in a second region of the base surface with respect to the second surface of the first compound semiconductor layer by forming a second sacrificial layer on the entire surface and then etching back the first compound semiconductor layer from the base surface toward the inside thereof using the second sacrificial layer and the first sacrificial layer as an etching mask; and
forming the first light reflecting layer on at least a top portion of the first region of the base surface,
in which $\theta_2' < \theta_1'$ is satisfied.

Here, $\theta_1'$ is a complementary angle of an angle formed by a curve formed by a cross-sectional shape of the first sacrificial layer when the first sacrificial layer is cut along the virtual plane and a straight line formed by a flat portion at an intersection of the curve and the straight line, and

$\theta_2'$ is a complementary angle of an angle formed by the curve and the straight line at an intersection of the curve formed by the first region and the straight line formed by the second region in the cross-sectional shape of the base surface obtained by the etch-back step.

[H02] The method for manufacturing a light emitting element according to [H01], in which in the etch-back step, the second sacrificial layer is formed a plurality of times, and then etch-back processing is performed from the base surface toward the inside using the second sacrificial layer and the first sacrificial layer as the etching mask.

[H03] The method for manufacturing a light emitting element according to [H01] or [H02], in which a step of forming the second sacrificial layer on the entire surface after executing the etch-back step, and then performing etch-back processing from the base surface toward the inside using the second sacrificial layer as the etching mask is repeated so that $\theta_{CA} = \theta_2'$.

REFERENCE SIGNS LIST

10A, 10D, 10E Light emitting element (surface emitting element, surface emitting laser element)

11 Compound semiconductor substrate (substrate for manufacturing light emitting element array)

11a First surface of compound semiconductor substrate (substrate for manufacturing light emitting element array) facing first compound semiconductor layer

11b Second surface of compound semiconductor substrate (substrate for manufacturing light emitting element array) facing first compound semiconductor layer

20 Laminated structure

21 First compound semiconductor layer

21a First surface of first compound semiconductor layer

21b Second surface of first compound semiconductor layer

22 Second compound semiconductor layer

22a First surface of second compound semiconductor layer

22b Second surface of second compound semiconductor layer

23 Active layer (light emitting layer)

31 First electrode

31' Opening portion provided in first electrode

32 Second electrode

33 Second pad electrode

34 Insulating layer (current confinement layer)

34A Opening portion provided in insulating layer (current confinement layer)

35 Bump

41 First light reflecting layer

42 Second light reflecting layer

42A Forward tapered inclined portion formed in second light reflecting layer

48 Bonding layer

49 Support substrate

51, 61 Current injection region

61A Current injection region

61B Current non-injection region

52, 62 Current non-injection/inner region

53, 63 Current non-injection/outer region

54, 64 Mode loss action site (mode loss action layer)

54A, 54B, 64A Opening portion formed in mode loss action site

55, 65 Mode loss action region

71 Light absorbing material layer

81, 81' First sacrificial layer

82 Second sacrificial layer

90 Base surface

91 First region

91' Top portion of first region (first-A region)

91A First-A region

91B First-B region

91a, 91b Protrusion

92 Second region

92a, 92b Flat surface

93 Base material

94 Uneven portion for forming base surface

95 Planarization film

96, 97 Partition wall

96', 97' Side surface of partition wall

96a, 97a Lower end portion of partition wall

96b, 97b Upper end portion of partition wall

**Claims**

1. A light emitting element comprising:

a laminated structure in which

a first compound semiconductor layer having a first surface and a second surface facing the first surface,

an active layer facing the second surface of the first compound semiconductor layer, and

a second compound semiconductor layer having a first surface facing the active layer and a second surface facing to the first surface

are laminated;

a first light reflecting layer; and

a second light reflecting layer formed on a side of the second surface of the second compound semiconductor layer and having a flat shape,

wherein a base surface located on a side of the first surface of the first compound semiconductor layer has a first region including a protruding portion protruding in a direction away from the active layer and a second region surrounding the first region and having a flat surface,

the first region includes a first-A region including a top portion of the protruding portion and a first-B region surrounding the first-A region,

the first light reflecting layer is formed on at least the first-A region,

a first curve formed by the first-A region in a cross-sectional shape of the base surface when the base surface is cut along a virtual plane including a lamination direction of the laminated structure is formed by an upwardly convex smooth curve,

at an intersection of a second curve formed by the first-B region and a straight line formed by the second region in the cross-sectional shape of the base surface, a complementary angle $\theta_{CA}$ of an angle formed by the second curve and the straight line has a value exceeding 0°, and

the second curve includes at least one kind of figure selected from the group consisting of a combination of a downwardly convex curve, a line segment, and an arbitrary curve.

2. The light emitting element according to claim 1, wherein the complementary angle $\theta_{CA}$ is 1° or more and 6° or less.

3. A light emitting element comprising:

a laminated structure in which

a first compound semiconductor layer having a first surface and a second surface facing the first surface,

an active layer facing the second surface of the first compound semiconductor layer, and

a second compound semiconductor layer having a first surface facing the active layer and a second surface facing the first surface

are laminated;

a first light reflecting layer; and

a second light reflecting layer formed on a side of the second surface of the second compound semiconductor layer and having a flat shape,

wherein a base surface located on a side of the first surface of the first compound semiconductor layer has a first region including a protruding portion protruding in a direction away from the active layer and a second region surrounding the first region and having a flat surface,

the first light reflecting layer is formed at least on a top portion of the first region, and

at an intersection of a curve formed by the first region and a straight line formed by the second region in a cross-sectional shape of the base surface when the base surface is cut along a virtual plane including a lamination direction of the laminated structure, a complementary angle $\theta_{CA}$ of an angle formed by the curve and the straight line is 1° or more and 6° or less.

4. The light emitting element according to claim 1 or 3, wherein a curvature radius $R_1$ of the top portion of the first region of the base surface is $1.5 \times 10^{-5}$ m or more and $2 \times 10^{-4}$ m or less.

5. The light emitting element according to claim 1 or 3, wherein a height $H_1$ of the first region with respect to the flat surface of the second region is 1 $\mu$m or more and 5 $\mu$m or less.

6. The light emitting element according to claim 1 or 3, wherein when a curvature radius of the top portion of the first region of the base surface is $R_1$ and a resonator length of the light emitting element is $L_{OR}$,

$$1 \leq R_1/L_{OR} \leq 10$$

is satisfied.

7. The light emitting element according to claim 1 or 3, wherein a diameter $D_1$ of the first region of the base surface is $3 \times 10^{-6}$ m or more and $1 \times 10^{-4}$ m or less.

8. A method for manufacturing a light emitting element including

a laminated structure in which
a first compound semiconductor layer having a first surface and a second surface facing the first surface,
an active layer facing the second surface of the first compound semiconductor layer, and
a second compound semiconductor layer having a first surface facing the active layer and a second surface facing the first surface
are laminated,
a first light reflecting layer, and
a second light reflecting layer formed on a side of the second surface of the second compound semiconductor layer and having a flat shape,
a base surface located on a side of the first surface of the first compound semiconductor layer having a first region including a protruding portion protruding in a direction away from the active layer and a second region surrounding the first region and having a flat surface,
the first light reflecting layer being formed at least on a top portion of the first region, and
at an intersection of a curve formed by the first region and a straight line formed by the second region in a cross-sectional shape of the base surface when the base surface is cut along a virtual plane including a lamination direction of the laminated structure, a complementary angle $\theta_{CA}$ of an angle formed by the curve and the straight line exceeding 0°, the method comprising:

forming the second light reflecting layer on a side of the second surface of the second compound semiconductor layer after forming the laminated structure;
after performing a protrusion forming step of forming a protrusion in a region where the first region of the base surface is to be formed and forming a flat surface in a region where the second region of the base surface is to be formed;
performing an etch-back step of forming a protrusion in a first region of the base surface and forming a flat surface in a second region of the base surface with reference to the second surface of the first compound semiconductor layer by forming a second sacrificial layer on the entire surface and then etching back the first compound semiconductor layer from the base surface toward the inside thereof using the second sacrificial layer as an etching mask; and
forming the first light reflecting layer on at least a top portion of the first region of the base surface, wherein

$$\theta_2 \; < \; \theta_1$$

is satisfied,
here, $\theta_1$ is a complementary angle of an angle formed by a curve and a straight line at an intersection of the curve and the straight line, the curve being formed by the region in which the first region is to be formed, and the straight line being formed by the region in which the second region is to be formed, in the cross-sectional shape of the base surface obtained in the protrusion forming step, and
$\theta_2$ is a complementary angle of an angle formed by the curve and the straight line at the intersection of the curve formed by the first region and the straight line formed by the second region in the cross-sectional shape of the base surface obtained in the etch-back step.

9. The method for manufacturing a light emitting element according to claim 8, wherein in the protrusion forming step, a first sacrificial layer having a convex surface is formed on the region where the first region of the base surface is to be formed, and then the first compound semiconductor layer is etched back from the base surface toward the inside thereof using the first sacrificial layer as an etching mask.

10. The method for manufacturing a light emitting element according to claim 8, wherein in the etch-back step, after the second sacrificial layer is formed a plurality of times, the first compound semiconductor layer is etched back from the base surface toward the inside thereof using the second sacrificial layer as an etching mask.

**11.** The method for manufacturing a light emitting element according to claim 8, wherein $\theta_{CA} = \theta_2$ by repeating the etch-back step.

**12.** A method for manufacturing a light emitting element including

a laminated structure in which
a first compound semiconductor layer having a first surface and a second surface facing the first surface,
an active layer facing the second surface of the first compound semiconductor layer, and
a second compound semiconductor layer having a first surface facing the active layer and a second surface facing the first surface
are laminated,
a first light reflecting layer, and
a second light reflecting layer formed on a side of the second surface of the second compound semiconductor layer and having a flat shape,
a base surface located on a side of the first surface of the first compound semiconductor layer having a first region including a protruding portion protruding in a direction away from the active layer and a second region surrounding the first region and having a flat surface,
the first light reflecting layer being formed at least on a top portion of the first region, and
at an intersection of a curve formed by the first region and a straight line formed by the second region in a cross-sectional shape of the base surface when the base surface is cut along a virtual plane including a lamination direction of the laminated structure, a complementary angle $\theta_{CA}$ of an angle formed by the curve and the straight line exceeding 0°, the method comprising:

forming the second light reflecting layer on a side of the second surface of the second compound semiconductor layer after forming the laminated structure;
forming a first sacrificial layer on the first region of the base surface on which the first light reflecting layer is to be formed;
performing an etch-back step of forming a protrusion in a first region of the base surface and forming a flat surface in a second region of the base surface with respect to the second surface of the first compound semiconductor layer by forming a second sacrificial layer on the entire surface and then etching back the first compound semiconductor layer from the base surface toward the inside thereof using the second sacrificial layer and the first sacrificial layer as an etching mask; and
forming the first light reflecting layer on at least a top portion of the first region of the base surface, wherein

$$\theta_2' \; < \; \theta_1'$$

is satisfied,
here, $\theta_1'$ is a complementary angle of an angle formed by a curve formed by a cross-sectional shape of the first sacrificial layer when the first sacrificial layer is cut along the virtual plane and a straight line formed by a flat portion at an intersection of the curve and the straight line, and
$\theta_2'$ is a complementary angle of an angle formed by the curve and the straight line at an intersection of the curve formed by the first region and the straight line formed by the second region in the cross-sectional shape of the base surface obtained by the etch-back step.

**13.** The method for manufacturing a light emitting element according to claim 12, wherein in the etch-back step, the second sacrificial layer is formed a plurality of times, and then the first compound semiconductor layer is etched back from the base surface toward the inside thereof using the second sacrificial layer and the first sacrificial layer as the etching mask.

**14.** The method for manufacturing a light emitting element according to claim 12, wherein a step of forming the second sacrificial layer on the entire surface after executing the etch-back step, and then etching back the first compound semiconductor layer from the base surface toward the inside thereof using the second sacrificial layer as the etching mask is repeated so that $\theta_{CA} = \theta_2'$.

*FIG. 1*

EP 4 071 946 A1

FIG. 2

EP 4 071 946 A1

FIG. 3

**FIG. 4**

## FIG. 5

# FIG. 6

EP 4 071 946 A1

*FIG. 7*

EP 4 071 946 A1

## FIG. 8

# FIG. 9

*FIG. 10A*

*FIG. 10B*

# FIG. 11

# FIG. 12

## FIG. 13A

21a

81

21

## FIG. 13B

21a

81'

21

## FIG. 14A

## FIG. 14B

## FIG. 15

*FIG. 16A*

82    21a                81

$\theta_1{}'$

21

*FIG. 16B*

91

92    21b    92b        91b

$\theta_2{}'$

21

## FIG. 17A

A

91

92

## FIG. 17B

A

A

91

92

B

# FIG. 18

# FIG. 19

# FIG. 20

# FIG. 21A

# FIG. 21B

# FIG. 21C

# FIG. 22

*FIG. 23A*

*FIG. 23B*

*FIG. 24*

(no)

# FIG. 25

# FIG. 26

## FIG. 27A

Z AXIS

## FIG. 27B

# FIG. 28

# FIG. 29

# FIG. 30

# FIG. 31

LIGHT EMITTING STRUCTURE

VERTICAL MODE

22

23

21

71

VERTICAL MODE A

21

VERTICAL MODE B

71

46. 5nm

93. 0nm

21

MODE LOSS COMPONENT

71

21

LIGHT INTENSITY

# FIG. 32

FIG. 33

EP 4 071 946 A1

FIG. 34

EP 4 071 946 A1

# FIG. 35

EP 4 071 946 A1

FIG. 36

EP 4 071 946 A1

FIG. 37

EP 4 071 946 A1

*FIG. 38*

EP 4 071 946 A1

*FIG. 39*

FIG. 40

EP 4 071 946 A1

# FIG. 41

# FIG. 42

## FIG. 43

# FIG. 44

# FIG. 45

# FIG. 46

# FIG. 47

# FIG. 48

# FIG. 49

VIRTUAL FIRST LIGHT
REFLECTING LAYER

VIRTUAL
ACTIVE LAYER

$2L_{OR}$

$2\omega_0$

SECOND LIGHT
REFLECTING LAYER

ACTIVE LAYER

LIGHT FIELD

FIRST LIGHT
REFLECTING LAYER

FIG. 50

EP 4 071 946 A1

FIG. 51

EP 4 071 946 A1

## FIG. 52A

34A（61B）

LIGHT
FIELD

34（61A）

[FIRST LIGHT REFLECTING LAYER]

## FIG. 52B

34A（61B）

34（61A）

LIGHT
FIELD

[FIRST LIGHT REFLECTING LAYER]

## FIG. 53A

GAIN SPECTRUM

WAVELENGTH

VERTICAL MODE DETERMINED
BY RESONATOR LENGTH

## FIG. 53B

GAIN SPECTRUM

$\Delta \lambda$

WAVELENGTH

VERTICAL MODE DETERMINED
BY RESONATOR LENGTH

# FIG. 54

## INTERNATIONAL SEARCH REPORT

International application No.

PCT/JP2020/045396

### A. CLASSIFICATION OF SUBJECT MATTER
Int.Cl. H01S5/183(2006.01)i, H01L21/3065(2006.01)i, H01S5/42(2006.01)i
FI: H01S5/183, H01S5/42, H01L21/302105B

According to International Patent Classification (IPC) or to both national classification and IPC

### B. FIELDS SEARCHED

Minimum documentation searched (classification system followed by classification symbols)
Int.Cl. H01S5/183, H01L21/3065, H01S5/42

Documentation searched other than minimum documentation to the extent that such documents are included in the fields searched

| | |
|---|---|
| Published examined utility model applications of Japan | 1922–1996 |
| Published unexamined utility model applications of Japan | 1971–2021 |
| Registered utility model specifications of Japan | 1996–2021 |
| Published registered utility model applications of Japan | 1994–2021 |

Electronic data base consulted during the international search (name of data base and, where practicable, search terms used)

### C. DOCUMENTS CONSIDERED TO BE RELEVANT

| Category* | Citation of document, with indication, where appropriate, of the relevant passages | Relevant to claim No. |
|---|---|---|
| X<br>A | WO 2018/221042 A1 (SONY CORPORATION) 06 December 2018 (2018-12-06), paragraphs [0002], [0012]–[0048], fig. 1-13 | 1, 4–7<br>2–3, 8–14 |
| A | JP 2002-237653 A (SAMSUNG ELECTRO MECH CO., LTD.) 23 August 2002 (2002-08-23), paragraphs [0046]–[0066], fig. 6-13 | 1-14 |
| A | JP 2007-178597 A (TOPCON CORPORATION) 12 July 2007 (2007-07-12), paragraphs [0027]-[0040], [0043]–[0064], fig. 1, 2, 5-7 | 1-14 |
| A | JP 2019-165198 A (RICOH CO., LTD.) 26 September 2019 (2019-09-26), paragraphs [0010]-[0066], fig. 1-11 | 1-14 |
| A | JP 2015-518288 A (MATTSON TECHNOLOGY, INC.) 25 June 2015 (2015-06-25), paragraphs [0013]-[0024], fig. 1-6 | 1-14 |

☒ Further documents are listed in the continuation of Box C.  ☒ See patent family annex.

| | |
|---|---|
| * Special categories of cited documents: | "T" later document published after the international filing date or priority date and not in conflict with the application but cited to understand the principle or theory underlying the invention |
| "A" document defining the general state of the art which is not considered to be of particular relevance | |
| "E" earlier application or patent but published on or after the international filing date | "X" document of particular relevance; the claimed invention cannot be considered novel or cannot be considered to involve an inventive step when the document is taken alone |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search | Date of mailing of the international search report |
|---|---|
| 01 February 2021 | 16 February 2021 |

| Name and mailing address of the ISA/ | Authorized officer |
|---|---|
| Japan Patent Office<br>3-4-3, Kasumigaseki, Chiyoda-ku,<br>Tokyo 100-8915, Japan | |
| | Telephone No. |

Form PCT/ISA/210 (second sheet) (January 2015)

**INTERNATIONAL SEARCH REPORT**

| International application No. |
|---|
| PCT/JP2020/045396 |

C (Continuation).   DOCUMENTS CONSIDERED TO BE RELEVANT

| Category* | Citation of document, with indication, where appropriate, of the relevant passages | Relevant to claim No. |
|---|---|---|
| A | JP 6-302563 A (NIPPON STEEL CORPORATION) 28 October 1994 (1994-10-28), paragraphs [0003]-[0012], fig. 1 | 1-14 |
| A | JP 2003-332686 A (AGILENT TECHNOLOGIES INC.) 21 November 2003 (2003-11-21), entire text, all drawings | 1-14 |
| A | US 2007/0280320 A1 (FEEZELL, D. F.) 06 December 2007 (2007-12-06), entire text, all drawings | 1-14 |

Form PCT/ISA/210 (second sheet) (January 2015)

<table>
<tr><td colspan="4">INTERNATIONAL SEARCH REPORT</td><td>International application No.</td></tr>
<tr><td colspan="4">Information on patent family members</td><td>PCT/JP2020/045396</td></tr>
</table>

```
WO 2018/221042 A1  06 December 2018   US 2020/0112141 A1
                                      paragraphs [0002], [0036]-[0071],
                                      fig. 1-13
                                      EP 3633807 A1

JP 2002-237653 A   23 August 2002     US 2002/0105988 A1
                                      paragraphs [0043]-[0050], fig. 6-13
                                      EP 1233493 A2
                                      KR 10-2002-0064521 A
                                      CN 1369940 A

JP 2007-178597 A   12 July 2007       (Family: none)

JP 2019-165198 A   26 September 2019  WO 2019/181757 A1
                                      TW 201939833 A

JP 2015-518288 A   25 June 2015       US 2013/0323933 A1
                                      paragraphs [0023]-[0034], fig. 1-6
                                      WO 2013/181140 A2
                                      TW 201409086 A
                                      KR 10-2015-0010767 A

JP 6-302563 A      28 October 1994    (Family: none)

JP 2003-332686 A   21 November 2003   US 2003/0214992 A1
                                      entire text, all drawings
                                      EP 1363369 A1

US 2007/0280320 A1 06 December 2007   WO 2007/133766 A2
```

Form PCT/ISA/210 (patent family annex) (January 2015)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- WO 2018083877 A1

**Non-patent literature cited in the description**

- **H. KOGELNIK ; T. LI.** Laser Beams and Resonators. *Applied Optics,* October 1966, vol. 5 (10